(19) Europäisches Patentamt
European Patent Office
Office européen des brevets

(11) EP 4 543 081 A1

(12) # EUROPEAN PATENT APPLICATION
published in accordance with Art. 153(4) EPC

(43) Date of publication:
**23.04.2025 Bulletin 2025/17**

(21) Application number: **23822857.1**

(22) Date of filing: **15.05.2023**

(51) International Patent Classification (IPC):
***H04W 28/04*** *(2009.01)* ***H04L 1/1812*** *(2023.01)*

(52) Cooperative Patent Classification (CPC):
**H04L 1/16; H04L 1/1812; H04W 28/04; H04W 28/06**

(86) International application number:
**PCT/CN2023/094340**

(87) International publication number:
**WO 2023/241287 (21.12.2023 Gazette 2023/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **15.06.2022 CN 202210675040**

(71) Applicant: **ZTE Corporation**
**Shenzhen, Guangdong 518057 (CN)**

(72) Inventors:
- **ZHAO, Zhe**
  **Shenzhen, Guangdong 518057 (CN)**
- **LIANG, Chulong**
  **Shenzhen, Guangdong 518057 (CN)**
- **XU, Jin**
  **Shenzhen, Guangdong 518057 (CN)**
- **YUAN, Zhifeng**
  **Shenzhen, Guangdong 518057 (CN)**
- **LI, Liguang**
  **Shenzhen, Guangdong 518057 (CN)**
- **YU, Guanghui**
  **Shenzhen, Guangdong 518057 (CN)**
- **KANG, Jian**
  **Shenzhen, Guangdong 518057 (CN)**
- **FU, Qiang**
  **Shenzhen, Guangdong 518057 (CN)**

(74) Representative: **Savi, Massimiliano et al**
**Notarbartolo & Gervasi S.p.A.**
**Viale Achille Papa, 30**
**20149 Milano (IT)**

(54) **INFORMATION TRANSMISSION METHOD AND APPARATUS, AND BASE STATION, DEVICE, STORAGE MEDIUM AND PROGRAM PRODUCT**

(57) Provided in the embodiments of the present disclosure is an information transmission method. The method comprises: receiving transport blocks sent by at least one second node, wherein the transport blocks form a transport block set; obtaining information of a correct transport block set according to the transport block set; performing encoding processing on the information of the correct transport block set, so as to obtain feedback information, wherein the feedback information is used for representing a receiving condition of the transport blocks sent by the at least one second node, and the encoding processing comprises compressing and encoding the information of the correct transport block set; and sending the feedback information to the at least one second node.

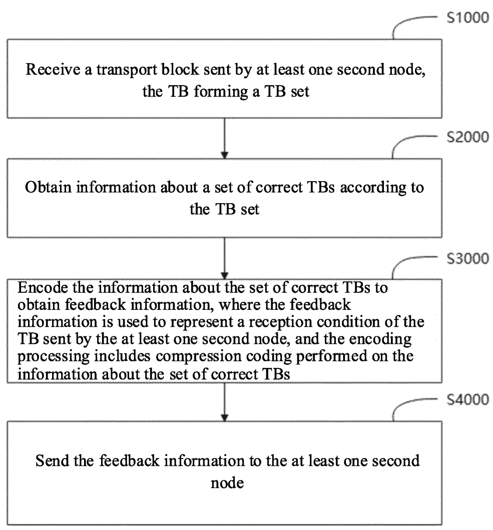

FIG. 2

EP 4 543 081 A1

## Description

## CROSS-REFERENCE TO RELATED APPLICATION

This application is based on and claims the priority of Chinese patent application No. 202210675040.0 filed on June 15, 2022, the disclosure of which is incorporated herein by reference in its entirety.

## TECHNICAL FIELD

Embodiments of the present disclosure relate to the field of communications technologies, in particular to an information transmission method and an apparatus, a base station, a user equipment, a storage medium, and a program product.

## BACKGROUND

With the development of wireless communications technology, each base station (BS) needs to support connection of tens of thousands of user equipments (UEs). Taking a contention-based grant-free (CBGF) random access transmission scheme as an example, a base station does not need to perform scheduling and resource allocation in advance for UEs which send data, and cannot know in advance which UEs have data transmission requirements. As a result, there is a possibility that a plurality of UEs use the same time and frequency resource for transmission. In order for the base station to distinguish between different UEs in a process of reception and detection, the UEs which send data each will randomly select a resource (also called signature) from a random access resource set (for example, a spread spectrum sequence, or a pilot sequence) provided by a system to transmit data.

Since the base station does not perform scheduling for the UEs, the base station needs to feed back an acknowledgment signal to each UE for determining whether a data packet is successfully received. However, as one base station serves thousands of UEs at the same time, if a 1-bit response signal is fed back to each served UE, thousands of bit response signals need to be fed back. Such feedback may cause excessive overhead, leading to a waste of spectrum resources.

## SUMMARY

Embodiments of the present disclosure provide an information transmission method and an apparatus, a base station, a UE, a computer-readable storage medium, and a computer program product, aiming at saving spectrum resources and improving data transmission efficiency.

In accordance with a first aspect of the present disclosure, an embodiment provides an information transmission method, which includes: receiving a transport block (TB) sent by at least one second node, where the TB forms a TB set; obtaining information about a set of correct TBs according to the TB set; encoding the information about the set of correct TBs to obtain feedback information, where the feedback information is used to represent a reception condition of the TB sent by the at least one second node; and the encoding processing includes performing compression coding on the information about the set of correct TBs; and sending the feedback information to the at least one second node.

In accordance with a second aspect of the present disclosure, an embodiment provides an information transmission method applied to a second node, which includes: sending a TB to a first node; and receiving feedback information sent by the first node; where the feedback information is used to represent a reception condition of the TB.

In accordance with a third aspect of the present disclosure, an embodiment provides an information transmission apparatus, which includes: a receiving module configured to receive a TB sent by at least one second node, where the TB forms a TB set; a correct TB information obtaining module configured to obtain information about a set of correct TBs according to the TB set; a feedback information generation module configured to encode the information about the set of correct TBs to obtain feedback information, where the feedback information is used to represent a reception condition of the TB sent by the at least one second node, and the encoding processing includes compression coding performed on the information about the set of correct TBs; and a sending module configured to send the feedback information to the at least one second node.

In accordance with a fourth aspect of the present disclosure, an embodiment provides an information transmission apparatus, which includes: a sending module configured to send a TB to a first node; and a receiving module configured to receive feedback information sent by the first node; where the feedback information is used to represent a reception condition of the TB.

In accordance with a fifth aspect of the present disclosure, an embodiment provides a base station, which includes: a memory, a processor, and a computer program stored in the memory and executable by the processor, where the computer program, when executed by the processor, causes the processor to perform the information transmission method of any one of the first aspect or the second aspect.

In accordance with a sixth aspect of the present disclosure, an embodiment provides a UE, which includes: a memory, a processor, and a computer program stored in the memory and executable by the processor, where the computer program, when executed by the processor, causes the processor to perform the information transmission method of any one of the first aspect or the second aspect.

In accordance with a seventh aspect of the present disclosure, an embodiment provides a computer-readable storage medium, the computer-readable storage medium storing computer-executable instructions configured to cause a computer to perform the information transmission method of any one of the first aspect or the second aspect.

In accordance with an eighth aspect of the present disclosure, an embodiment provides a computer program product, which includes a computer program or computer instructions stored in a computer-readable storage medium, from which a processor of a computing device reads the computer program or the computer instructions, where the computer program or the computer instructions, when executed by the processor, cause the computing device to perform the information transmission method of any one of the first aspect or the second aspect.

## BRIEF DESCRIPTION OF DRAWINGS

FIG. 1 is a schematic diagram of an application scenario and system architecture of an information transmission method provided by an embodiment of the present disclosure;

FIG. 2 is a flowchart of an information transmission method provided by an embodiment of the present disclosure;

FIG. 3 is a flowchart of determining feedback information according to a set of identifiers of correct TBs provided by an embodiment of the present disclosure;

FIG. 4 is a flowchart of determining feedback information according to a set of identifiers of correct TBs provided by another embodiment of the present disclosure;

FIG. 5 is a flowchart of a method for determining a TB error pattern provided by an embodiment of the present disclosure;

FIG. 6 is a flowchart of a method for determining a TB error pattern provided by another embodiment of the present disclosure;

FIG. 7 is a flowchart of determining feedback information according to a TB error pattern provided by an embodiment of the present disclosure;

FIG. 8 is a flowchart of determining feedback information according to a TB error pattern provided by another embodiment of the present disclosure;

FIG. 9 is a flowchart of determining an intermediate codeword according to a set of identifiers of correct TBs provided by an embodiment of the present disclosure;

FIG. 10 is a flowchart of determining an intermediate codeword according to a set of identifiers of correct TBs provided by another embodiment of the present disclosure;

FIG. 11 is a flowchart of determining an intermediate codeword according to a TB error pattern provided by an embodiment of the present disclosure;

FIG. 12 is a flowchart of determining an intermediate codeword according to a TB error pattern provided by another embodiment of the present disclosure;

FIG. 13 is a flowchart of determining feedback information according to an intermediate codeword provided by an embodiment of the present disclosure;

FIG. 14 is a schematic diagram of a relationship among a second node, a TB, and a UE identifier provided by an example of the present disclosure;

FIG. 15 is a diagram of a mapping relationship among a quantity of correct TBs, a set of correct TBs, a TB error pattern, an intermediate codeword, an offset value bit sequence, and feedback information provided by an example of the present disclosure;

FIG. 16 is a diagram of a mapping relationship among a quantity of correct TBs, a set of correct TBs, a TB error pattern, an intermediate codeword, an offset value bit sequence, and feedback information provided by an example of the present disclosure;

FIG. 17 is a diagram of a mapping relationship among a quantity of correct TBs, a set of correct TBs, a TB error pattern, an intermediate codeword, an offset value bit sequence, and feedback information provided by an example of the present disclosure;

FIG. 18 is a schematic diagram of a relationship among a second node, a TB, a UE identifier, a random access signature, and a signature index provided by an example of the present disclosure;

FIG. 19 is a diagram of a mapping relationship among a quantity of correct TBs, a set of correct TBs, a TB error pattern, an intermediate codeword, an offset value bit sequence, and feedback information provided by an example of the present disclosure;

FIG. 20 is a schematic diagram of a relationship among a second node, a TB, a UE identifier, a random access signature, and a signature index provided by an example of the present disclosure;

FIG. 21 is a diagram of a mapping relationship among a quantity of correct TBs, a set of correct TBs, a TB error pattern, an intermediate codeword, an offset value bit sequence, and feedback information provided by an example of the present disclosure;

FIG. 22 is a schematic diagram of a relationship among a second node, a TB, a random access signature, and a signature index provided by an example of the present disclosure;

FIG. 23 is a diagram of a mapping relationship among a quantity of correct TBs, a set of correct TBs, a TB error pattern, an intermediate codeword, an offset value bit sequence, and feedback information provided by an example of the present disclosure;

FIG. 24 is a diagram of a mapping relationship among a quantity of correct TBs, a set of correct TBs, a TB error pattern, an offset value, and feedback information provided by an example of the present disclosure;

FIG. 25 is a flowchart of determining feedback information according to a set of identifiers of correct TBs provided by an example of the present disclosure;

FIG. 26 is a diagram of a mapping relationship among a quantity of correct TBs, a set of correct TBs, a TB error pattern, an offset value, and feedback information provided by an example of the present disclosure;

FIG. 27 is a flowchart of determining feedback information according to a set of identifiers of correct TBs provided by another example of the present disclosure;

FIG. 28 is a schematic diagram of a relationship among a second node, a TB, a random access signature, and a signature index provided by an example of the present disclosure;

FIG. 29 is a schematic diagram of a relationship among a second node, a TB, a UE identifier, and an index value of the UE identifier provided by an example of the present disclosure;

FIG. 30 is a flowchart of an information transmission method provided by an embodiment of the present disclosure;

FIG. 31 is a flowchart of a determining method based on a decoding result provided by an embodiment of the present disclosure;

FIG. 32 is a schematic diagram of an information transmission apparatus provided by an embodiment of the present disclosure;

FIG. 33 is a schematic diagram of an information transmission apparatus provided by an embodiment of the present disclosure;

FIG. 34 is a schematic diagram of a base station provided by an embodiment of the present disclosure; and

FIG. 35 is a schematic diagram of a UE provided by an embodiment of the present disclosure.

## DETAILED DESCRIPTION

It is to be noted that although a functional module division is shown in a schematic diagram of an apparatus and a logical order is shown in a flowchart, the steps shown or described may be executed, in some cases, with a different module division from that of the apparatus or in a different order from that in the flowchart. The terms such as "first" and "second" in the description, claims and above-mentioned drawings are intended to distinguish between similar objects and are not necessarily to describe a specific order or sequence.

In the description of embodiments of the present disclosure, unless otherwise explicitly defined, the terms such as "configure", "install", and "connect" should be construed in a broad sense, and those having ordinary skill in the art can determine the specific meanings of the above terms in the present disclosure in a rational way in conjunction with the specific contents of embodiments of the technical schemes. In the embodiments of the present disclosure, the term such as "further," "exemplary," or "optionally" is used to represent as an example, an illustration, or a description and should not be construed as being more preferred or advantageous than another embodiment or design. The use of the term such as "further," "exemplary," or "optionally," is intended to present a related concept in a specific manner.

FIG. 1 is a schematic diagram of an application scenario and system architecture of an information transmission method provided by an embodiment of the present disclosure. As shown in FIG. 1, in a wireless communications system 100, a base station 110 serves a plurality of types of UEs (120, 130, 140), and there may be one or more UEs for each type. Therefore, the base station 110 serves a plurality of UEs.

The information transmission method provided in the present disclosure may be applied to various communications systems, for example, an Internet of Things (IoT), a narrow band Internet of Things (NB-IoT), Long Term Evolution (LTE), or a 5th Generation (5G) communications system, or may also be a hybrid architecture of LTE and 5G, a 5G new radio (NR) system, or a new communications system emerging in future communications development. Provided that an entity in the communication system can receive a TB and send feedback information on a reception condition of the TB, and another entity can send the TB and receive the feedback information on the reception condition of the TB, the information transmission method provided by the embodiments of the present disclosure can be used.

The UE in the embodiments of the present disclosure is a device which provides voice and/or data connectivity to a user, for example, a handheld device or vehicle-mounted device with a wireless connection function. The UE may also be another processing device connected to a wireless modem. The UE can communicate with one or more core networks through a radio access network (RAN). The UE may also be referred to as a wireless terminal, a subscriber unit, a subscriber station, a mobile station, a mobile, a remote station, an access point, a remote terminal, an access terminal, a user terminal, or a user agent. The UE may be a mobile terminal device, for example, a mobile phone (also referred to as a "cellular" phone), or a computer having a mobile terminal device. For example, the UE may be a portable, pocket-sized, handheld, computer-built-in or vehicle-mounted mobile apparatus, which exchanges a language and/or data with the RAN. For example, the UE may alternatively be a device such as a personal communication service (PCS) phone, a cordless telephone set, a session initiation protocol (SIP) phone, a wireless local loop (WLL) station, or a personal digital assistant (PDA). Common UEs include, for example, a mobile phone, a tablet computer, a notebook computer, a palmtop computer, a mobile internet device (MID), or a wearable device, for example, a smart watch, a smart band, or a pedometer. The embodiments of the present disclosure are not limited thereto.

The base station in the embodiments of the present disclosure may be a base transceiver station (BTS) in a global system for mobile communication (GSM) or code division multiple access (CDMA), a NodeB in wideband code division multiple access (WCDMA), an evolved Node B (eNB or e-NodeB) in LTE, an NR controller, a gNode B (gNB) in a 5G system, a centralized unit, a new wireless base station, a radio remote module, a micro base station, a relay, a distributed unit, a transmission reception point (TRP) or a transmission point (TP), or any other wireless access device. However, the embodiments of the present disclosure are not limited thereto. A network device may cover one or more cells.

Taking the 5G Technical Specification (TS) of the 3rd Generation Partnership Project (3GPP) as an example, transmission of UE is scheduled by a base station, and therefore, an acknowledgment signal does not need to be fed back in the downlink. In the uplink, the UE receives a TB signal sent by the base station, and determines, by using a cyclic redundancy check (CRC) code of a TB, whether a current TB is correctly received. If the CRC check succeeds for the TB, it is considered that the reception is correct, and the UE feeds back a positive acknowledgment (ACK) state (represented by bit "1") to the base station on a time-frequency resource designated by the base station. Otherwise, the UE feeds back a negative acknowledgment (NACK) state (represented by bit "0") to the base station. According to requirements of different scenarios, the acknowledgment state can be transmitted on five physical uplink control channel (PUCCH) formats defined by the 5G standard. These five formats are: PUCCH format 0, PUCCH format 1, PUCCH format 2, PUCCH format 3, and PUCCH format 4, respectively. PUCCH formats 0 and 1 are used to transmit 1-or 2-bit hybrid automatic repeat request (HARQ) acknowledgment (HARQ-ACK) information and scheduling request. PUCCH formats 2 to 4 are used to transmit a channel state information (CSI) report or multi-bit HARQ-ACK information.

Table 1 A quantity of resources occupied by different PUCCH formats, a quantity of bits transmitted, and example uses

| PUCCH format | Number of OFDM symbols $N_{symb}$ | Number of RBs $N_{RB}$ | Number of REs $N_{RE}$ | Number A of bits of a payload | Use |
|---|---|---|---|---|---|
| 0 | 1~2 | 1 | 12 or 24 | ≤ 2 | HARQ-ACK information feedback, and scheduling request |
| 1 | 4-14 | 1 | 48~168 | ≤ 2 | HARQ-ACK information feedback, and scheduling request |
| 2 | 1~2 | >1 | ≥12 | >2 | HARQ-ACK information feedback, scheduling request, and CSI report |
| 3 | 4~14 | ≥ 1 | ≥48 | >2 | HARQ-ACK information feedback, scheduling request, and CSI report |
| 4 | 4~14 | 1 | ≥48 | >2 | HARQ-ACK information feedback, scheduling request, and CSI report |

Table 1 shows the number of bits of the payload, the number of resources occupied, and the uses under different PUCCH formats, where OFDM represents orthogonal frequency division multiplexing, RB represents resource block, and RE represents resource element.

The number of bits of the payload of each of PUCCH formats 0 and 1 is not greater than 2. Phase-shift keying (PSK) is performed on a load, then a modulated load is multiplied by a sequence, and spectrum spreading is performed on a product thereof to obtain a transmission signal. PUCCH formats 2 to 4 use polarization code channel coding and PSK to obtain a transmission signal.

As can be seen from Table 1, on average, at least 6 REs are required for transmitting each 1-bit acknowledgment signal. For a future large-scale scheduling-free system, even if the base station only serves 1000 UEs, at least 6000 REs are required for acknowledgment signal feedback (about 36 RBs, each RB having 12*14=168 REs). This will occupy a large amount of spectrum resources. However, in fact, the number of UEs with data transmission at the same time is significantly less than 1000 (often only a few dozen), and efficiency of feeding back acknowledgment signals is low.

In view of this, the embodiments of the present disclosure provide an information transmission method and an apparatus, a base station, a UE, a storage medium, and a program product. By performing compression coding on information about a set of correctly-received TBs, a plurality of correctly-received acknowledgment signals of UEs are compressed, so that a quantity of input bits of channel coding is minimized, and then channel coding and modulation are performed and processed signals are transmitted. Each UE decodes and decompresses the received acknowledgment signal and extracts a corresponding acknowledgment signal, thereby achieving the purpose of saving spectrum resources and improving data transmission efficiency.

FIG. 2 is a flowchart of an information transmission method provided by an embodiment of the present disclosure. As shown in FIG. 2, the information transmission method provided by the embodiment of the present disclosure can be used for any network element having data reception and signaling transmission functions, such as a base station, a relay, or a terminal device, including but not limited to steps S1000, S2000, S3000 and S4000.

At S1000, a TB sent by at least one second node is received, the TB forming a TB set.

In some embodiments, a first node receives a signal, including a TB, sent by one second node.

In some embodiments, when the first node receives signals including TBs sent by a plurality of second nodes, the second nodes form a sequence of second nodes, and the TBs sent by the plurality of second nodes form a TB set. Here, the sequence of second nodes includes Nu second nodes, and the TB set includes Nb TBs, where Nu and Nb are positive integers, and Nu is less than or equal to Nb.

It is to be noted that, in some embodiments, one second node may send one or more TBs to the first node, and the one or more TBs form a TB set. In some other embodiments, two or more second nodes may send one or more TBs to the first node, respectively, and the TBs form a TB set.

In some embodiments, a TB in the TB set includes a TB identifier, an ordered set of TB identifiers includes Na TB identifiers I(1), I(2), ..., and I(Na), and Na is a size of the ordered set of TB identifiers. For i=1, 2, ..., Na, an $i^{th}$ element in the ordered set of TB identifiers is I(i). Here, the $i^{th}$ element I(i) in the ordered set of TB identifiers may be an integer i or an integer i-1.

In some embodiments, the TB is indicated by a TB identifier.

In some embodiments, the TB identifier may be one of the following: a UE identifier, an index value of a UE identifier, or a signature index.

In some embodiments, the UE identifier is a UE identifier of a second node in the sequence of second nodes, and UE identifiers of two different second nodes in the sequence of second nodes are different. The UE identifiers may be used for the first node to distinguish between different TBs in the TB set in a signal including the TB set, and the UE identifier is an integer.

It should be noted that the UE identifier may be a subscription permanent identifier (SUPI), a generic public subscription identifier (GPSI), a permanent equipment identifier (PEI), a network access identifier (NAI), a subscription concealed identifier (SUCI), a globally unique temporary identity (GUTI), a radio network temporary identifier (RNTI), a system information RNTI (SI-RNTI), a paging RNTI (P-RNTI), a random access RNTI (RA-RNTI), a temporary cell RNTI, (TC-RNTI), a cell RNTI (C-RNTI), a transmit power control-physical uplink control channel-RNTI (TPC-PUCCH-RNTI), a transmit power control-physical uplink shared channel-RNTI (TPC-PUSCH-RNTI), a transmit power control-sounding reference symbols-RNTI (TPC-SRS-RNTI), an interruption RNTI (INT-RNTI), a modulation coding scheme cell RNTI (MCS-C-RNTI), a configured scheduling RNTI (CS-RNTI), a slot format indication RNTI (SFI-RNTI), a semi-persistent RNTI (SP-CSI-RNTI), or the like.

In some embodiments, the TB identifier is a UE identifier, and elements in the ordered set of TB identifiers are UE identifiers. In an example, the ordered set of TB identifiers I = <I(1), 1(2), I(3), I(4), I(5)> =<0, 1, 2, 3, 4>, where the size Na of the ordered set of TB identifiers is equal to 5, and a UE identifier corresponding to the second element I(2) in the ordered set of TB identifiers is 1. In another example, the ordered set of TB identifiers I = <I(1), I(2), I(3), I(4), I(5)> = <1, 2, 3, 4, 5>, where the size Na of the ordered set of TB identifiers is equal to 5, and the UE identifier corresponding to the second element I(2) in the ordered set of TB identifiers is 2. Still in another example, the ordered set of TB identifiers I = <I(1), I(2), I(3), I(4)> = <0, 11, 20, 30>, where the size Na of the ordered set of TB identifiers is equal to 4, and the UE identifier corresponding to the second element I(2) in the ordered set of TB identifiers is 11.

In some embodiments, the index value of a UE identifier is an index i of an element I(i) in an ordered set of TB identifiers I = <I(1), I(2), ..., I(Na)>, i = 1, 2, ..., Na, and the index value of the UE identifier is an integer.

In some embodiments, the TB identifier is the index value of the UE identifier, the UE identifier is an element in an ordered set of UE identifiers, and the ordered set of UE identifiers includes Na UE identifiers ID(1), ID(2), ..., ID(Na). Here, Na is a size of the ordered set of UE identifiers and the size of the ordered set of TB identifiers, i = 1, 2, ..., Na, and an index value of a UE identifier corresponding to an $i^{th}$ UE identifier ID(i) in the ordered set of UE identifiers is an $i^{th}$ element I(i) in elements in the ordered set of TB identifiers. In an example, the ordered set of UE identifiers ID = <ID(1), ID(2), ID(3), ID(4)> = <0, 11, 20, 30>, and the corresponding ordered set of TB identifiers I = <I(1), I(2), I(3), I(4)> = <0, 1, 2, 3>; where the size of the ordered set of UE identifiers and the size of the ordered set of TB identifiers are both Na = 4, and an index value of a UE identifier of an element ID(2) = 11 in the ordered set of UE identifiers is the element I(2) = 1 in the ordered set of TB identifiers.

In some embodiments, the TB identifier is a signature index, and the signature index is a signature index of a random access signature, that is, a TB in the TB set includes the random access signature. The random access signature is an element in an ordered set of random access signatures, and the ordered set of random access signatures includes Na random access signatures r(1), r(2), ..., r(Na). Here, Na is a size of the ordered set of random access signatures and the size of the ordered set of TB identifiers, i = 1, 2, ..., Na, and a signature index of an $i^{th}$ random access signature r(i) in the ordered set of random access signatures is an $i^{th}$ element I(i) in the ordered set of TB identifiers, where the $i^{th}$ element I(i) in the ordered set of TB identifiers may be an integer i or an integer i-1.

It should be noted that the random access signature may be a pilot, a reference signal, a preamble, a spread spectrum sequence, an interleaver, an interleaver pattern, an interleaver sequence, a scrambling sequence, a sparse code sequence, or the like.

In some embodiments, the second node determines a random access signature of a TB according to a UE identifier of the TB, as a random access signature included in the TB in the TB set. The random access signatures may be used for the first node to distinguish between different TBs in the TB set in the signal containing the TB set.

In some embodiments, the second node determines a random access signature of a TB according to a higher layer parameter, as a random access signature included in the TB in the TB set. The random access signatures may be used for the first node to distinguish between different TBs in the TB set in the signal containing the TB set.

It should be noted that the first node and the second node may be any network elements with data reception and signaling transmission functions such as base stations, relays, or terminal devices.

At S2000, information about a set of correct TBs is obtained according to the TB set.

It should be noted that the information about the set of correct TBs includes a maximum quantity Pmax of correct TBs, an ordered set of TB identifiers, the size Na of the ordered set of TB identifiers, a set of identifiers of correct TBs, a quantity P of correct TBs, an intermediate codeword c, a TB error pattern a, or an ordered set Q of offset values. It should be noted that the feedback information can be obtained according to one or more of the foregoing information about the correct TB, that is, the generation of the feedback information does not necessarily require all the information.

In some embodiments, the maximum quantity Pmax of correct TBs is equal to the size Na of the ordered set of TB identifiers. In some other embodiments, the maximum quantity Pmax of correct TBs is configured by the first node. In some other embodiments, the maximum quantity Pmax of correct TBs is pre-configured by using a higher layer parameter.

It should also be noted that a quantity of elements in the ordered set Q of offset values is determined according to the maximum quantity Pmax of correct TBs. Numerical values of the elements in the ordered set Q of offset values are determined by the size Na of the ordered set of TB identifiers and indexes, in the ordered set Q of offset values, of the elements in the ordered set Q of offset values.

In some embodiments, the ordered set Q of offset values includes Pmax non-negative integers Q(1), Q(2), ..., Q(Pmax), where for i = 1, 2, ..., Pmax, an $i^{th}$ element Q(i) in the ordered set Q of offset values is equal to $\sum_{j=0}^{i-1} 2^{\left\lceil \log_2 \binom{Na}{j} \right\rceil}$, where $\left\lceil \log_2 \binom{Na}{j} \right\rceil$ is the smallest integer greater than or equal to $\log_2 \binom{Na}{j}$, and $\binom{Na}{j}$ is a number of combinations of Na choosing j.

In some embodiments, the ordered set Q of offset values includes Pmax non-negative integers Q(1), Q(2), ..., Q(Pmax), where for i = 1, 2, ..., Pmax, an $i^{th}$ element Q(i) in the ordered set Q of offset values is equal to $\sum_{j=1}^{i-1} 2^{\left\lceil \log_2 \binom{Na}{j} \right\rceil}$, where $\left\lceil \log_2 \binom{Na}{j} \right\rceil$ is the smallest integer greater than or equal to $\log_2 \binom{Na}{j}$, and $\binom{Na}{j}$ is a number of combinations of Na choosing j.

In some embodiments, the ordered set Q of offset values includes Pmax+2 non-negative integers Q(1), Q(2), ..., Q(Pmax), Q(Pmax+1), Q(Pmax+2), where Q(1) = 0, for i = 2, ..., Pmax, Pmax+1, Pmax+2, the $i^{th}$ element Q(i) in the ordered set Q of offset values is equal to $\sum_{j=0}^{i-2} \binom{Na}{j}$, where $\binom{Na}{j}$ is a number of combinations of Na choosing j.

In some embodiments, the ordered set Q of offset values includes Pmax+1 non-negative integers Q(1), Q(2), ..., Q(Pmax), Q(Pmax+1), where Q(1) = 0, and for i = 2, ..., Pmax, Pmax+ 1, the $i^{th}$ element Q(i) in the ordered set Q of offset values is equal to $\sum_{j=1}^{i-1} \binom{Na}{j}$, where $\binom{Na}{j}$ is a number of combinations of Na choosing j.

In some embodiments, the information about the set of correct TBs is the set of identifiers of correct TBs, and the set of identifiers of correct TBs is a set of UE identifiers included in correctly-received TBs in the TB set. The correctly-received TB is a TB whose acknowledgment state is a positive acknowledgment ACK. A UE identifier belonging to the set of identifiers of correct TBs is used to indicate that an acknowledgment state of a TB corresponding to the UE identifier is positive acknowledgment ACK. A UE identifier not belonging to the set of identifiers of correct TBs is used to indicate that an acknowledgment state of a TB corresponding to the UE identifier is negative acknowledgment NACK.

In some embodiments, the information about the set of correct TBs is the set of identifiers of correct TBs, and the set of identifiers of correct TBs is a set of index values of UE identifiers. The correctly-received TB is a TB whose acknowledgment state is a positive acknowledgment ACK. An index value of a UE identifier belonging to the set of identifiers of correct TBs is used to indicate that an acknowledgment state of a TB corresponding to the index value of the UE identifier is positive acknowledgment ACK. An index value of a UE identifier not belonging to the set of identifiers of correct TBs is used to indicate that an acknowledgment state of a TB corresponding to the index value of the UE identifier is negative acknowledgment NACK.

In some embodiments, the information about the set of correct TBs is the set of identifiers of correct TBs, and the set of identifiers of correct TBs is a set of signature indexes of random access signatures corresponding to correctly-received TBs in the TB set. The correctly-received TB is a TB whose acknowledgment state is a positive acknowledgment ACK. A signature index of a random access signature belonging to the set of identifiers of correct TBs is used to indicate that an acknowledgment state of a TB corresponding to the random access signature is positive acknowledgment ACK. A signature index of a random access signature not belonging to the set of identifiers of correct TBs is used to indicate that an acknowledgment state of a TB corresponding to the random access signature is negative acknowledgment NACK.

At step S3000, the information about the set of correct TBs is encoded to obtain feedback information, where the feedback information is used to represent a reception condition of the TB sent by the at least one second node. The encoding processing includes compression coding performed on the information about the set of correct TBs.

In some embodiments, binary representation is performed on offset value elements in the ordered set of offset values to obtain an offset value bit sequence having the same length as the feedback information. By performing mapping processing on the set of identifiers of correct TBs, binary addition calculation is performed on the offset value bit sequence and the set of identifiers of correct TBs after the mapping processing to obtain the feedback information.

In some embodiments, compression coding is performed on the set of identifiers of correct TBs to obtain an intermediate codeword, and then the intermediate codeword and the offset value bit sequence are added to obtain the feedback information.

In some embodiments, according to the information about the set of correct TBs, a TB error pattern is obtained, then the TB error pattern is mapped to a feedback information bit sequence, and the feedback information bit sequence is determined as the feedback information.

In some embodiments, compression coding is performed on the TB error pattern to obtain an intermediate codeword, and then the intermediate codeword and the offset value bit sequence are added to obtain the feedback information.

A process of encoding the information about the set of correct TBs will be described in detail below by using embodiments and the accompanying drawings.

At step S4000, the feedback information is sent to the at least one second node.

In some embodiments, the first node sends the feedback information to the sequence of one or more second nodes, where the feedback information can represent a reception condition at the first node of the TB sent by the at least one second node.

The information transmission method provided by the embodiment can minimize a quantity of input bits of channel coding, thereby saving spectrum resources and improving data transmission efficiency.

In some embodiments, the first node has no correctly-received TB, and the set of identifiers of correct TBs is an empty set, that is, when P = 0, the first node determines that a length Nf of the feedback information f is 0, that is, the feedback information f is an empty sequence. The first node determines that a signal including the feedback information f which is an empty sequence is a null signal. In other words, the first node determines that the signal including the feedback information f is a zero power signal.

In the information transmission method provided by the above embodiment, the first node sends the zero power signal, so that energy overheads are reduced, and a second node in the sequence of second nodes does not receive the signal including the feedback information f (that is, the zero power signal) successfully. Therefore, the second node in the sequence of second nodes can determine that the feedback information is negative acknowledgment NACK.

Next, an embodiment of calculating an ordered set of offset values is provided.

In some embodiments, a length Nf of feedback information f is determined according to a maximum quantity Pmax of correct TBs and a size Na of an ordered set of TB identifiers.

In some embodiments, the length Nf of the feedback information f is greater than or equal to

$$\left\lceil \log_2\left(\sum_{i=0}^{Pmax} 2^{\left\lceil \log_2 \binom{Na}{i} \right\rceil}\right) \right\rceil.$$

In some embodiments, the length Nf of the feedback information f is greater than or equal to

$$\left\lceil \log_2\left(\sum_{i=1}^{Pmax} 2^{\left\lceil \log_2 \binom{Na}{i} \right\rceil}\right) \right\rceil.$$

In some embodiments, the length Nf of the feedback information f is greater than or equal to

$$\left\lceil \log_2\left(\sum_{i=0}^{Pmax} \binom{Na}{i}\right) \right\rceil.$$

In some embodiments, the length Nf of the feedback information f is greater than or equal to $\left\lceil \log_2\left(\sum_{i=1}^{Pmax}\binom{Na}{i}\right)\right\rceil$.

In some embodiments, when $Nf = \left\lceil \log_2\left(\sum_{i=0}^{Pmax} 2^{\left\lceil \log_2\binom{Na}{i}\right\rceil}\right)\right\rceil$, an ordered set Q of offset values includes Pmax non-negative integers Q(1), Q(2), ..., Q(Pmax), where for i = 1, 2, ..., Pmax, an $i^{th}$ element Q(i) in the ordered set Q of offset values is equal to $\sum_{j=0}^{i-1} 2^{\left\lceil \log_2\binom{Na}{j}\right\rceil}$.

In some embodiments, when $Nf = \left\lceil \log_2\left(\sum_{i=1}^{Pmax} 2^{\left\lceil \log_2\binom{Na}{i}\right\rceil}\right)\right\rceil$, the ordered set Q of offset values includes Pmax non-negative integers Q(1), Q(2), ..., Q(Pmax), where Q(1) = 0, and for i = 2, ..., Pmax, an $i^{th}$ element Q(i) in the ordered set Q of offset values is equal to $\sum_{j=1}^{i-1} 2^{\left\lceil \log_2\binom{Na}{j}\right\rceil}$.

In some embodiments, when $Nf = \left\lceil \log_2\left(\sum_{i=0}^{Pmax}\binom{Na}{i}\right)\right\rceil$, the ordered set Q of offset values includes Pmax+2 non-negative integers Q(1), Q(2), ..., Q(Pmax), Q(Pmax+1), Q(Pmax+2), where Q(1) = 0, and for i = 2, 3, ..., Pmax+1, Pmax+2, an $i^{th}$ element Q(i) in the ordered set Q of offset values is equal to $\sum_{j=0}^{i-2}\binom{Na}{j}$.

In some embodiments, when $Nf = \left\lceil \log_2\left(\sum_{i=1}^{Pmax}\binom{Na}{i}\right)\right\rceil$, the ordered set Q of offset values includes Pmax+1 non-negative integers Q(1), Q(2), ..., Q(Pmax), Q(Pmax+1), where Q(1) = 0, and for i = 2, 3, ..., Pmax+1, an $i^{th}$ element Q(i) in the ordered set Q of offset values is equal to $\sum_{j=1}^{i-1}\binom{Na}{j}$.

It should be noted that in all embodiments of the present disclosure, $\lceil x \rceil$ is the smallest integer greater than or equal to x, $\binom{x}{y}$ is a number of combinations of x choosing y, and mod means a remainder function. For example, 0 mod 2 = 0, 1 mod 2 = 1, 3 mod 2 = 1, 5 mod 3 = 2, which will not be repeated subsequently.

Based on the obtained ordered set of offset values, an embodiment in which information about a set of correct TBs is encoded to obtain feedback information is provided.

FIG. 3 is a flowchart of determining feedback information according to a set of identifiers of correct TBs provided by an embodiment of the present disclosure. In an embodiment, compression coding performed by a first node on information about a set of correct TBs refers to a coding process of mapping $\sum_{i=0}^{P_{max}}\binom{Na}{i}$ sets of identifiers of correct TBs each including at most Pmax elements to a bit sequence with a length of Nf. When $Nf = \left\lceil \log_2\left(\sum_{i=0}^{Pmax} 2^{\left\lceil \log_2\binom{Na}{i}\right\rceil}\right)\right\rceil$, in the flow shown in FIG. 3, P is a quantity of correct TBs, Na is a size of an ordered set of TB identifiers, $Ni = \left\lceil \log_2\binom{Na}{P}\right\rceil$, I(1), I(2), ..., I(Na) are Na elements included in the ordered set of TB identifiers, BI is a set of identifiers of correct TBs, and f(j) is a $j^{th}$ bit of feedback information f. For i = 1, 2, ..., Pmax, a bit sequence [q(i, 1), q(i, 2), ..., q(i, Nf)] is binary representation of Nf bits of an $i^{th}$ element Q(i) of an ordered set Q of offset values. In other words, the bit sequence [q(i, 1), q(i, 2), ..., q(i, Nf)] is an offset value bit sequence corresponding to the offset value element Q(i), where q(i, 1) is a most significant bit, and q(i, Nf) is a least significant bit.

FIG. 4 is a flowchart of determining feedback information according to a set of identifiers of correct TBs provided by another embodiment of the present disclosure. In an embodiment, compression coding performed by a first node on a set of identifiers of correct TBs refers to a coding process of mapping $\sum_{i=1}^{P_{max}}\binom{Na}{i}$ sets of identifiers of correct TBs each including at most Pmax elements and at least one element to a bit sequence with a length of Nf. When $Nf = \left\lceil \log_2\left(\sum_{i=1}^{Pmax} 2^{\left\lceil \log_2\binom{Na}{i}\right\rceil}\right)\right\rceil$, in the flow shown in FIG. 4, P is a quantity of correct TBs, Na is a size of an ordered set of TB identifiers, $Ni = \left\lceil \log_2\binom{Na}{P}\right\rceil$, I(1), I(2), ..., I(Na) are Na elements included in the ordered set of TB identifiers, BI is a set of identifiers of correct TBs, and f(j) is a $j^{th}$ bit of feedback information f. For i = 1, 2, ..., Pmax, a bit sequence [q(i, 1), q(i, 2), ..., q(i, Nf)] is binary representation of Nf bits of an $i^{th}$ element Q(i) of an ordered set Q of offset values. In other words, the bit sequence [q(i, 1), q(i, 2), ..., q(i, Nf)] is an offset value bit sequence corresponding to the offset value element Q(i), where q(i, 1) is a most significant bit, and q(i, Nf) is a least significant bit.

Next, several embodiments of calculating a TB error pattern are provided.

In some embodiments, a TB error pattern a is determined according to at least one of the following: an ordered set of TB identifiers, a size Na of an ordered set of TB identifiers, a set of identifiers of correct TBs, or a quantity P of correct TBs.

FIG. 5 is a flowchart of a method for determining a TB error pattern provided by an embodiment of the present disclosure. As shown in FIG. 5, a TB error pattern a is determined by the following steps S3510, S3521, and S3522.

At step S3510, it is determined whether each element in an ordered set of TB identifiers belongs to a set of identifiers of correct TBs.

At step S3521, in response to each element in the ordered set of TB identifiers belonging to the set of identifiers of correct TBs, an $i^{th}$ bit of the TB error pattern a(i) = ack.

At step S3522, in response to each element in the ordered set of TB identifiers not belonging to the set of identifiers of correct TBs, the $i^{th}$ bit of the TB error pattern a(i) = nack.

It can be understood that the "ack" bit is used to indicate that an acknowledgment state of a TB is positive acknowledgment ACK, and the "nack" bit is used to indicate that an acknowledgment state of a TB is negative acknowledgment NACK. In other words, a(i) = ack indicates that an acknowledgment state of a TB corresponding to an $i^{th}$ element in the ordered set of TB identifiers is positive acknowledgment ACK, and a(i) = nack indicates that an acknowledgment state of a TB corresponding to the $i^{th}$ element in the ordered set of TB identifiers is negative acknowledgment NACK.

In some embodiments, the "ack" bit is bit "1" and the "nack" bit is bit "0".

In some embodiments, the "ack" bit is bit "0" and the "nack" bit is bit "1".

FIG. 6 is a flowchart of a method for determining a TB error pattern provided by another embodiment of the present disclosure. As shown in FIG. 6, a TB error pattern a is determined by the following steps S3610, S3620, and S3630.

At step S3610, according to a preset length of a TB error pattern, an initial pattern, of the TB error pattern, corresponding to the preset length is obtained, where each element in the initial pattern of the TB error pattern corresponds to a negative acknowledgment bit.

In some embodiments, the TB error pattern is set to be a sequence having a length of Na and each element being a "nack" bit, where Na is a size of an ordered set of TB identifiers.

At step S3620, in the initial pattern of the TB error pattern according to a set of correct TBs, a bit with a sequence number equal to an element in the set of correct TBs is set as a positive acknowledgment bit.

At step S3630, the initial pattern of the TB error pattern is determined as the TB error pattern.

In some embodiments, according to a set of correct TBs, BI = {BI(1), BI(2), ..., BI(P)}, for i = 1, 2, ..., P, a $BI(i)^{th}$ bit in the initial pattern of the TB error pattern is set to a(BI(i)) = ack, and an updated initial pattern of the TB error pattern is the TB error pattern, where P is a quantity of correct TBs.

It can be understood that an "ack" bit is used to indicate that an acknowledgment state of a TB is positive acknowledgment ACK, and the "nack" bit is used to indicate that an acknowledgment state of a TB is negative acknowledgment NACK. In other words, a(i) = ack indicates that an acknowledgment state of a TB corresponding to an $i^{th}$ element in the ordered set of TB identifiers is positive acknowledgment ACK, and a(i) = nack indicates that an acknowledgment state of a TB corresponding to the $i^{th}$ element in the ordered set of TB identifiers is negative acknowledgment NACK.

In some embodiments, the "ack" bit is bit "1" and the "nack" bit is bit "0".

In some embodiments, the "ack" bit is bit "0" and the "nack" bit is bit "1".

Based on the obtained TB error pattern, an embodiment in which information about a set of correct TBs is encoded to obtain feedback information is provided.

FIG. 7 is a flowchart of determining feedback information according to a TB error pattern provided by an embodiment of the present disclosure. Compression coding performed by a first node on a TB error pattern means mapping $\sum_{i=0}^{P_{max}}\binom{Na}{i}$ TB error patterns a each having a length of Na and including at most Pmax "ack" bits to a bit sequence with a length of Nf. When Nf = $\left\lceil \log_2\left(\sum_{i=0}^{Pmax} 2^{\left\lceil \log_2\binom{Na}{i}\right\rceil}\right)\right\rceil$, in the flow shown in FIG. 7, P is a quantity of correct TBs, Na is a size of an ordered set of TB identifiers, $Ni = \left\lceil \log_2\binom{Na}{P}\right\rceil$, a is the TB error pattern, and f(j) is a $j^{th}$ bit of feedback information f. For i = 1, 2, ..., Pmax, a bit sequence [q(i, 1), q(i, 2), ..., q(i, Nf)] is binary representation of Nf bits of an $i^{th}$ element Q(i) of an ordered set Q of offset values. In other words, the bit sequence [q(i, 1), q(i, 2), ..., q(i, Nf)] is an offset value bit sequence corresponding to the offset value element Q(i), where q(i, 1) is a most significant bit, and q(i, Nf) is a least significant bit.

FIG. 8 is a flowchart of determining feedback information according to a TB error pattern provided by another embodiment of the present disclosure. Compression coding performed by a first node on a TB error pattern means mapping $\sum_{i=1}^{P_{max}}\binom{Na}{i}$ TB error patterns a each having a length of Na and including at most Pmax "ack" bits and at least one "ack" bit to a bit sequence with a length of Nf. When $Nf = \left\lceil \log_2\left(\sum_{i=1}^{Pmax} 2^{\left\lceil \log_2\binom{Na}{i}\right\rceil}\right)\right\rceil$, in the flow shown in FIG. 8, P is a quantity of correct TBs, Na is a size of an ordered set of TB identifiers, $Ni = \left\lceil \log_2\binom{Na}{P}\right\rceil$, a is the TB error pattern, and f(j) is a $j^{th}$ bit of feedback information f. For i = 1, 2, ..., Pmax, a bit sequence [q(i, 1), q(i, 2), ..., q(i, Nf)] is binary representation of Nf bits of an $i^{th}$ element Q(i) of an ordered set Q of offset values. In other words, the bit sequence [q(i, 1), q(i, 2), ..., q(i, Nf)] is an offset value bit sequence corresponding to the offset value element Q(i), where q(i, 1) is a most significant bit, and q(i, Nf) is a least significant bit.

In some embodiments, an intermediate codeword c is determined by the first node according to at least any one or any combination of the following parameters: the ordered set of TB identifiers, the size Na of the ordered set of TB identifiers, a set of identifiers of correct TBs, a quantity P of correct TBs, the TB error pattern a, and a maximum quantity Pmax of correct TBs.

In some embodiments, a length Nc of the intermediate codeword c is greater than or equal to $\left\lceil \log_2 \binom{Na}{P} \right\rceil$.

In some embodiments, the length Nc of the intermediate codeword c is greater than or equal to a length of the feedback information f.

In some embodiments, the intermediate codeword c includes an all-zero sequence with a length of $Nf - \left\lceil \log_2 \binom{Na}{P} \right\rceil$, where Nf is the length of the feedback information f.

In some embodiments, the intermediate codeword is obtained by compression coding on the set of identifiers of correct TBs, which is implemented by arithmetic coding of mapping $\binom{Na}{P}$ sets of identifiers of correct TBs each including P elements to a bit sequence with a length of $\left\lceil \log_2 \binom{Na}{P} \right\rceil$. Next, several embodiments of calculating an intermediate codeword are provided.

FIG. 9 is a flowchart of determining an intermediate codeword according to a set of identifiers of correct TBs provided by an embodiment of the present disclosure. As shown in the figure, in some embodiments, P is a quantity of correct TBs, Na is a size of an ordered set of TB identifiers, I(1), I(2), ..., I(Na) are Na elements included in the ordered set of TB identifiers, BI is a set of identifiers of correct TBs, c(j) is a $j^{th}$ bit of an intermediate codeword c, and $Nc = \left\lceil \log_2 \binom{Na}{P} \right\rceil$ is a length of the intermediate codeword c.

FIG. 10 is a flowchart of determining an intermediate codeword according to a set of identifiers of correct TBs provided by another embodiment of the present disclosure. As shown in the figure, in other embodiments, P is a quantity of correct TBs, Na is a size of an ordered set of TB identifiers, I(1), I(2), ..., I(Na) are Na elements included in the ordered set of TB identifiers, BI is a set of identifiers of correct TBs, c(j) is a $j^{th}$ bit of an intermediate codeword c, $Ni = \left\lceil \log_2 \binom{Na}{P} \right\rceil$, Nc = Nf is a length of the intermediate codeword c, and Nf is a length of feedback information f, where the intermediate codeword c includes an all-zero sequence with a length of Nf-Ni. In the flowchart of FIG. 10, the first Nf-Ni bits of the intermediate codeword c are bits "0".

In some embodiments, the intermediate codeword is obtained by compression coding on a TB error pattern, which is implemented by arithmetic coding of mapping $\binom{Na}{P}$ bit sequences each having a length of Na and including P "ack" bits to a bit sequence with a length of $\left\lceil \log_2 \binom{Na}{P} \right\rceil$. Next, several embodiments of calculating an intermediate codeword are provided.

FIG. 11 is a flowchart of determining an intermediate codeword according to a TB error pattern provided by an embodiment of the present disclosure. As shown in the figure, in some embodiments, P is a quantity of correct TBs, Na is a size of an ordered set of TB identifiers, a(i) is an $i^{th}$ bit of a TB error pattern a, c(j) is a jth bit of an intermediate codeword c, and $Nc = \left\lceil \log_2 \binom{Na}{P} \right\rceil$ is a length of the intermediate codeword c.

FIG. 12 is a flowchart of determining an intermediate codeword according to a TB error pattern provided by another embodiment of the present disclosure. As shown in the figure, P is a quantity of correct TBs, Na is a size of an ordered set of TB identifiers, a(i) is an $i^{th}$ bit of a TB error pattern a, c(j) is a $j^{th}$ bit of an intermediate codeword c,

$$Ni = \left\lceil \log_2 \binom{Na}{P} \right\rceil$$

, Nc = Nf is a length of the intermediate codeword c, and Nf is a length of feedback information f. The intermediate codeword c includes an all-zero sequence with a length of Nf-Ni. In the flowchart of FIG. 12, the first Nf-Ni bits of the intermediate codeword c are bits "0".

After the intermediate codeword is determined, the feedback information is determined according to the intermediate codeword. An embodiment of determining the feedback information according to the intermediate codeword is provided below.

FIG. 13 is a flowchart of determining feedback information according to an intermediate codeword provided by an embodiment of the present disclosure. As shown in the figure, P is a quantity of correct TBs, a bit sequence [q(P, 1), q(P, 2), ..., q(P, Nf)] is binary representation of Nf bits of a $P^{th}$ element Q(P) of an ordered set Q of offset values. In other words, the bit sequence [q(P, 1), q(P, 2), ..., q(P, Nf)] is an offset value bit sequence corresponding to the offset value element Q(P), where Nf is a length of feedback information f, Nc is a length of an intermediate codeword c, q(P, 1) is a most significant bit, and q(P, Nf) is a least significant bit.

In some embodiments, channel coding is performed on the feedback information to obtain a first coding sequence.

It should be noted that the channel coding may be, but is not limited to, polar coding, low-density parity check (LDPC) coding, convolutional coding, turbo coding, Reed-Muller (RM) coding, Reed-Solomon (RS) coding, Bose-Chaudhuri-Hocquenghem (BCH) coding, concatenated coding, cyclic coding, block coding, Hamming coding, Golay coding, repetition coding, single-parity-check (SPC) coding, cyclic redundancy check coding, superposition coding, sparse superposition coding, sparse regression coding, lattice coding, algebraic geometric coding, Goppa coding, polarization-adjusted convolutional (PAC) coding, pre-transformed polar coding, or parity-check polar coding.

Example 1:

In this example, a first node is a base station and a second node is a terminal device. This example includes a plurality of terminal devices which form a sequence of terminal devices, and a TB identifier is a UE identifier.

FIG. 14 is a schematic diagram of a relationship among a second node, a TB, and a UE identifier provided by an example of the present disclosure. As shown in FIG. 14, the base station receives a signal, including a TB set B, sent by a sequence of terminal devices. The sequence of terminal devices includes Nu = 4 terminal devices: SN(1), SN(2), SN(3), and SN(4), and the TB set B includes Nb = 4 TBs: b(1), b(2), b(3), and b(4). The signal including the TB set B includes a signal including the TB b(1), a signal including the TB b(2), a signal including the TB b(3), and a signal including the TB b(4).

In this example, for t = 1, 2, 3, 4, a TB b(t) in the TB set B is sent to the base station by a terminal device SN(t) in the sequence of terminal devices. The TB b(t) in the TB set B includes a UE identifier of the terminal device SN(t), and the UE identifier of the terminal device SN(t) is an RA-RNTI. UE identifiers of the terminal devices SN(1), SN(2), SN(3) and SN(4) are 4, 3, 2 and 5, respectively, where the UE identifiers 4, 3, 2, 5 are elements of an ordered set of TB identifiers I = <I(1), I(2), I(3), I(4), I(5), I(6), I(7), I(8)> = <1, 2, 3, 4, 5, 6, 7, 8>. The ordered set I of TB identifiers includes Na = 8 UE identifiers 1, 2, 3, 4, 5, 6, 7, and 8.

In this example, a maximum quantity of correct TBs Pmax = 3 is configured by the base station. The set of identifiers of correct TBs is a set of UE identifiers included in correctly-received TBs in the TB set. In this example, the base station determines the following according to the signal including the TB set B: the set of identifiers of correct TBs is a set BI = {2, 3}, and a quantity P of correct TBs is equal to 2.

In this example, feedback information f is determined by compression coding by the base station according to the following parameters: a maximum quantity of correct TBs Pmax = 3, an ordered set I of TB identifiers, a size of the ordered set of TB identifiers Na = 8, the set BI of identifiers of correct TBs, the quantity of correct TBs P = 2, a TB error pattern a, an intermediate codeword c, and an ordered set Q of offset values. A length Nf of the feedback information f =

$$\left\lceil \log_2\left(\sum_{i=0}^{Pmax} 2^{\left\lceil \log_2 \binom{Na}{i} \right\rceil}\right) \right\rceil = \left\lceil \log_2\left(2^{\left\lceil \log_2 \binom{8}{0} \right\rceil} + 2^{\left\lceil \log_2 \binom{8}{1} \right\rceil} + 2^{\left\lceil \log_2 \binom{8}{2} \right\rceil} + 2^{\left\lceil \log_2 \binom{8}{3} \right\rceil}\right) \right\rceil = 7$$

, and the ordered set of offset values Q = <Q(1), Q(2), Q(3)> =

$$\left\langle 2^{\left\lceil \log_2 \binom{Na}{0} \right\rceil}, 2^{\left\lceil \log_2 \binom{Na}{0} \right\rceil} + 2^{\left\lceil \log_2 \binom{Na}{1} \right\rceil}, 2^{\left\lceil \log_2 \binom{Na}{0} \right\rceil} + 2^{\left\lceil \log_2 \binom{Na}{1} \right\rceil} + 2^{\left\lceil \log_2 \binom{Na}{2} \right\rceil} \right\rangle = <1, 9, 41>$$

.

In this example, offset value bit sequences corresponding to Nf = 7 binary-represented bits of integer offset values Q(1), Q(2), and Q(3) are

$$[q(1,1), q(1,2), q(1,3), q(1,4), q(1,5), q(1,6), q(1,7)] = [0, 0, 0, 0, 0, 0, 1],$$

$$[q(2,1), q(2,2), q(2,3), q(2,4), q(2,5), q(2,6), q(2,7)] = [0, 0, 0, 1, 0, 0, 1],$$

and

$$[q(3,1), q(3,2), q(3,3), q(3,4), q(3,5), q(3,6), q(3,7)] = [0, 1, 0, 1, 0, 0, 1],$$

respectively.

The intermediate codeword c is determined by the base station according to the following parameters: the size of the ordered set of TB identifiers Na = 8, the TB error pattern a, the quantity of correct TBs P = 2, and the maximum quantity of correct TBs Pmax = 3, where the intermediate codeword c is a bit sequence with a length Nc = Nf = 7.

In this example, the TB error pattern a is determined by the base station according to the following parameters: the ordered set I of TB identifiers, the size of the ordered set of TB identifiers Na = 8, and the set BI of identifiers of correct TBs, where the TB error pattern a is a bit sequence with a length Na = 8.

In the TB error pattern, an "ack" bit indicating positive acknowledgment ACK is bit "1", and a "nack" bit indicating negative acknowledgment NACK is bit "0".

FIG. 15 is a diagram of a mapping relationship among a quantity P of correct TBs, a set BI of correct TBs, a TB error pattern a, an intermediate codeword c, an offset value bit sequence [q(P,1), q(P,2), q(P,3), q(P,4), q(P,5), q(P,6), q(P,7)], and feedback information f provided by an example of the present disclosure. According to the mapping relationship shown in FIG. 15 (only a mapping relationship involved in this example is shown in the figure), the base station determines the feedback information f according to the following method.

The base station determines the TB error pattern a = [0, 1, 1, 0, 0, 0, 0, 0] according to the ordered set I of TB identifiers, the size of the ordered set of TB identifiers Na = 8, and the set BI of identifiers of correct TBs.

As shown in FIG. 12, the base station performs compression coding on the TB error pattern a = [0, 1, 1, 0, 0, 0, 0, 0] to obtain an intermediate codeword c = [0, 0, 1, 0, 1, 1, 1]. The compression coding performed by the base station on the TB error pattern a refers to arithmetic coding of mapping $\binom{Na}{P} = \binom{8}{2} = 28$ bit sequences each having a length Na = 8 and including P = 2 bits "1" to a bit sequence with a length of $\left\lceil \log_2 \binom{Na}{P} \right\rceil = \left\lceil \log_2 \binom{8}{2} \right\rceil = 5$, and $Ni = \left\lceil \log_2 \binom{Na}{P} \right\rceil =$ 5, where the intermediate codeword c includes an all-zero sequence with a length of Nf - $\left\lceil \log_2 \binom{Na}{P} \right\rceil = 7 - \left\lceil \log_2 \binom{8}{2} \right\rceil = 2$.

According to the following program execution flow, the base station obtains feedback information f = [0, 1, 0, 0, 0, 0, 0] according to the intermediate codeword c = [0, 0, 1, 0, 1, 1, 1] and the offset value bit sequence [q(2,1), q(2,2), q(2,3), q(2,4), q(2,5), q(2,6), q(2,7)] corresponding to Nf = 7 binary-represented bits of the integer offset value Q(2).

| | |
|---|---|
| 1 | Initialization: j = Nf; w = 0; |
| 2 | while j > 0; |
| 3 | s = q(P,j) + c(j) + w; |
| 4 | f(j) = s mod 2; |
| 5 | j =j - 1; |
| 6 | w=0; |

(continued)

| | |
|---|---|
| 7 | if s > 1 |
| 8 | w = 1; |
| 9 | end |
| 10 | end |

In this example, the base station sends a signal including the feedback information f = [0, 1, 0, 0, 0, 0, 0] to a sequence of terminal devices <SN(1), SN(2), SN(3), SN(4)>. The sequence of terminal devices <SN(1), SN(2), SN(3), SN(4)> receives the signal including the feedback information f. Terminal devices SN(1), SN(2), SN(3), and SN(4) separately decode the signal including the feedback information f, and determine acknowledgment of TBs b(1), b(2), b(3), and b(4), respectively, according to the following method.

If the terminal device SN(1) fails in decoding, the terminal device SN(1) determines that acknowledgment of a TB b(1) is negative acknowledgment NACK. If the terminal device SN(1) performs decoding successfully and obtains the set BI of identifiers of correct TBs, and the terminal device SN(1) determines that a UE identifier 4 of the terminal device SN(1) does not belong to the set BI of identifiers of correct TBs, then the terminal device SN(1) determines that acknowledgment of the TB b(1) is negative acknowledgment NACK.

If the terminal device SN(2) fails in decoding, the terminal device SN(2) determines that acknowledgment of a TB b(2) is negative acknowledgment NACK. If the terminal device SN(2) performs decoding successfully and obtains the set BI of identifiers of correct TBs, and the terminal device SN(2) determines that a UE identifier 3 of the terminal device SN(2) belongs to the set BI of identifiers of correct TBs, then the terminal device SN(2) determines that acknowledgment of the TB b(2) is positive acknowledgment ACK.

If the terminal device SN(3) fails in decoding, the terminal device SN(3) determines that acknowledgment of a TB b(3) is negative acknowledgment NACK. If the terminal device SN(3) performs decoding successfully and obtains the set BI of identifiers of correct TBs, and the terminal device SN(3) determines that a UE identifier 2 of the terminal device SN(3) belongs to the set BI of identifiers of correct TBs, then the terminal device SN(3) determines that acknowledgment of the TB b(3) is positive acknowledgment ACK.

If the terminal device SN(4) fails in decoding, the terminal device SN(4) determines that acknowledgment of a TB b(4) is negative acknowledgment NACK. If the terminal device SN(4) performs decoding successfully and obtains the set BI of identifiers of correct TBs, and the terminal device SN(4) determines that a UE identifier 5 of the terminal device SN(4) does not belong to the set BI of identifiers of correct TBs, then the terminal device SN(4) determines that acknowledgment of the TB b(4) is negative acknowledgment NACK.

Example 2:

A difference between this example and Example 1 is that in this example, for t = 1, 2, 3, 4, a UE identifier of a terminal device SN(t) is a TC-RNTI. An intermediate codeword c is a bit sequence with a length

$$\mathrm{Nc} = \left\lceil \log_2 \binom{\mathrm{Na}}{\mathrm{P}} \right\rceil = \left\lceil \log_2 \binom{8}{2} \right\rceil = 5$$

.

Another difference between this example and Example 1 is that in this example, an "ack" bit is bit "0" and a "nack" bit is bit "1 ". FIG. 16 is a diagram of a mapping relationship among a quantity P of correct TBs, a set BI of correct TBs, a TB error pattern a, an intermediate codeword c, an offset value bit sequence [q(P,1), q(P,2), q(P,3), q(P,4), q(P,5), q(P,6), q(P,7)], and feedback information f provided by an example of the present disclosure. According to the mapping relationship shown in FIG. 16 (only a mapping relationship involved in this example is shown in the figure), a base station determines the feedback information f according to the following method.

The base station determines the TB error pattern a = [1, 0, 0, 1, 1, 1, 1, 1] according to an ordered set I of TB identifiers, a size of the ordered set of TB identifiers Na = 8, and the set BI of identifiers of correct TBs.

As shown in FIG. 11, the base station performs compression coding on the TB error pattern a = [1, 0, 0, 1, 1, 1, 1, 1] to obtain an intermediate codeword c = [0,1,0,0,1]. The compression coding performed by the base station on the TB error pattern a refers to arithmetic coding of mapping $\binom{\mathrm{Na}}{\mathrm{P}} = \binom{8}{2} = 28$ bit sequences each having a length Na = 8 and including P = 2 bits "0" to a bit sequence with a length of $\left\lceil \log_2 \binom{Na}{P} \right\rceil = \left\lceil \log_2 \binom{8}{2} \right\rceil = 5$.

According to the program execution flow shown in FIG. 13, the base station obtains feedback information f= [0, 0, 1, 0, 0, 1, 0] according to the intermediate codeword c = [0,1,0,0,1] and an offset value bit sequence [q(2,1), q(2,2), q(2,3), q(2,4), q(2,5), q(2,6), q(2,7)] corresponding to Nf = 7 binary-represented bits of an integer offset value Q(2).

```
Initialization: i = Nc; j = Nf; w = 0;
while j > 0;
    s = 0;
    if i > 0
        s = c(i);
    end
    s = q(P,j) + s + w;
    f(j) = s mod 2;
    j = j-1;
    i=i-1;
    w = 0;
    if s > 1
        w = 1;
    end
end
```

The base station sends a signal including the feedback information f = [0, 0, 1, 0, 0, 1, 0] to a sequence of terminal devices <SN(1), SN(2), SN(3), SN(4)>.

In the information transmission method provided by the above example, the intermediate codeword c does not include an all-zero sequence with a length of $Nf - \left\lceil \log_2 \binom{Na}{P} \right\rceil$, which reduces storage overheads, saves storable resources, and improves information transmission efficiency.

Example 3:

A difference between this example and Example 1 is that in this example, a first node is a relay. For t = 1, 2, 3, 4, a UE identifier of a terminal device SN(t) is a C-RNTI.

Another difference between this example and Example 1 is that in this example, feedback information f is determined by compression coding by the relay according to the following parameters: a maximum quantity of correct TBs Pmax = 3, a size of an ordered set of TB identifiers Na = 8, a set BI of identifiers of correct TBs, a quantity of correct TBs P = 2, a TB error pattern a, and an ordered set Q of offset values. A length Nf of the feedback information f =

$$\left\lceil \log_2 \left( \sum_{i=0}^{Pmax} 2^{\left\lceil \log_2 \binom{Na}{i} \right\rceil} \right) \right\rceil = \left\lceil \log_2 \left( 2^{\left\lceil \log_2 \binom{8}{0} \right\rceil} + 2^{\left\lceil \log_2 \binom{8}{1} \right\rceil} + 2^{\left\lceil \log_2 \binom{8}{2} \right\rceil} + 2^{\left\lceil \log_2 \binom{8}{3} \right\rceil} \right) \right\rceil = 7$$

, and the ordered set of offset values Q = <Q(1), Q(2), Q(3)> =

$$\left\langle 2^{\left\lceil \log_2 \binom{Na}{0} \right\rceil}, 2^{\left\lceil \log_2 \binom{Na}{0} \right\rceil} + 2^{\left\lceil \log_2 \binom{Na}{1} \right\rceil}, 2^{\left\lceil \log_2 \binom{Na}{0} \right\rceil} + 2^{\left\lceil \log_2 \binom{Na}{1} \right\rceil} + 2^{\left\lceil \log_2 \binom{Na}{2} \right\rceil} \right\rangle = <1, 9, 41>$$

.

According to the mapping relationship shown in FIG. 15, the relay determines the feedback information f according to the following method.

The relay determines the TB error pattern a = [0, 1, 1, 0, 0, 0, 0, 0], according to the size of the ordered set of TB identifiers Na = 8 and the set BI of identifiers of correct TBs.

According to the program flow shown in FIG. 7, the relay performs compression coding on the TB error pattern a = [0, 1, 1, 0, 0, 0, 0, 0] to obtain feedback information f = [0, 1, 0, 0, 0, 0, 0]. The compression coding performed by the relay on the TB error pattern a refers to a coding method of mapping $\sum_{i=0}^{P_{max}} \binom{Na}{i} = \binom{8}{0} + \binom{8}{1} + \binom{8}{2} + \binom{8}{3} = 93$ TB error patterns each having a length of Na = 8 and including at most Pmax = 3 bits "1" to a bit sequence with a length of Nf = 7, where $Ni = \left\lceil \log_2 \binom{Na}{P} \right\rceil = \left\lceil \log_2 \binom{8}{2} \right\rceil = 5$ in the program flowchart shown in FIG. 8.

In the information transmission method provided by the above example, storage overheads of the intermediate codeword are saved, thereby reducing storable resources, and improving transmission efficiency.

Example 4:

A difference between this example and Example 1 is that in this example, for t = 1, 2, 3, 4, a UE identifier of a terminal device SN(t) is an MCS-C-RNTI.

In this example, feedback information f is determined by compression coding by a base station according to the following parameters: a maximum quantity of correct TBs Pmax = 3, an ordered set I of TB identifiers, a size of the ordered set of TB identifiers Na = 8, a set BI of identifiers of correct TBs, a quantity of correct TBs P = 2, a TB error pattern a, and an ordered set Q of offset values. A length Nf of the feedback information

$$f = \left\lceil \log_2 \left( \sum_{i=1}^{P_{max}} 2^{\left\lceil \log_2 \binom{Na}{i} \right\rceil} \right) \right\rceil = \left\lceil \log_2 \left( 2^{\left\lceil \log_2 \binom{8}{1} \right\rceil} + 2^{\left\lceil \log_2 \binom{8}{2} \right\rceil} + 2^{\left\lceil \log_2 \binom{8}{3} \right\rceil} \right) \right\rceil = 7$$

, and the ordered set of offset values Q = <Q(1), Q(2), Q(3)> = 

$$\left\langle 0, 2^{\left\lceil \log_2 \binom{Na}{1} \right\rceil}, 2^{\left\lceil \log_2 \binom{Na}{1} \right\rceil} + 2^{\left\lceil \log_2 \binom{Na}{2} \right\rceil} \right\rangle = \langle 0, 8, 40 \rangle$$

.

Offset value bit sequences corresponding to Nf = 7 binary-represented bits of integer offset values Q(1), Q(2), and Q(3) are:

[q(1,1), q(1,2), q(1,3), q(1,4), q(1,5), q(1,6), q(1,7)] = [0, 0, 0, 0, 0, 0, 0],
[q(2,1), q(2,2), q(2,3), q(2,4), q(2,5), q(2,6), q(2,7)] = [0, 0, 0, 1, 0, 0, 0],
and [q(3,1), q(3,2), q(3,3), q(3,4), q(3,5), q(3,6), q(3,7)] = [0, 1, 0, 1, 0, 0, 0], respectively.

FIG. 17 is a diagram of a mapping relationship among a quantity P of correct TBs, a set BI of correct TBs, a TB error pattern a, an intermediate codeword c, an offset value bit sequence [q(P,1), q(P,2), q(P,3), q(P,4), q(P,5), q(P,6), q(P,7)], and feedback information f provided by an example of the present disclosure. According to the mapping relationship shown in FIG. 17 (only a mapping relationship involved in this example is shown in the figure), the base station determines the feedback information f according to the following method.

The base station determines the TB error pattern a = [0, 1, 1, 0, 0, 0, 0, 0] according to the ordered set I of TB identifiers, the size of the ordered set of TB identifiers Na = 8, and the set BI of identifiers of correct TBs.

According to the program flow shown in FIG. 8, the base station performs compression coding on the TB error pattern a = [0, 1, 1, 0, 0, 0, 0, 0] to obtain feedback information f = [0, 0, 1, 1, 1, 1, 1]. The compression coding performed by the base station on the TB error pattern a refers to a coding method of mapping $\sum_{i=1}^{P_{max}} \binom{Na}{i} = \binom{8}{1} + \binom{8}{2} + \binom{8}{3} = 92$ TB error patterns each having a length of Na = 8 and including at most Pmax = 3 bits "1" and at least one bit "1" to a bit sequence with a length of Nf = 7, where

$$\mathrm{Ni} = \left\lceil \log_2 \binom{\mathrm{Na}}{\mathrm{P}} \right\rceil = \left\lceil \log_2 \binom{8}{2} \right\rceil = 5$$

Another difference between this example and Example 1 is that in this example, if the quantity P of correct TBs is 0, the length Nf of the feedback information f is 0, the feedback information f is an empty sequence, and a signal including the feedback information f is a zero power signal.

In the information transmission method provided by the above example, when the quantity P of correct TBs is 0, the feedback information f is a zero power signal, thereby reducing energy consumption. In contention-based grant-free random access, a first node cannot know in advance whether there is a user sending information in a current time slot. As a result, the first node needs to perform signal reception, signal decoding and acknowledgment feedback processing in each time slot. According to the above example, when the first node does not correctly receive any TB, the first node feeds back a zero power signal, that is, the first node does not perform acknowledgment feedback processing, which can reduce power consumption of the first node.

Example 5:

A difference between this example and Example 1 is that in this example, for t = 1, 2, 3, 4, a UE identifier of a terminal device SN(t) is a CS-RNTI.

Feedback information f is determined by compression coding by a base station according to the following parameters: a maximum quantity of correct TBs Pmax = 3, an ordered set I of TB identifiers, a size of the ordered set of TB identifiers Na = 8, a set BI of identifiers of correct TBs, a quantity of correct TBs P = 2, an intermediate codeword c, and an ordered set Q of offset values. A length Nf of the feedback information

$$\mathrm{f} = \left\lceil \log_2 \left( \sum_{i=1}^{\mathrm{Pmax}} 2^{\left\lceil \log_2 \binom{\mathrm{Na}}{i} \right\rceil} \right) \right\rceil = \left\lceil \log_2 \left( 2^{\left\lceil \log_2 \binom{8}{1} \right\rceil} + 2^{\left\lceil \log_2 \binom{8}{2} \right\rceil} + 2^{\left\lceil \log_2 \binom{8}{3} \right\rceil} \right) \right\rceil = 7$$

, and the ordered set of offset values Q = <Q(1), Q(2),

$$\mathrm{Q(3)>} = \left\langle 0, 2^{\left\lceil \log_2 \binom{\mathrm{Na}}{1} \right\rceil}, 2^{\left\lceil \log_2 \binom{\mathrm{Na}}{1} \right\rceil} + 2^{\left\lceil \log_2 \binom{\mathrm{Na}}{2} \right\rceil} \right\rangle = <0, 8, 40>$$

.

Another difference between this example and Example 1 is that in this example, Offset value bit sequences corresponding to Nf = 7 binary-represented bits of integer offset values Q(1), Q(2), and Q(3) are:

$$[q(1,1), q(1,2), q(1,3), q(1,4), q(1,5), q(1,6), q(1,7)] = [0, 0, 0, 0, 0, 0, 0],$$

$$[q(2,1), q(2,2), q(2,3), q(2,4), q(2,5), q(2,6), q(2,7)] = [0, 0, 0, 1, 0, 0, 0],$$

and

$$[q(3,1), q(3,2), q(3,3), q(3,4), q(3,5), q(3,6), q(3,7)] = [0, 1, 0, 1, 0, 0, 0],$$

respectively.

The intermediate codeword c is determined by the base station according to the following parameters: the size of the ordered set of TB identifiers Na = 8, the quantity of correct TBs P = 2, and the maximum quantity of correct TBs Pmax = 3, where the intermediate codeword c is a bit sequence with a length of Nc = Nf = 7.

According to the mapping relationship shown in FIG. 17, the base station determines the feedback information f according to the following method:

According to the program flow shown in FIG. 10, the base station performs compression coding on a set of identifiers of correct TBs BI = {2, 3} to obtain an intermediate codeword c = [0, 0, 1, 0, 1, 1, 1]. The compression coding performed by the base station on the set of identifiers of correct TBs BI = {2, 3} refers to arithmetic coding of mapping

$$\binom{\mathrm{Na}}{\mathrm{P}} = \binom{8}{2} = 28$$

sets of identifiers of correct TBs each including P = 2 elements to a bit sequence with a length of Ni = $\left\lceil \log_2 \binom{Na}{P} \right\rceil = \left\lceil \log_2 \binom{8}{2} \right\rceil = 5$, where the first $Nf - \left\lceil \log_2 \binom{Na}{P} \right\rceil = 7 - 5 = 2$ bits of the intermediate codeword c = [0, 0, 1, 0, 1, 1, 1] is an all-zero sequence.

As shown in FIG. 17, according to the method described below, the base station obtains feedback information f = [0, 0, 1, 1, 1, 1, 1] according to the intermediate codeword c = [0, 0, 1, 0, 1, 1, 1] and an offset value bit sequence [q(2,1), q(2,2), q(2,3), q(2,4), q(2,5), q(2,6), q(2,7)] corresponding to Nf = 7 binary-represented bits of an integer offset value Q(2).

```
Initialization: j = Nf; w = 0;
while j > 0;
    s = q(P,j) + c(j) + w;
    f(j) = s mod 2;
    j = j - 1;
    w=0;
    if s > 1
        w = 1;
    end
end
```

The base station sends a signal including the feedback information f = [0, 0, 1, 1, 1, 1, 1] to a sequence of terminal devices <SN(1), SN(2), SN(3), SN(4)>.

In the information transmission method provided by the above example, when a quantity P of correct TBs is 0, the feedback information f is a zero power signal, thereby reducing energy consumption. In addition, because the length of Nf is generally much smaller than that of Na, this example directly determines the intermediate codeword c using the set of identifiers of correct TBs, thereby saving storage space.

Example 6:

In this example, a first node is a base station, and a second node is a terminal device. There are a plurality of terminal devices which form a sequence of terminal devices, and a TB identifier is a UE identifier.

FIG. 18 is a schematic diagram of a relationship among a second node, a TB, a UE identifier, a random access signature, and a signature index provided by an example of the present disclosure. As shown in FIG. 18, the base station receives a signal, including a TB set B, sent by a sequence of terminal devices. The sequence of terminal devices includes Nu = 4 terminal devices: SN(1), SN(2), SN(3), and SN(4), and the TB set B includes Nb = 4 TBs: b(1), b(2), b(3), and b(4). The signal including the TB set B includes a signal including the TB b(1), a signal including the TB b(2), a signal including the TB b(3), and a signal including the TB b(4).

In this example, for t = 1, 2, 3, 4, a TB b(t) in the TB set B is sent to the base station by a terminal device SN(t) in the sequence of terminal devices. The TB b(t) in the TB set B includes a UE identifier and a random access signature of the terminal device SN(t).

In this example, the UE identifier of the terminal device SN(t) is a PEI, and the random access signature is a reference signal. UE identifiers of the terminal devices SN(1), SN(2), SN(3) and SN(4) are 4, 3, 2 and 5, respectively, where the UE identifiers 4, 3, 2, 5 are elements of an ordered set of TB identifiers I = <I(1), I(2), I(3), I(4), I(5), I(6), I(7), I(8)> = <1, 2, 3, 4, 5, 6, 7, 8>. The ordered set I of TB identifiers includes Na = 8 UE identifiers 1, 2, 3, 4, 5, 6, 7, and 8.

In this example, the reference signal is an element of an ordered set of random access signatures. The ordered set of random access signatures includes six reference signals r(1), r(2), r(3), r(4), r(5), and r(6), where the signature indexes of the reference signals r(1), r(2), r(3), r(4), r(5) and r(6) are 0, 1, 2, 3, 4 and 5, respectively. Random access signatures included in the TBs b(1), b(2), b(3), b(4) are determined by the terminal devices SN(1), SN(2), SN(3), SN(4) according to the UE identifiers 4, 3, 2, 5 of the terminal devices SN(1), SN(2), SN(3), SN(4) in the following manner.

A signature index of a reference signal included in the TB b(t) = a remainder obtained by dividing the square of the UE identifier of the terminal device SN(t) by 6.

The UE identifiers 4, 3, 2 and 5 of the terminal devices SN(1), SN(2), SN(3) and SN(4) are substituted into the above formula, to obtain signature indexes of reference signals of the terminal devices SN(1), SN(2), SN(3) and SN(4) as 4, 3, 4 and 1, respectively, and finally obtain the reference signals of the terminal devices SN(1), SN(2), SN(3) and SN(4) as r(5), r(4), r(5) and r(2), respectively.

In this example, a maximum quantity of correct TBs Pmax = 3 is configured by the base station. The set of identifiers of correct TBs is a set of UE identifiers included in correctly-received TBs in the TB set. The base station determines the following according to the signal including the TB set B: the set of identifiers of correct TBs is a set BI = {2, 3}, and a quantity P of correct TBs is equal to 2.

In this example, feedback information f is determined by compression coding by a base station according to the following parameters: a maximum quantity of correct TBs Pmax = 3, an ordered set I of TB identifiers, a size of the ordered set of TB identifiers Na = 8, a set BI of identifiers of correct TBs, a quantity of correct TBs P = 2, an intermediate codeword c, and an ordered set Q of offset values. A length Nf of the feedback information

$$f = \left\lceil \log_2\left(\sum_{i=1}^{Pmax} 2^{\left\lceil \log_2\binom{Na}{i}\right\rceil}\right)\right\rceil = \left\lceil \log_2\left(2^{\left\lceil \log_2\binom{8}{1}\right\rceil} + 2^{\left\lceil \log_2\binom{8}{2}\right\rceil} + 2^{\left\lceil \log_2\binom{8}{3}\right\rceil}\right)\right\rceil = 7$$

, and the ordered set of offset values Q = <Q(1), Q(2),

$$Q(3)> = \left\langle 0, 2^{\left\lceil \log_2\binom{Na}{1}\right\rceil}, 2^{\left\lceil \log_2\binom{Na}{1}\right\rceil} + 2^{\left\lceil \log_2\binom{Na}{2}\right\rceil}\right\rangle = <0, 8, 40>$$

.

In this example, Offset value bit sequences corresponding to Nf = 7 binary-represented bits of integer offset values Q(1), Q(2), and Q(3) are:

[q(1,1), q(1,2), q(1,3), q(1,4), q(1,5), q(1,6), q(1,7)] = [0, 0, 0, 0, 0, 0, 0],
[q(2,1), q(2,2), q(2,3), q(2,4), q(2,5), q(2,6), q(2,7)] = [0, 0, 0, 1, 0, 0, 0],
and [q(3,1), q(3,2), q(3,3), q(3,4), q(3,5), q(3,6), q(3,7)] = [0, 1, 0, 1, 0, 0, 0], respectively.

In this example, the intermediate codeword c is determined by the base station according to the following parameters: the size of the ordered set of TB identifiers Na = 8, the quantity of correct TBs P = 2, and the maximum quantity of correct TBs Pmax = 3, where the intermediate codeword c is a bit sequence with a length of

$$Nc = \left\lceil \log_2\binom{Na}{P}\right\rceil = \left\lceil \log_2\binom{8}{2}\right\rceil = 5$$

.

In this example, an "ack" bit is bit "1" and a "nack" bit is bit "0".

FIG. 19 is a diagram of a mapping relationship among a quantity P of correct TBs, a set BI of correct TBs, a TB error pattern a, an intermediate codeword c, an offset value bit sequence [q(P,1), q(P,2), q(P,3), q(P,4), q(P,5), q(P,6), q(P,7)], and feedback information f provided by an example of the present disclosure. According to the mapping relationship shown in FIG. 19 (only a mapping relationship involved in this example is shown in the figure), a base station determines the feedback information f according to the following method.

As shown in FIG. 19, the base station performs compression coding on a set of identifiers of correct TBs BI = {2, 3} to obtain an intermediate codeword c = [1, 0, 1, 1, 1]. The compression coding performed by the base station on the set of identifiers of correct TBs BI = {2, 3} refers to arithmetic coding of mapping $\binom{Na}{P} = \binom{8}{2} = 28$ sets of identifiers of correct TBs each including P = 2 elements to a bit sequence with a length of $\left\lceil \log_2\binom{Na}{P}\right\rceil = \left\lceil \log_2\binom{8}{2}\right\rceil = 5$.

According to the method described below, the base station obtains feedback information f = [0, 0, 1, 1, 1, 1, 1] according to the intermediate codeword c = [1, 0, 1, 1, 1] and an offset value bit sequence [q(2,1), q(2,2), q(2,3), q(2,4), q(2,5), q(2,6), q(2,7)] corresponding to Nf = 7 binary-represented bits of an integer offset value Q(2).

| | |
|---|---|
| 1 | Initialization: i = Nc; j = Nf; w = 0; |
| 2 | while j > 0; |
| 3 | s = 0; |

(continued)

```
    if i > 0
        s = c (i);
    end
    s = q(P,j) + s + w;
    f(j) = s mod 2;
    j=j-1;
    i=i-1;
    w = 0;
    if s > 1
            w = 1;
    end
end
```

In this example, the base station sends a signal including the feedback information f = [0, 0, 1, 1, 1, 1, 1] to a sequence of terminal devices <SN(1), SN(2), SN(3), SN(4)>. The sequence of terminal devices <SN(1), SN(2), SN(3), SN(4)> receives the signal including the feedback information f. Terminal devices SN(1), SN(2), SN(3), and SN(4) separately decode the signal including the feedback information f, and determine acknowledgment of TBs b(1), b(2), b(3), and b(4), respectively, according to the following method.

If the terminal device SN(1) fails in decoding, the terminal device SN(1) determines that acknowledgment of a TB b(1) is negative acknowledgment NACK. If the terminal device SN(1) performs decoding successfully and obtains the set BI of identifiers of correct TBs, and the terminal device SN(1) determines that a UE identifier 4 of the terminal device SN(1) does not belong to the set BI of identifiers of correct TBs, then the terminal device SN(1) determines that acknowledgment of the TB b(1) is negative acknowledgment NACK.

If the terminal device SN(2) fails in decoding, the terminal device SN(2) determines that acknowledgment of a TB b(2) is negative acknowledgment NACK. If the terminal device SN(2) performs decoding successfully and obtains the set BI of identifiers of correct TBs, and the terminal device SN(2) determines that a UE identifier 3 of the terminal device SN(2) belongs to the set BI of identifiers of correct TBs, then the terminal device SN(2) determines that acknowledgment of the TB b(2) is positive acknowledgment ACK.

If the terminal device SN(3) fails in decoding, the terminal device SN(3) determines that acknowledgment of a TB b(3) is negative acknowledgment NACK. If the terminal device SN(3) performs decoding successfully and obtains the set BI of identifiers of correct TBs, and the terminal device SN(3) determines that a UE identifier 2 of the terminal device SN(3) belongs to the set BI of identifiers of correct TBs, then the terminal device SN(3) determines that acknowledgment of the TB b(3) is positive acknowledgment ACK.

If the terminal device SN(4) fails in decoding, the terminal device SN(4) determines that acknowledgment of a TB b(4) is negative acknowledgment NACK. If the terminal device SN(4) performs decoding successfully and obtains the set BI of identifiers of correct TBs, and the terminal device SN(4) determines that a UE identifier 5 of the terminal device SN(4) does not belong to the set BI of identifiers of correct TBs, then the terminal device SN(4) determines that acknowledgment of the TB b(4) is negative acknowledgment NACK.

In the information transmission method provided by the above example, the intermediate codeword c does not include an all-zero sequence with a length of $Nf-\left\lceil \log_2 \binom{Na}{P} \right\rceil$, which further saves storage space.

Example 7:

In this example, a first node is a base station, and a second node is a terminal device. There are a plurality of terminal devices which form a sequence of terminal devices, and a TB identifier is a signature index.

FIG. 20 is a schematic diagram of a relationship among a second node, a TB, a UE identifier, a random access signature, and a signature index provided by an example of the present disclosure. As shown in FIG. 20, the base station receives a signal, including a TB set B, sent by a sequence of terminal devices. The sequence of terminal devices includes Nu = 4 terminal devices: SN(1), SN(2), SN(3), and SN(4), and the TB set B includes Nb = 4 TBs: b(1), b(2), b(3), and b(4).The signal including the TB set B includes a signal including the TB b(1), a signal including the TB b(2), a signal including the TB b(3), and a signal including the TB b(4).

In this example, for t = 1, 2, 3, 4, a TB b(t) in the TB set B is sent to the base station by a terminal device SN(t) in the sequence of terminal devices. The TB b(t) in the TB set B includes a UE identifier and a random access signature of the terminal device SN(t).

In this example, a UE identifier of the terminal device SN(t) is a GPSI, and the random access signature is a preamble. UE identifiers of the terminal devices SN(1), SN(2), SN(3) and SN(4) are 4, 3, 2 and 5, respectively.

In this example, the preamble is an element of an ordered set of random access signatures. The ordered set of random access signatures includes Na = 6 preambles r(1), r(2), r(3), r(4), r(5), and r(6), where signature indexes of the preambles r(1), r(2), r(3), r(4), r(5) and r(6) are 1, 2, 3, 4, 5 and 6, respectively. The signature indexes 1, 2, 3, 4, 5, 6 of the preambles r(1), r(2), r(3), r(4), r(5), and r(6) are elements of an ordered set of TB identifiers I = <I(1), I(2), I(3), I(4), I(5), I(6)> = <1, 2, 3, 4, 5, 6>. The ordered set I of TB identifiers includes Na = 6 signature indexes 1, 2, 3, 4, 5, and 6. Random access signatures, that is, preambles, included in the TBs b(1), b(2), b(3), and b(4) are determined by the terminal devices SN(1), SN(2), SN(3), and SN(4) according to the UE identifiers 4, 3, 2, and 5 of the terminal devices SN(1), SN(2), SN(3), and SN(4) in the following manner:

The terminal devices SN(1), SN(2), SN(3), and SN(4) respectively use the UE identifiers 4, 3, 2 and 5 of the terminal devices SN(1), SN(2), SN(3) and SN(4) as part of a random number seed of a pseudo-random sequence generator (PRSG) to obtain signature indexes of preambles of the terminal devices SN(1), SN(2), SN(3), and SN(4) as 4, 3, 2, 1, respectively, and obtain the preambles included in the TBs b(1), b(2), b(3), and b(4) as r(4), r(3), r(2), and r(1), respectively.

In this example, a maximum quantity of correct TBs Pmax = 3 is configured by using a higher layer parameter. In this example, a set of identifiers of correct TBs is a set of signature indexes of random access signatures included in correctly-received TBs in the TB set. In this example, the base station determines the following according to the signal including the TB set B: the set of identifiers of correct TBs is a set BI = {2, 3}, and a quantity P of correct TBs is equal to 2.

In this example, feedback information f is determined by compression coding by the base station according to the following parameters: a maximum quantity of correct TBs Pmax = 3, an ordered set I of TB identifiers, a size of the ordered set of TB identifiers Na = 6, a set BI of **identifiers** of correct TBs, a quantity of correct TBs P = 2, and an ordered set Q of offset values. A length Nf of the feedback information

$$f = \left\lceil \log_2\left( \sum_{i=1}^{Pmax} 2^{\left\lceil \log_2 \binom{Na}{i} \right\rceil} \right) \right\rceil = \left\lceil \log_2\left( 2^{\left\lceil \log_2 \binom{6}{1} \right\rceil} + 2^{\left\lceil \log_2 \binom{6}{2} \right\rceil} + 2^{\left\lceil \log_2 \binom{6}{3} \right\rceil} \right) \right\rceil = 6$$

, and the ordered set of offset values Q = <Q(1), Q(2),

$$Q(3)> = \left\langle 0, 2^{\left\lceil \log_2 \binom{Na}{1} \right\rceil}, 2^{\left\lceil \log_2 \binom{Na}{1} \right\rceil} + 2^{\left\lceil \log_2 \binom{Na}{2} \right\rceil} \right\rangle = <0, 8, 24>$$

.

In this example, offset value bit sequences corresponding to Nf = 6 binary-represented bits of integer offset values Q(1), Q(2), and Q(3) are:

$$[q(1,1), q(1,2), q(1,3), q(1,4), q(1,5), q(1,6)] = [0, 0, 0, 0, 0, 0],$$

$$[q(2,1), q(2,2), q(2,3), q(2,4), q(2,5), q(2,6)] = [0, 0, 1, 0, 0, 0],$$

and

$$[q(3,1), q(3,2), q(3,3), q(3,4), q(3,5), q(3,6)] = [0, 1, 1, 0, 0, 0],$$

respectively.

In this example, an "ack" bit is bit "1" and a "nack" bit is bit "0". The base station determines the feedback information f according to the following method.

According to the program flow shown in FIG. 4, the base station performs compression coding on the set BI of identifiers of correct TBs to obtain feedback information f = [0, 1, 0, 0, 1, 0]. The compression coding on the set BI of identifiers of correct TBs refers a coding method of mapping $\sum_{i=1}^{P_{max}}\binom{Na}{i} = \binom{6}{1}+\binom{6}{2}+\binom{6}{3} = 41$ sets of identifiers of correct TBs each including at most Pmax = 3 elements and at least one element to a bit sequence with a length of Nf = 6, where The codeword mapping relationship is shown in FIG. 21 (only a mapping relationship involved in this example is shown in the figure), where $Ni = \left\lceil \log_2\binom{Na}{P} \right\rceil$.

In this example, the base station sends a signal including the feedback information f = [0, 1, 0, 0, 1, 0] to a sequence of terminal devices <SN(1), SN(2), SN(3), SN(4)>. The sequence of terminal devices <SN(1), SN(2), SN(3), SN(4)> receives the signal including the feedback information f. Terminal devices SN(1), SN(2), SN(3), and SN(4) separately decode the signal including the feedback information f, and determine acknowledgment of TBs b(1), b(2), b(3), and b(4), respectively, according to the following method.

If the terminal device SN(1) fails in decoding, the terminal device SN(1) determines that acknowledgment of a TB b(1) is negative acknowledgment NACK. If the terminal device SN(1) performs decoding successfully and obtains the set BI of identifiers of correct TBs, and the terminal device SN(1) determines that a signature index 4 of the random access signature included in the TB b(1) does not belong to the set BI of identifiers of correct TBs, then the terminal device SN(1) determines that acknowledgment of the TB b(1) is negative acknowledgment NACK.

If the terminal device SN(2) fails in decoding, the terminal device SN(2) determines that acknowledgment of a TB b(2) is negative acknowledgment NACK. If the terminal device SN(2) performs decoding successfully and obtains the set BI of identifiers of correct TBs, and the terminal device SN(2) determines that a signature index 3 of the random access signature included in the TB b(2) belongs to the set BI of identifiers of correct TBs, then the terminal device SN(2) determines that acknowledgment of the TB b(2) is positive acknowledgment ACK.

If the terminal device SN(3) fails in decoding, the terminal device SN(3) determines that acknowledgment of a TB b(3) is negative acknowledgment NACK. If the terminal device SN(3) performs decoding successfully and obtains the set BI of identifiers of correct TBs, and the terminal device SN(3) determines that a signature index 2 of the random access signature included in the TB b(3) belongs to the set BI of identifiers of correct TBs, then the terminal device SN(3) determines that acknowledgment of the TB b(3) is positive acknowledgment ACK.

If the terminal device SN(4) fails in decoding, the terminal device SN(4) determines that acknowledgment of a TB b(4) is negative acknowledgment NACK. If the terminal device SN(4) performs decoding successfully and obtains the set BI of identifiers of correct TBs, and the terminal device SN(4) determines that a signature index 1 of the random access signature included in the TB b(4) does not belong to the set BI of identifiers of correct TBs, then the terminal device SN(4) determines that acknowledgment of the TB b(4) is negative acknowledgment NACK.

In the information transmission method provided by the above example, there is no intermediate codeword c, which further saves storage space. In this example, a quantity of UE identifiers is generally much greater than a quantity of random access signatures. If a signature collision probability meets a requirement, using the signature index as a TB identifier can reduce the length of the feedback information f, and further reduce the use of feedback resources. In this example, a pseudo-random number generator is used to generate the random access signature, which can avoid a signature collision.

Example 8:

In this example, a first node is a base station, and a second node is a terminal device. There are a plurality of terminal devices which form a sequence of terminal devices, and a TB identifier is a signature index.

FIG. 22 is a schematic diagram of a relationship among a second node, a TB, a random access signature, and a signature index provided by an example of the present disclosure. As shown in FIG. 22, the base station receives a signal, including a TB set B, sent by a sequence of terminal devices. The sequence of terminal devices includes Nu = 3 terminal devices: SN(1), SN(2), and SN(3), and the TB set B includes Nb = 4 TBs: b(1), b(2), b(3), and b(4). The signal including the TB set B includes a signal including the TB b(1), a signal including the TB b(2), a signal including the TB b(3), and a signal including the TB b(4).

In this example, the TBs b(1), b(2), b(3), and b(4) in the TB set B are respectively sent to the base station by the terminal devices SN(1), SN(2), SN(3), and SN(1) in the sequence of terminal devices. The TBs b(1), b(2), b(3), and b(4) in the TB set B include random access signatures, where the random access signatures are interleavers.

In this example, the interleavers are elements of an ordered set of random access signatures. The ordered set of random access signatures includes Na = 5 interleavers r(1), r(2), r(3), r(4), and r(5), where signature indexes of the interleavers r(1), r(2), r(3), r(4), and r(5) are 1, 2, 3, 4, and 5, respectively. The signature indexes 1, 2, 3, 4, and 5 of the interleavers r(1), r(2), r(3), r(4), and r(5) are elements of an ordered set of TB identifiers I = <I(1), I(2), I(3), I(4), I(5)> = <1, 2, 3, 4, 5>. The ordered set I of TB identifiers includes Na = 5 signature indexes 1, 2, 3, 4, and 5.

In this example, the random access signatures included in the TBs b(1), b(2), b(3), and b(4) are respectively determined by the terminal devices SN(1), SN(2), SN(3), and SN(1) as r(4), r(3), r(2), and r(1) according to higher layer parameters, where signature indexes of the random access signatures of the TBs b(1), b(2), b(3) and b(4) are 4, 3, 2 and 1, respectively.

In this example, a maximum quantity of correct TBs Pmax = 2 is configured by using a higher layer parameter. In this example, a set of identifiers of correct TBs is a set of signature indexes of random access signatures included in correctly-received TBs in the TB set. In this example, the base station determines the following according to the signal including the TB set B: the set of identifiers of correct TBs is a set BI = {2, 3}, and a quantity P of correct TBs is equal to 2.

In this example, feedback information f is determined by compression coding by the base station according to the following parameters: a maximum quantity of correct TBs Pmax = 2, an ordered set I of TB identifiers, a size of the ordered set of TB identifiers Na = 5, a set BI of identifiers of correct TBs, a quantity of correct TBs P = 2, and an ordered set Q of offset values. A length Nf of the feedback information

$$f = \left\lceil \log_2\left(\sum_{i=0}^{Pmax} 2^{\left\lceil \log_2 \binom{Na}{i} \right\rceil}\right)\right\rceil = \left\lceil \log_2\left(2^{\left\lceil \log_2 \binom{5}{0} \right\rceil} + 2^{\left\lceil \log_2 \binom{5}{1} \right\rceil} + 2^{\left\lceil \log_2 \binom{5}{2} \right\rceil}\right)\right\rceil = 5$$

, and the ordered set of offset values Q = <Q(1), Q(2)>

$$= \left\langle 2^{\left\lceil \log_2 \binom{Na}{0} \right\rceil}, 2^{\left\lceil \log_2 \binom{Na}{0} \right\rceil} + 2^{\left\lceil \log_2 \binom{Na}{1} \right\rceil} \right\rangle = <1, 9>$$

.

In this example, offset value bit sequences corresponding to Nf = 5 binary-represented bits of integer offset values Q(1) and Q(2) are:

$$[q(1,1), q(1,2), q(1,3), q(1,4), q(1,5)] = [0, 0, 0, 0, 1],$$

and

$$[q(2,1), q(2,2), q(2,3), q(2,4), q(2,5)] = [0, 1, 0, 0, 1],$$

respectively.

In this example, an "ack" bit is bit" 1" and a "nack" bit is bit "0". The base station determines the feedback information f according to the following method.

According to the program flow shown in FIG. 3, the base station performs compression coding on the set BI of identifiers of correct TBs to obtain feedback information f= [1, 0, 0, 1, 0]. The compression coding on the set BI of identifiers of correct TBs refers a coding method of mapping

$$\sum_{i=0}^{P_{max}} \binom{Na}{i} = \binom{5}{0} + \binom{5}{1} + \binom{5}{2} = 16$$

sets of identifiers of correct TBs each including at most Pmax = 2 elements to a bit sequence with a length of Nf = 5, where the codeword mapping relationship is shown in FIG. 23, where

$$Ni = \left\lceil \log_2 \binom{Na}{P} \right\rceil$$

.

In this example, the base station sends a signal including the feedback information f = [1, 0, 0, 1, 0] to a sequence of terminal devices <SN(1), SN(2), SN(3), SN(1)>. The sequence of terminal devices <SN(1), SN(2), SN(3), SN(1)> receives the signal including the feedback information f. Terminal devices SN(1), SN(2), SN(3), and SN(4) separately decode the signal including the feedback information f, and determine acknowledgment of the TBs b(1), b(2), b(3), and b(4), respectively, according to the following method.

If the terminal device SN(1) fails in decoding, the terminal device SN(1) determines that acknowledgment of each of the TBs b(1) and b(4) is negative acknowledgment NACK. If the terminal device SN(1) performs decoding successfully and obtains the set BI of identifiers of correct TBs, and the terminal device SN(1) determines that a signature index 4 of the random access signature included in the TB b(1) does not belong to the set BI of identifiers of correct TBs, then the terminal device SN(1) determines that acknowledgment of the TB b(1) is negative acknowledgment NACK; if the terminal device SN(1) determines that a signature index 1 of the random access signature included in the TB b(4) does not belong to the set BI of identifiers of correct TBs, the terminal device SN(1) determines that acknowledgment of the TB b(4) is negative acknowledgment NACK.

If the terminal device SN(2) fails in decoding, the terminal device SN(2) determines that acknowledgment of a TB b(2) is negative acknowledgment NACK. If the terminal device SN(2) performs decoding successfully and obtains the set BI of identifiers of correct TBs, and the terminal device SN(2) determines that a signature index 3 of the random access signature included in the TB b(2) belongs to the set BI of identifiers of correct TBs, then the terminal device SN(2) determines that acknowledgment of the TB b(2) is positive acknowledgment ACK.

If the terminal device SN(3) fails in decoding, the terminal device SN(3) determines that acknowledgment of a TB b(3) is negative acknowledgment NACK. If the terminal device SN(3) performs decoding successfully and obtains the set BI of identifiers of correct TBs, and the terminal device SN(3) determines that a signature index 2 of the random access signature included in the TB b(3) belongs to the set BI of identifiers of correct TBs, then the terminal device SN(3) determines that acknowledgment of the TB b(3) is positive acknowledgment ACK.

In the information transmission method provided by the above example, the terminal device SN(1) sends the two TBs b(1) and b(4), but selects different random access signatures. The base station determines the feedback information f according to a signature index of a random access signature of a correctly decoded TB, so that the terminal device SN(1) can determine whether the two TBs b(1) and b(4) are correctly received. In addition, because a quantity of signature indexes is generally less than a quantity of UE identifiers, the length of the feedback information f can also be reduced.

Example 9:

A difference between this example and Example 8 is that in this example, a random access signature is a spread spectrum sequence.

In this example, feedback information f is determined by compression coding by a base station according to the following parameters: a maximum quantity of correct TBs Pmax = 2, an ordered set I of TB identifiers, a size of the ordered set of TB identifiers Na = 5, a set BI of identifiers of correct TBs, a quantity of correct TBs P = 2, and an ordered set Q of offset values. A length Nf of the feedback information $f = \left\lceil \log_2\left(\sum_{i=0}^{Pmax}\binom{Na}{i}\right)\right\rceil = \left\lceil \log_2\left(\binom{5}{0}+\binom{5}{1}+\binom{5}{2}\right)\right\rceil = 4$, and the ordered set of offset values Q = <Q(1), Q(2), Q(3), Q(4)> = $\left\langle 0, \binom{Na}{0}, \binom{Na}{0}+\binom{Na}{1}, \binom{Na}{0}+\binom{Na}{1}+\binom{Na}{2}\right\rangle = \langle 0, 1, 6, 16\rangle$.

In this example, according to the mapping relationship shown in FIG. 24, the base station determines the feedback information f according to the following method: FIG. 25 is a flowchart of determining feedback information according to a set of identifiers of correct TBs provided by an example of the present disclosure. According to the program flow shown in FIG. 25, the base station performs compression coding on the set BI of identifiers of correct TBs to obtain feedback information f = [1, 0, 1, 1]. The compression coding on the set BI of identifiers of correct TBs refers a coding method of mapping $\sum_{i=0}^{P_{max}}\binom{Na}{i} = \binom{5}{0}+\binom{5}{1}+\binom{5}{2} = 16$ sets of identifiers of correct TBs each including at most Pmax = 2 elements to a bit sequence with a length of Nf = 4, where floor(F/2) means the largest integer less than or equal to F/2.

The base station sends a signal including the feedback information f = [1, 0, 1, 1] to a sequence of terminal devices <SN(1), SN(2), SN(3), SN(1)>.

In the information transmission method provided by the above example, the length Nf of the feedback information f is further shortened.

Example 10:

A difference between this example and Example 8 is that in this example, a random access signature is a sparse code sequence.

Feedback information f is determined by compression coding by a base station according to the following parameters: a maximum quantity of correct TBs Pmax = 2, an ordered set I of TB identifiers, a size of the ordered set of TB identifiers Na = 5, a set BI of identifiers of correct TBs, a quantity of correct TBs P = 2, and an ordered set Q of offset values.

A length Nf of the feedback information $f = \left\lceil \log_2\left(\sum_{i=1}^{Pmax}\binom{Na}{i}\right)\right\rceil = \left\lceil \log_2\left(\binom{5}{1}+\binom{5}{2}\right)\right\rceil = 4$, and the ordered set of offset values Q = <Q(1), Q(2), $Q(3)> = \left\langle 0, \binom{Na}{1}, \binom{Na}{1}+\binom{Na}{2} \right\rangle = <0, 5, 15>$.

Another difference between this example and Example 8 is that in this example, according to the mapping relationship shown in FIG. 26, the base station determines the feedback information f according to the following method. According to the program flow shown in FIG. 27, the base station performs compression coding on the set BI of identifiers of correct TBs to obtain feedback information f = [1, 0, 1, 0]. The compression coding on the set BI of identifiers of correct TBs refers a coding method of mapping $\sum_{i=1}^{P_{max}}\binom{Na}{i} = \binom{5}{1}+\binom{5}{2} = 15$ sets of identifiers of correct TBs each including at most Pmax = 2 elements and at least one element to a bit sequence with a length of Nf = 4.

The base station sends a signal including the feedback information f = [1, 0, 1, 0] to a sequence of terminal devices <SN(1), SN(2), SN(3), SN(1)>.

In the information transmission method provided by the above example, the length Nf of the feedback information f is further shortened. In addition, when the quantity of correct TBs is equal to 0, the length Nf of the feedback information f is 0, and the signal including the feedback information f is a zero power signal, thereby saving transmission energy.

Example 11:

A difference between this example and Example 8 is that in this example, a random access signature is a scrambling sequence. The scrambling sequence is an element of an ordered set of random access signatures. The ordered set of random access signatures includes Na = 5 scrambling sequences r(1), r(2), r(3), r(4), and r(5), where signature indexes of the scrambling sequences r(1), r(2), r(3), r(4) and r(5) are 0, 1, 2, 3 and 4, respectively. The signature indexes 0, 1, 2, 3, and 4 of the scrambling sequences r(1), r(2), r(3), r(4), and r(5) are elements of an ordered set I of TB identifiers I = <I(1), I(2), I(3), I(4), I(5)> = <0, 1, 2, 3, 4>. The ordered set I of TB identifiers includes Na = 5 signature indexes 0, 1, 2, 3, and 4. Signature indexes of random access signatures of TBs b(1), b(2), b(3) and b(4) are 3, 2, 1, and 0 respectively, as shown in FIG. 28.

Another difference between this example and Example 8 is that in this example, a base station determines the following according to a signal including a TB set B: a set of identifiers of correct TBs being an empty set Φ, or a quantity P of correct TBs equal to 0.

Feedback information f is determined by compression coding by the base station according to the following parameters: the set Φ of identifiers of correct TBs, or the quantity P of correct TBs equal to 0, where a length Nf of the feedback information f is equal to 0.

In this example, an "ack" bit is bit "1" and a "nack" bit is bit "0". The base station determines the feedback information f according to the following method. The base station determines that the feedback information f is an empty sequence according to the set of identifiers of correct TBs being an empty set Φ (or the quantity P of correct TBs equal to 0). The base station determines that a signal including the feedback information f is a zero power signal.

In this example, the base station sends the zero power signal including the feedback information f to a sequence of terminal devices <SN(1), SN(2), SN(3), SN(1)>. The sequence of terminal devices <SN(1), SN(2), SN(3), SN(1)> receives the zero power signal including the feedback information f. If the terminal device SN(1) fails in decoding, it is determined that acknowledgment of the TBs b(1) and b(4) are negative acknowledgment NACK; if the terminal device SN(2) fails in decoding, it is determined that acknowledgment of the TB b(2) is negative acknowledgment NACK; and if the terminal device SN(3) fails in decoding, it is determineed that acknowledgment of the TB b(3) is negative acknowledgment NACK.

In the information transmission method provided by the above example, the set of identifiers of correct TBs is an empty set, and the base station sends a zero power signal including the feedback information f, that is, does not send a signal. This reduces power consumption of the base station.

Example 12:

A difference between this example and Example 1 is that in this example, a TB identifier is an index value of a UE identifier. FIG. 29 is a schematic diagram of a relationship among a second node, a TB, a UE identifier, and an index value of the UE identifier provided by an example of the present disclosure. As shown in FIG. 29, a base station receives a signal, including a TB set B, sent by a sequence of terminal devices. The sequence of terminal devices includes Nu = 4 terminal devices: SN(1), SN(2), SN(3), and SN(4), and the TB set B includes Nb = 4 TBs: b(1), b(2), b(3), and b(4). The signal including the TB set B includes a signal including the TB b(1), a signal including the TB b(2), a signal including the TB b(3), and a signal including the TB b(4).

Another difference between this example and Example 1 is that in this example, for t = 1, 2, 3, 4, a TB b(t) in the TB set B is sent to the base station by a terminal device SN(t) in the sequence of terminal devices. The TB b(t) in the TB set B includes a UE identifier of the terminal device SN(t), and the UE identifier of the terminal device SN(t) is an RA-RNTI. UE identifiers of the terminal devices SN(1), SN(2), SN(3) and SN(4) are 13, 10, 6 and 51, respectively, where the UE identifiers 13, 10, 6, and 51 are elements of an ordered set of UE identifiers ID = <ID(1), ID(2), ID(3), ID(4), ID(5), ID(6), ID(7), ID(8)> = <7, 42, 6, 10, 13, 51, 19, 63>, and index values of a UE identifier of the UE identifiers 13, 10, 6, and 51 are 4, 3, 2, and 5, respectively. Index values of the UE identifiers 7, 42, 6, 10, 13, 51, 19, and 63 in the ordered set ID of UE identifiers are elements I(1), I(2), I(3), I(4), I(5), I(6), I(7), and I(8) of an ordered set of TB identifiers I = <I(1), I(2), I(3), I(4), I(5), I(6), I(7), I(8) > = <1, 2, 3, 4, 5, 6, 7, 8>, where Na = 8 is a size of the ordered set of TB identifiers, and is also a size of ordered set of UE identifiers.

Another difference between this example and Example 1 is that in this example, a set of identifiers of correct TBs is a set of index values of UE identifiers included in correctly-received TBs in the TB set.

Another difference between this example and Example 1 is that in this example, the sequence of terminal devices <SN(1), SN(2), SN(3), SN(4)> receives a signal including feedback information f. Terminal devices SN(1), SN(2), SN(3), and SN(4) separately decode the signal including the feedback information f, and determine acknowledgment of the TBs b(1), b(2), b(3), and b(4), respectively, according to the following method.

If the terminal device SN(1) fails in decoding, the terminal device SN(1) determines that acknowledgment of the TB b(1) is negative acknowledgment NACK. If the terminal device SN(1) performs decoding successfully and obtains a set BI of identifiers of correct TBs, and the terminal device SN(1) determines that an index value 4 of a UE identifier of the terminal device SN(1) does not belong to the set BI of identifiers of correct TBs, then the terminal device SN(1) determines that acknowledgment of the TB b(1) is negative acknowledgment NACK.

If the terminal device SN(2) fails in decoding, the terminal device SN(2) determines that acknowledgment of the TB b(2) is negative acknowledgment NACK. If the terminal device SN(2) performs decoding successfully and obtains the set BI of identifiers of correct TBs, and the terminal device SN(2) determines that an index value 3 of a UE identifier of the terminal device SN(2) belongs to the set BI of identifiers of correct TBs, then the terminal device SN(2) determines that acknowledgment of the TB b(2) is positive acknowledgment ACK.

If the terminal device SN(3) fails in decoding, the terminal device SN(3) determines that acknowledgment of the TB b(3) is negative acknowledgment NACK. If the terminal device SN(3) performs decoding successfully and obtains the set BI of identifiers of correct TBs, and the terminal device SN(3) determines that an index value 2 of a UE identifier of the terminal device SN(3) belongs to the set BI of identifiers of correct TBs, then the terminal device SN(3) determines that acknowledgment of the TB b(3) is positive acknowledgment ACK.

If the terminal device SN(4) fails in decoding, the terminal device SN(4) determines that acknowledgment of the TB b(4) is negative acknowledgment NACK. If the terminal device SN(4) performs decoding successfully and obtains a set BI of identifiers of correct TBs, and the terminal device SN(4) determines that an index value 5 of a UE identifier of the terminal device SN(4) does not belong to the set BI of identifiers of correct TBs, then the terminal device SN(4) determines that acknowledgment of the TB b(4) is negative acknowledgment NACK.

The benefit of this example is that using an index value of the UE identifier as a TB identifier can reduce the size of the ordered set of TB identifiers. Because the largest element in a set of UE identifiers is 63, if the UE identifier is used as the TB identifier, the size of the ordered set of TB identifiers is required to be Na = 63 to cover all UE identifiers represented by positive integers less than or equal to 63. However, in fact, in this example, the UE identifier is taken from the ordered set ID of UE identifiers with the size of 8. Using the index value of the UE identifier as the TB identifier can greatly reduce the size of the ordered set of TB identifiers.

FIG. 30 shows an information transmission method provided by an embodiment of the present disclosure, including step S5000 and step S6000.

At step S5000, a TB is sent to a first node.

At S6000, feedback information sent by the first node is received, where the feedback information is used to represent a reception condition of the TB.

In some embodiments, one second node sends a signal including one or more TBs to the first node, the one or more TBs forming a TB set at the first node. In some other embodiments, two or more second nodes may send one or more TBs to the first node, respectively, and the TBs form a TB set.

In some embodiments, when a plurality of second nodes send TBs to the first node, the second nodes that send the TB set constitute a sequence of second nodes. Here, the sequence of second nodes includes Nu second nodes, and the TB set includes Nb TBs, Here, Nu and Nb are positive integers, and Nu is less than or equal to Nb.

In some embodiments, a TB in the TB set includes a TB identifier, an ordered set of TB identifiers includes Na TB identifiers I(1), I(2), ..., and I(Na), and Na is a size of the ordered set of TB identifiers. For i=1, 2, ..., Na, an $i^{th}$ element in the ordered set of TB identifiers is I(i). Here, the $i^{th}$ element I(i) in the ordered set of TB identifiers may be an integer i or an integer i-1.

In some embodiments, the TB is indicated by a TB identifier.

In some embodiments, the TB identifier may be one of the following: a UE identifier, an index value of a UE identifier, or a signature index.

In some embodiments, the UE identifier is a UE identifier of a second node in the sequence of second nodes, and UE identifiers of two different second nodes in the sequence of second nodes are different. The UE identifiers may be used for the first node to distinguish between different TBs in the TB set in a signal including the TB set, and the UE identifier is an integer.

In some embodiments, the TB identifier is a UE identifier, and elements in the ordered set of TB identifiers are UE identifiers. In an example, the ordered set of TB identifiers I = <I(1), I(2), I(3), I(4), I(5)> = <0, 1, 2, 3, 4>, where the size Na of the ordered set of TB identifiers is equal to 5, and a UE identifier corresponding to the second element I(2) in the ordered set of TB identifiers is 1. In another example, the ordered set of TB identifiers I = <I(1), I(2), I(3), I(4), I(5)> = <1, 2, 3, 4, 5>, where the size Na of the ordered set of TB identifiers is equal to 5, and the UE identifier corresponding to the second element I(2) in the ordered set of TB identifiers is 2. Still in another example, the ordered set of TB identifiers I = <I(1), I(2), I(3), I(4)> = <0, 11, 20, 30>, where the size Na of the ordered set of TB identifiers is equal to 4, and the UE identifier corresponding to the second element I(2) in the ordered set of TB identifiers is 11.

In some embodiments, the index value of a UE identifier is an index i of an element I(k) in an ordered set of TB identifiers I = <I(1), I(2), ..., I(Na)>, i = 1, 2, ..., Na, and the index value of the UE identifier is an integer.

In some embodiments, the TB identifier is the index value of the UE identifier, the UE identifier is an element in an ordered set of UE identifiers, and the ordered set of UE identifiers includes Na UE identifiers ID(1), ID(2), ..., ID(Na). Here, Na is a size of the ordered set of UE identifiers and the size of the ordered set of TB identifiers, i = 1, 2, ..., Na, and an index value of a UE identifier corresponding to an $i^{th}$ UE identifier ID(i) in the ordered set of UE identifiers is an $i^{th}$ element I(i) in elements in the ordered set of TB identifiers. In an example, the ordered set of UE identifiers ID = <ID(1), ID(2), ID(3), ID(4)> = <0, 11, 20, 30>, and the corresponding ordered set of TB identifiers I = <I(1), I(2), I(3), I(4)> = <0, 1, 2, 3>; where the size of the ordered set of UE identifiers and the size of the ordered set of TB identifiers are both Na = 4, and an index value of a UE identifier of an element ID(2) = 11 in the ordered set of UE identifiers is the element I(2) = 1 in the ordered set of TB identifiers.

In some embodiments, the TB identifier is a signature index, and the signature index is a signature index of a random access signature, that is, a TB in the TB set includes the random access signature. The random access signature is an element in an ordered set of random access signatures, and the ordered set of random access signatures includes Na random access signatures r(1), r(2), ..., r(Na). Here, Na is a size of the ordered set of random access signatures and the size of the ordered set of TB identifiers, i = 1, 2, ..., Na, and a signature index of an $i^{th}$ random access signature r(i) in the ordered set of random access signatures is an $i^{th}$ element I(i) in the ordered set of TB identifiers, where the $i^{th}$ element I(i) in the ordered set of TB identifiers may be an integer i or an integer i-1.

It should be noted that the UE identifier may be a SUPI, a GPSI, a PEI, a NAI, an SUCI, a GUTI, an RNTI, an SI-RNTI, a P-RNTI, an RA-RNTI, a TC-RNTI, a C-RNTI, a TPC-PUCCH-RNTI, a TPC-PUSCH-RNTI, a TPC-SRS-RNTI, an INT-RNTI, an MCS-C-RNTI, a CS-RNTI, an SFI-RNTI, an SP-CSI-RNTI, or the like.

It should be noted that the random access signature may be a pilot, a reference signal, a preamble, a spread spectrum sequence, an interleaver, an interleaver pattern, an interleaver sequence, a scrambling sequence, a sparse code sequence, or the like.

In some embodiments, the second node determines a random access signature of a TB according to a UE identifier of the TB, as a random access signature included in the TB in the TB set. The random access signatures may be used for the first node to distinguish between different TBs in the TB set in the signal including the TB set.

In some embodiments, the second node determines a random access signature of a TB according to a higher layer parameter, as a random access signature included in the TB in the TB set. The random access signatures may be used for the first node to distinguish between different TBs in the TB set in the signal including the TB set.

It should be noted that the first node and the second node may be any network elements with data reception and signaling transmission functions such as base stations, relays, or terminal devices.

It should be noted that information about a set of correct TBs includes a maximum quantity Pmax of correct TBs, an ordered set of TB identifiers, the size Na of the ordered set of TB identifiers, a set of identifiers of correct TBs, a quantity P of correct TBs, an intermediate codeword c, a TB error pattern a, or an ordered set Q of TB identifiers. It should be noted that the feedback information can be obtained according to one or more of the foregoing information about the correct TB, that is, the generation of the feedback information does not necessarily require all the information.

In some embodiments, the maximum quantity Pmax of correct TBs is equal to the size Na of the ordered set of TB identifiers. In some other embodiments, the maximum quantity Pmax of correct TBs is configured by the first node. In some other embodiments, the maximum quantity Pmax of correct TBs is pre-configured by using a higher layer parameter.

In some embodiments, the information about the set of correct TBs is the set of identifiers of correct TBs, and the set of identifiers of correct TBs is a set of UE identifiers included in correctly-received TBs in the TB set. The correctly-received TB is a TB whose acknowledgment state is a positive acknowledgment ACK. A UE identifier belonging to the set of identifiers of correct TBs is used to indicate that an acknowledgment state of a TB corresponding to the UE identifier is positive acknowledgment ACK. A UE identifier not belonging to the set of identifiers of correct TBs is used to indicate that an acknowledgment state of a TB corresponding to the UE identifier is negative acknowledgment NACK.

In some embodiments, the information about the set of correct TBs is the set of identifiers of correct TBs, and the set of identifiers of correct TBs is a set of index values of UE identifiers. The correctly-received TB is a TB whose acknowledgment state is a positive acknowledgment ACK. An index value of a UE identifier belonging to the set of identifiers of correct TBs is used to indicate that an acknowledgment state of a TB corresponding to the index value of the UE identifier is positive acknowledgment ACK. An index value of a UE identifier not belonging to the set of identifiers of correct TBs is used to indicate that an acknowledgment state of a TB corresponding to the index value of the UE identifier is negative acknowledgment NACK.

In some embodiments, the information about the set of correct TBs is the set of identifiers of correct TBs, and the set of identifiers of correct TBs is a set of signature indexes of random access signatures corresponding to correctly-received TBs in the TB set. The correctly-received TB is a TB whose acknowledgment state is a positive acknowledgment ACK. A signature index of a random access signature belonging to the set of identifiers of correct TBs is used to indicate that an acknowledgment state of a TB corresponding to the random access signature is positive acknowledgment ACK. A signature index of a random access signature not belonging to the set of identifiers of correct TBs is used to indicate that an acknowledgment state of a TB corresponding to the random access signature is negative acknowledgment NACK.

Example 13:

In this example, a process of obtaining feedback information f is described from the perspective of a terminal device.

In this example, as shown in FIG. 22, a sequence of terminal devices receives a signal including the feedback information f sent by a base station, where the sequence of terminal devices includes Nu = 3 terminal devices SN(1), SN(2) and SN(3), the feedback information f is feedback information of a TB set B, where the feedback information f is a bit sequence with a length Nf = $\left\lceil \log_2\left(\sum_{i=0}^{Pmax} 2^{\left\lceil \log_2\binom{Na}{i}\right\rceil}\right)\right\rceil = \left\lceil \log_2\left(2^{\left\lceil \log_2\binom{5}{0}\right\rceil} + 2^{\left\lceil \log_2\binom{5}{1}\right\rceil} + 2^{\left\lceil \log_2\binom{5}{2}\right\rceil}\right)\right\rceil = 5$. Here, the TB set B is sent to the base station by the sequence of terminal devices, Na = 5 is a size of an ordered set of TB identifiers, and Pmax = 2 is a maximum quantity of correct TBs. Here, the TB set B includes Nb = 4 TBs: b(1), b(2), b(3), and b(4). Here, the feedback information f is determined by the base station according to a signal including the TB set B sent by the sequence of terminal devices.

FIG. 31 is a flowchart of a determining method based on a decoding result provided by an embodiment of the present disclosure, the method including steps S7100, S7200, S7300, S7310, and S7320.

At S7100, a feedback signal corresponding to feedback information is decoded to obtain a decoding result.

At S7200, it is determined according to the decoding result whether the decoding succeeds.

At S7300, in response to the decoding being successful, a set of identifiers of correct TBs is obtained, and it is determined whether the decoding result includes a TB identifier of a TB sent by a second node.

At S7310, if the decoding result does not include the TB identifier of the TB sent by the second node, it is determined that acknowledgment of the TB sent by the second node is negative acknowledgment NACK.

At S7320, if the decoding result includes the TB identifier of the TB sent by the second node, it is determined that acknowledgment of the TB sent by the second node is positive acknowledgment ACK.

FIG. 32 is a schematic diagram of an information transmission apparatus provided by an embodiment of the present disclosure. As shown in FIG. 32, the information transmission apparatus 200 provided in this embodiment of the present disclosure is applied to a base station and can execute the information transmission method provided in the embodiments of the present disclosure. The apparatus has functional modules for execution of the method and can achieve corresponding technical effects. The apparatus can be realized by software, hardware or a combination of software and hardware, including:

- a receiving module 201 configured to receive a TB sent by the at least one second node, where the TB forms a TB set;

- a correct TB information obtaining module 202 configured to obtain information about a set of correct TBs according to the TB set;

- a feedback information generation module 203 configured to encode the information about the set of correct TBs to obtain feedback information, where the feedback information is used to represent a reception condition of the TB sent by the at least one second node, and the encoding processing includes compression coding performed on the information about the set of correct TBs; and

- a sending module 204 configured to send feedback information to a sequence of second nodes.

FIG. 33 is a schematic diagram of an information transmission apparatus provided by an embodiment of the present disclosure. As shown in FIG. 33, the information transmission apparatus 300 provided in this embodiment of the present disclosure is applied to a UE and can execute the information transmission method provided in the embodiments of the present disclosure. The apparatus has functional modules for execution of the method and can achieve corresponding technical effects. The apparatus can be realized by software, hardware or a combination of software and hardware, including:

- a sending module 301 configured to send a TB to a first node, where the TB forms a TB set at the first node; and

- a receiving module 302 configured to receive feedback information sent by the first node, where the feedback information is used to represent a reception condition of the TB.

FIG, 34 is a schematic diagram of a base station provided by an embodiment of the present disclosure. As shown in FIG. 34, the base station 400 includes a memory 401, a processor 402, a receiver 403, and a transmitter 404. There may be one or more memories 401 and processors 402, although one memory 401 and one processor 402 are shown as an example in FIG. 34. The memory 401 and the processor 402 of the base station may be connected by a bus or in other ways. In FIG. 34, the connection is realized by a bus, for example.

As a computer-readable storage medium, the memory 401 may be configured to store a software program, a computer-executable program and a module, for example, the program instructions/modules corresponding to the information transmission method of any one of the embodiments of the present disclosure. The processor 402 implements the above information transmission method by executing the software programs, instructions and modules stored in the memory 401.

The memory 401 may mainly include a storage program area and a storage data area, where the program storage area may store an operating system and application program(s) required by at least one feature. In addition, the memory 401 may include a high-speed random access memory and a non-volatile memory, for example, at least one magnetic disk storage device, a flash memory device, or another non-volatile solid-state storage device. In some examples, the memory 401 further includes memories remotely located with respect to the processor 402, and these remote memories may be connected to the device via a network. Examples of the above-mentioned network include, but are not limited to, the Internet, an intranet, a local area network, a mobile communication network, and a combination thereof.

The receiver 403 is configured to perform information reception. The transmitter 404 is configured to transmit feedback information according to the control of the processor 402.

FIG. 35 is a schematic diagram of a UE provided by an embodiment of the present disclosure. As shown in FIG. 35, the user equipment 500 includes a memory 501, a processor 502, a receiver 503, and a transmitter 504. There may be one or more memories 501 and processors 502, although one memory 501 and one processor 502 are shown as an example in FIG. 35. There may be one or more memories 501 and processors 502, although one memory 501 and one processor 502 are shown as an example in FIG. 35.

As a computer-readable storage medium, the memory 501 may be configured to store a software program, a computer-executable program and a module, for example, the program instructions/modules corresponding to the information transmission method of any one of the embodiments of the present disclosure. The processor 502 implements the above information transmission method by executing the software programs, instructions and modules stored in the memory 501.

The memory 501 may mainly include a storage program area and a storage data area, where the program storage area may store an operating system and application program(s) required by at least one feature. In addition, the memory 501 may include a high-speed random access memory and a non-volatile memory, for example, at least one magnetic disk storage device, a flash memory device, or another non-volatile solid-state storage device. In some examples, the memory 501 further includes memories remotely located with respect to the processor 502, and these remote memories may be connected to the device via a network. Examples of the above-mentioned network include, but are not limited to, the Internet, an intranet, a local area network, a mobile communication network, and a combination thereof.

The receiver 503 is configured to receive feedback information. The transmitter 504 is configured to transmit a TB according to the control of the processor 502.

An embodiment of the present disclosure provides a computer-readable storage medium storing computer-executable instructions for executing an information transmission method as provided in any embodiment of the present disclosure.

An embodiment of the present disclosure provides a computer program product, including a computer program or computer instructions, where the computer program or the computer instructions are stored in a computer-readable storage medium, a processor of a computing device reads the computer program or the computer instructions from the computer-readable storage medium, and the computer program or the computer instructions, when executed by the processor, cause the computing device to perform the information transmission method according to any of the embodiments of the present disclosure.

The system architecture and an application scenario described in the embodiment of the present disclosure are for more clearly describing the technical schemes of the embodiments of the present disclosure, and do not constitute a limitation on the technical schemes provided by the embodiments of the present disclosure. Those having ordinary skill in the art may understand that, with evolution of the system architecture and emergence of new application scenarios, the technical schemes provided by the embodiments of the present disclosure are also applicable to similar technical problems.

It can be understood by those having ordinary skill in the art that all or some of the steps of the methods, systems and functional modules/units in the devices disclosed above can be implemented as software, firmware, hardware and appropriate combinations thereof.

In a hardware implementation, the division between functional modules/units mentioned in the above description does not necessarily correspond to the division of physical components; for example, a physical component may have multiple functions, or a function or step may be performed cooperatively by several physical components. Some or all of the physical components may be implemented as software executed by a processor, such as a central processing unit, a digital signal processor or a microprocessor, or as hardware, or as an integrated circuit, such as an application-specific integrated circuit. Such software may be distributed on computer-readable media, which may include computer-readable storage media (or non-transitory media) and communication media (or transitory media). As well known to those having ordinary skill in the art, the term computer-readable storage medium includes volatile and nonvolatile, removable and non-removable media implemented in any method or technique for storing information, such as computer-readable instructions, data structures, program modules or other data. A computer-readable storage medium includes but is not limited to RAM, ROM, EEPROM, flash memory or other memory technologies, CD-ROM, digital versatile disk (DVD) or other optical disk storage, cassettes, magnetic tapes, magnetic disk storage or other magnetic storage apparatuses, or any other medium that can be configured to store desired information and can be accessed by a computer. Furthermore, it is well known to those having ordinary skill in the art that communication media typically contain computer-readable instructions, data structures, program modules or other data in a modulated data signal such as a carrier wave or other transmission mechanism, and may include any information transmission media.

Terms such as "component", "module", and "system" used in this specification indicate computer-related entities, hardware, firmware, combinations of hardware and software, software, or software being executed. For example, a component may be, but is not limited to, a process that runs on a processor, a processor, an object, an executable file, a thread of execution, a program, or a computer. As illustrated by using figures, both a computing device and an application that runs on a computing device may be components. One or more components may reside within a process or a thread of execution, and a component may be located on one computer or distributed between two or more computers. In addition, these components may be executed by various computer-readable media that store various data structures. For example, the components may communicate by using a local or remote process and based on a signal having one or more data packets (for example, data from two components interacting with another component in a local system, a distributed system, or across a network such as Internet interacting with another system by using the signal).

Some embodiments of the present disclosure have been described above with reference to the accompanying drawings and are not to limit the scope of the present disclosure. Any modifications, equivalent substitutions, and improvements made by those having ordinary skill in the art without departing from the scope and essence of the present disclosure shall fall within the scope of the present disclosure.

## Claims

**1.** An information transmission method, comprising:

receiving a transport block (TB) sent by at least one second node, wherein the TB forms a TB set;
obtaining information about a set of correct TBs according to the TB set;
encoding the information about the set of correct TBs to obtain feedback information, wherein the feedback information is used to represent a reception condition of the TB sent by the at least one second node, and the encoding processing comprises performing compression coding on the information about the set of correct TBs; and
sending the feedback information to the at least one second node.

**2.** The method of claim 1, wherein the TB is indicated by a TB identifier, and the TB identifier comprises at least one of: a user equipment (UE) identifier, an index value of a UE identifier, or a signature index.

**3.** The method of claim 1, wherein:

the set of correct TBs is an empty set; and
the encoding the information about the set of correct TBs to obtain feedback information comprises: determining that the feedback information is an empty sequence; wherein a feedback signal comprising the feedback information is a zero power signal.

**4.** The method of claim 2 or 3, wherein:

the information about the set of correct TBs comprises a set of identifiers of correct TBs, an ordered set of TB identifiers, and a maximum quantity of correct TBs; and
the encoding the information about the set of correct TBs to obtain feedback information comprises:

obtaining an ordered set of offset values according to the ordered set of TB identifiers and the maximum quantity of correct TBs;
performing binary representation on offset value elements in the ordered set of offset values to obtain an offset value bit sequence having the same length as the feedback information;
performing mapping processing on the set of identifiers of correct TBs; and
performing binary addition calculation on the offset value bit sequence and the set of identifiers of correct TBs after the mapping processing to obtain the feedback information.

**5.** The method of claim 2 or 3, wherein:

the information about the set of correct TBs comprises a set of identifiers of correct TBs, an ordered set of TB identifiers, and a maximum quantity of correct TBs; and
the encoding the information about the set of correct TBs to obtain feedback information comprises:

obtaining an ordered set of offset values according to the ordered set of TB identifiers and the maximum quantity of correct TBs;
performing binary representation on offset value elements in the ordered set of offset values to obtain an offset value bit sequence having the same length as the feedback information;
performing compression coding on the set of identifiers of correct TBs to obtain an intermediate codeword; and
adding the intermediate codeword and the offset value bit sequence to obtain the feedback information.

**6.** The method of claim 2 or 3, wherein the encoding the information about the set of correct TBs to obtain feedback information comprises:

obtaining a TB error pattern according to the information about the set of correct TBs; and
performing mapping processing on the TB error pattern to obtain the feedback information.

**7.** The method of claim 6, wherein:

the information about the set of correct TBs comprises an ordered set of TB identifiers, and a maximum quantity of correct TBs; and
the performing mapping processing on the TB error pattern to obtain the feedback information comprises:

obtaining an ordered set of offset values according to the ordered set of TB identifiers and the maximum quantity of correct TBs;
performing binary representation on offset value elements in the ordered set of offset values to obtain an offset value bit sequence having the same length as the feedback information;
performing compression coding on the TB error pattern to obtain an intermediate codeword; and
adding the intermediate codeword and the offset value bit sequence to obtain the feedback information.

**8.** The method of claim 6, wherein:

the information about the set of correct TBs comprises a set of identifiers of correct TBs, and an ordered set of TB identifiers; and
the obtaining a TB error pattern according to the information about the set of correct TBs comprises:

determining whether each element in the ordered set of TB identifiers belongs to the set of identifiers of correct TBs; and
forming the TB error pattern according to the determination result.

**9.** The method of claim 6, wherein:

the information about the set of correct TBs comprises a set of identifiers of correct TBs; and
the obtaining a TB error pattern according to the information about the set of correct TBs comprises:

according to a preset length of the TB error pattern, obtaining an initial pattern, of the TB error pattern, corresponding to the preset length, wherein each element in the initial pattern of the TB error pattern corresponds to a negative acknowledgment bit;
setting, in the initial pattern of the TB error pattern according to the set of correct TBs, a bit with a sequence number equal to an element in the set of correct TBs as a positive acknowledgment bit; and
determining the initial pattern of the TB error pattern as the TB error pattern.

**10.** The method of claim 1, further comprising:
performing channel coding on the feedback information to obtain a first coding sequence.

**11.** The method of claim 1, wherein the compression coding comprises at least one of the following source coding algorithms:
arithmetic coding, Huffman coding, or Shannon-Fano coding.

**12.** The method of claim 1, wherein the information about the set of correct TBs comprises at least one of:
a maximum quantity of correct TBs, an ordered set of TB identifiers, a quantity of elements in the ordered set of TB identifiers, a set of identifiers of correct TBs, a quantity of correct TBs, an intermediate codeword, a TB error pattern, or an ordered set of offset values.

**13.** The method of claim 12, wherein the maximum quantity of correct TBs is pre-configured by using a higher layer parameter.

**14.** The method of claim 2, wherein the UE identifier comprises at least one of:
a subscription permanent identifier, a generic public subscription identifier, a permanent equipment identifier, a network access identifier, a subscription concealed identifier, a globally unique temporary identity, a radio network temporary identifier (RNTI), a system information RNTI, a paging RNTI, a random access RNTI, a temporary cell RNTI, a cell RNTI, a transmit power control-physical uplink control channel-RNTI, a transmit power control-physical uplink shared channel-RNTI, a transmit power control-sounding reference symbols-RNTI, an interruption RNTI, a modulation coding scheme cell RNTI, a configured scheduling RNTI, a slot format indication RNTI, or a semi-persistent RNTI.

**15.** The method of claim 2, wherein the signature index is a signature index of a random access signature, and the random access signature comprises at least one of:
a pilot, a reference signal, a preamble, a spread spectrum sequence, an interleaver, an interleaver pattern, an interleaver sequence, a scrambling sequence, or a sparse code sequence.

**16.** The method of claim 10, wherein the channel coding comprises at least one of:
polar coding, low-density parity check coding, convolutional coding, turbo coding, Reed-Muller coding, Reed-Solomon coding, Bose-Chaudhuri-Hocquenghem coding, concatenated coding, cyclic coding, block coding, Hamming coding, Golay coding, repetition coding, single-parity-check coding, cyclic redundancy check coding, superposition coding, sparse superposition coding, sparse regression coding, lattice coding, algebraic geometric coding, Goppa coding, polarization-adjusted convolutional coding, pre-transformed polar coding, or parity-check polar coding.

**17.** An information transmission method, which is applied to a second node, the method comprising:

sending a transport block (TB) to a first node; and
receiving feedback information sent by the first node, wherein the feedback information is used to represent a reception condition of the TB.

**18.** The method of claim 17, wherein the TB is indicated by a TB identifier, and the TB identifier comprises at least one of: a user equipment (UE) identifier, an index value of a UE identifier, or a signature index.

**19.** The method of claim 17, further comprising:
decoding a feedback signal corresponding to the feedback information to obtain a decoding result; and
determining, according to the decoding result, the reception condition of the TB sent by the second node.

**20.** The method of claim 19, wherein the determining, according to the decoding result, the reception condition of the TB sent by the second node comprises:
in response to a failure of the decoding, determining that acknowledgment of the TB sent by the second node is negative acknowledgment NACK.

**21.** The method of claim 19, wherein the determining, according to the decoding result, the reception condition of the TB sent by the second node comprises:
in response to a success of the decoding, determining whether a TB identifier in the decoding result belongs to a set of identifiers of correct TBs.

**22.** An information transmission apparatus, comprising:

a receiving module configured to receive a transport block (TB) sent by at least one second node, wherein the TB forms a TB set;
a correct TB information obtaining module configured to obtain information about a set of correct TBs according to the TB set;
a feedback information generation module, configured to encode the information about the set of correct TBs to obtain feedback information, wherein the feedback information is used to represent a reception condition of the TB sent by the at least one second node, and the encoding processing comprises compression coding performed on the information about the set of correct TBs; and
a sending module, configured to send the feedback information to the at least one second node.

**23.** An information transmission apparatus, comprising:

a sending module, configured to send a transport block (TB) to a first node; and
a receiving module, configured to receive feedback information sent by the first node; wherein the feedback information is used to represent a reception condition of the TB.

**24.** A base station, comprising: a memory, a processor, and a computer program stored in the memory and executable by the processor, wherein the computer program, when executed by the processor, causes the processor to perform the information transmission method of any one of claims 1 to 21.

**25.** A user equipment, comprising: a memory, a processor, and a computer program stored in the memory and executable by the processor, wherein the computer program, when executed by the processor, causes the processor to perform the information transmission method of any one of claims 1 to 21.

**26.** A computer-readable storage medium, storing computer-executable instructions configured to cause a computer to perform the information transmission method of any one of claims 1 to 21.

**27.** A computer program product, comprising a computer program or computer instructions stored in a computer-readable storage medium, from which a processor of a computing device reads the computer program or the computer instructions, wherein the computer program or the computer instructions, when executed by the processor, cause the computing device to perform the information transmission method of any one of claims 1 to 21.

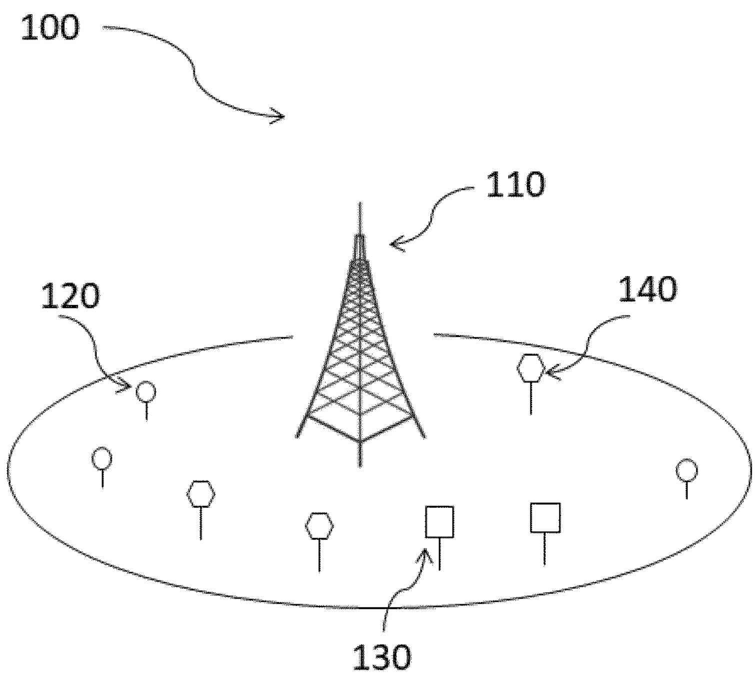


FIG. 1

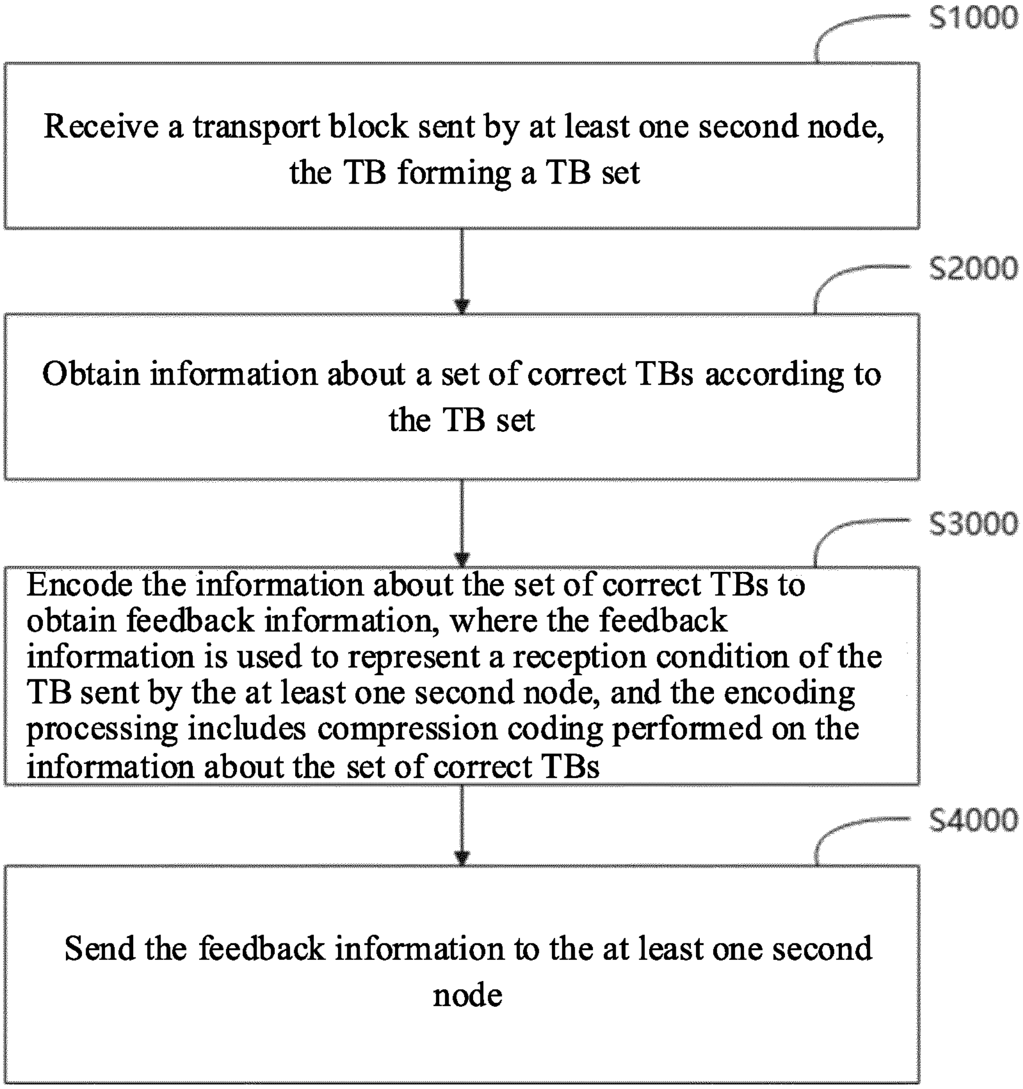
S1000
Receive a transport block sent by at least one second node, the TB forming a TB set
S2000
Obtain information about a set of correct TBs according to the TB set
S3000
Encode the information about the set of correct TBs to obtain feedback information, where the feedback information is used to represent a reception condition of the TB sent by the at least one second node, and the encoding processing includes compression coding performed on the information about the set of correct TBs
S4000
Send the feedback information to the at least one second node

FIG. 2

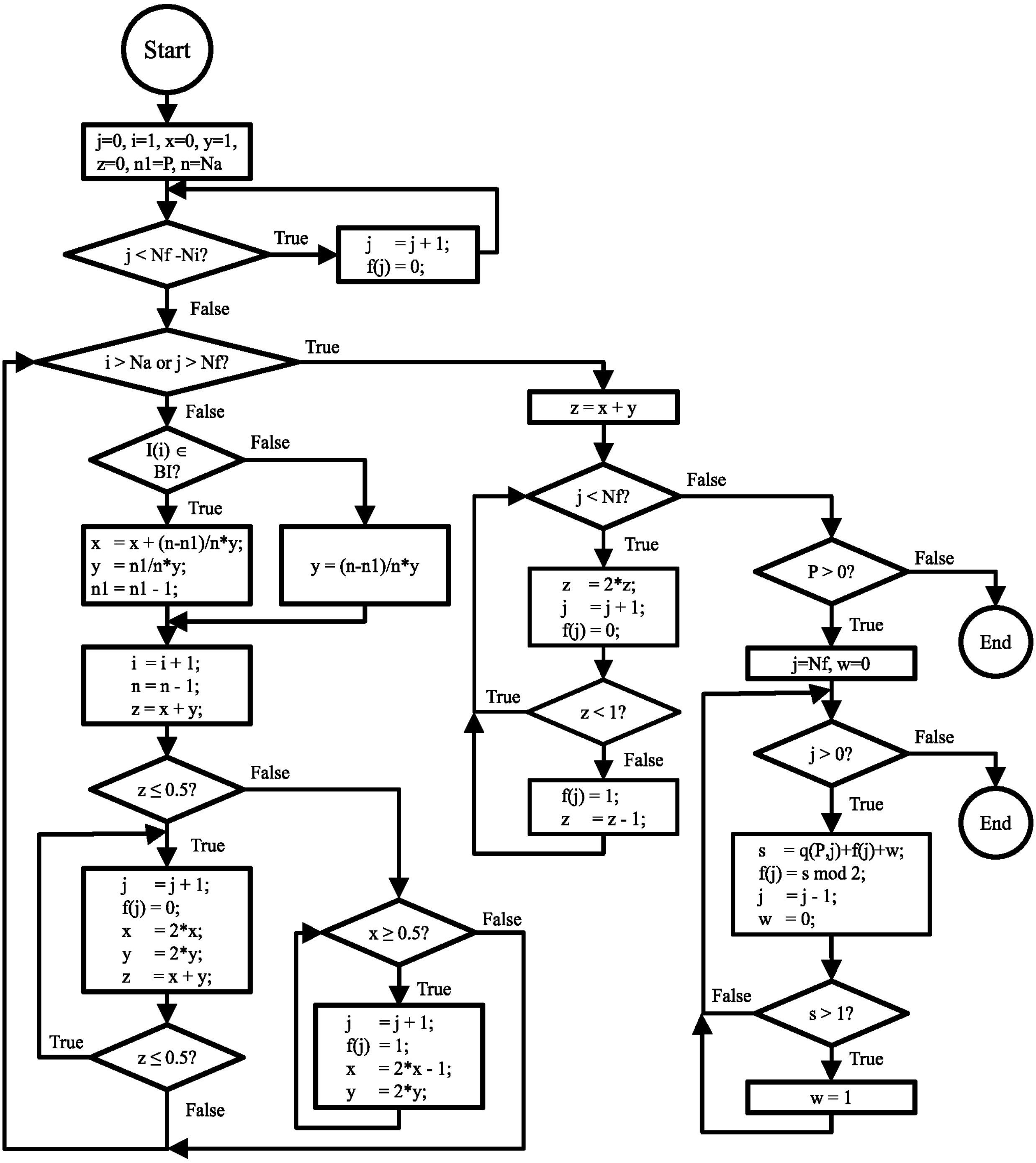
Start
j=0, i=1, x=0, y=1, z=0, n1=P, n=Na
j < Nf -Ni?
True
j = j + 1; f(j) = 0;
False
i > Na or j > Nf?
True
z = x + y
False
I(i) ∈ BI?
False
True
x = x + (n-n1)/n*y; y = n1/n*y; n1 = n1 - 1;
y = (n-n1)/n*y
i = i + 1; n = n - 1; z = x + y;
z ≤ 0.5?
False
True
j = j + 1; f(j) = 0; x = 2*x; y = 2*y; z = x + y;
z ≤ 0.5?
True
False
x ≥ 0.5?
False
True
j = j + 1; f(j) = 1; x = 2*x - 1; y = 2*y;
j < Nf?
False
True
z = 2*z; j = j + 1; f(j) = 0;
z < 1?
True
False
f(j) = 1; z = z - 1;
P > 0?
False
True
End
j=Nf, w=0
j > 0?
False
True
End
s = q(P,j)+f(j)+w; f(j) = s mod 2; j = j - 1; w = 0;
s > 1?
False
True
w = 1

FIG. 3

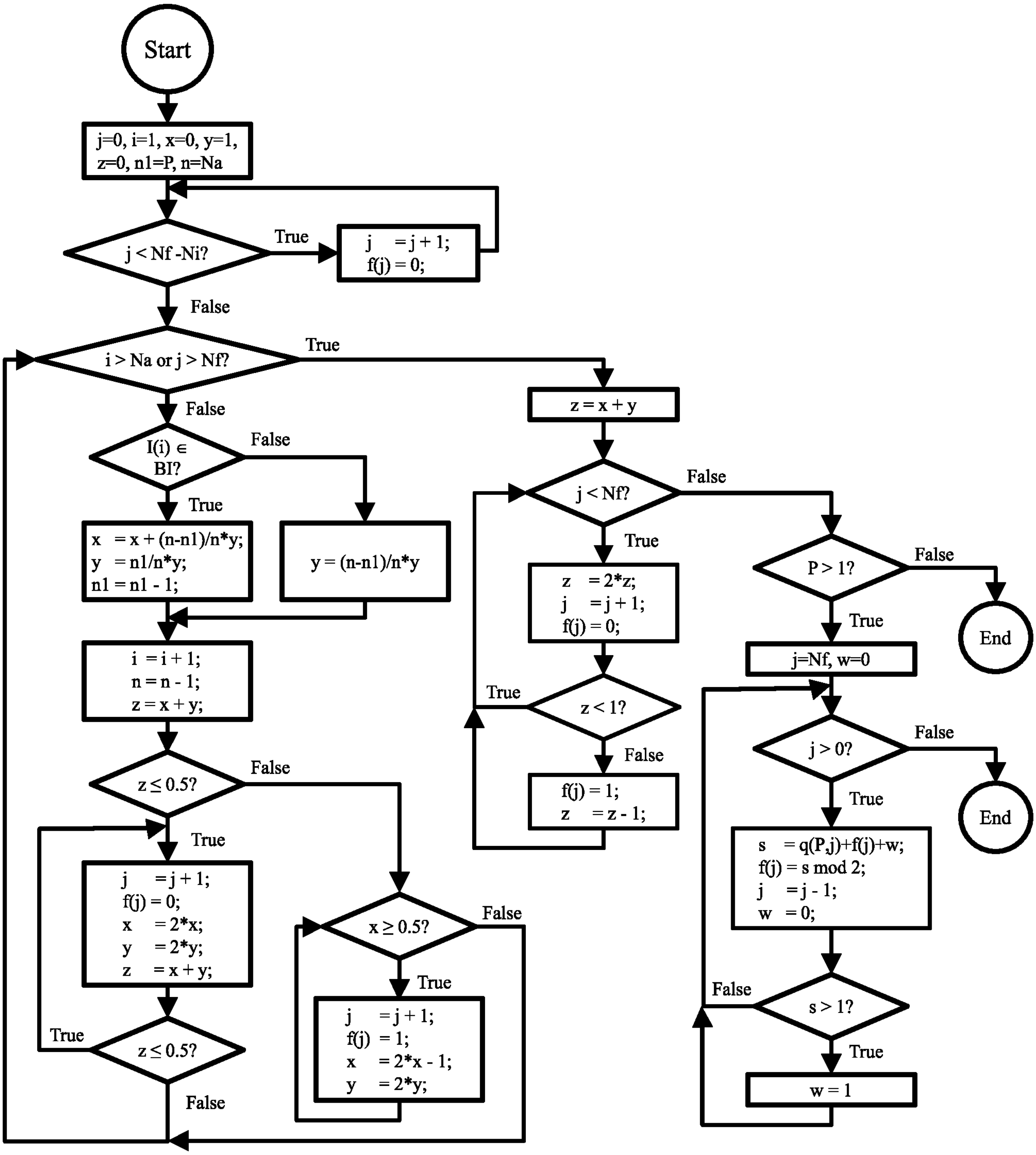
Start
j=0, i=1, x=0, y=1,
z=0, n1=P, n=Na
j < Nf -Ni?
True
j =j + 1;
f(j) = 0;
False
i > Na or j > Nf?
True
False
I(i) ∈
BI?
False
True
x = x + (n-n1)/n*y;
y = n1/n*y;
n1 = n1 - 1;
y = (n-n1)/n*y
i = i + 1;
n = n - 1;
z = x + y;
z ≤ 0.5?
False
True
j = j + 1;
f(j) = 0;
x = 2*x;
y = 2*y;
z = x + y;
z ≤ 0.5?
True
False
x ≥ 0.5?
False
True
j = j + 1;
f(j) = 1;
x = 2*x - 1;
y = 2*y;
z = x + y
j < Nf?
False
True
z = 2*z;
j = j + 1;
f(j) = 0;
z < 1?
True
False
f(j) = 1;
z = z - 1;
P > 1?
False
True
End
j=Nf, w=0
j > 0?
False
True
End
s = q(P,j)+f(j)+w;
f(j) = s mod 2;
j = j - 1;
w = 0;
s > 1?
False
True
w = 1

FIG. 4

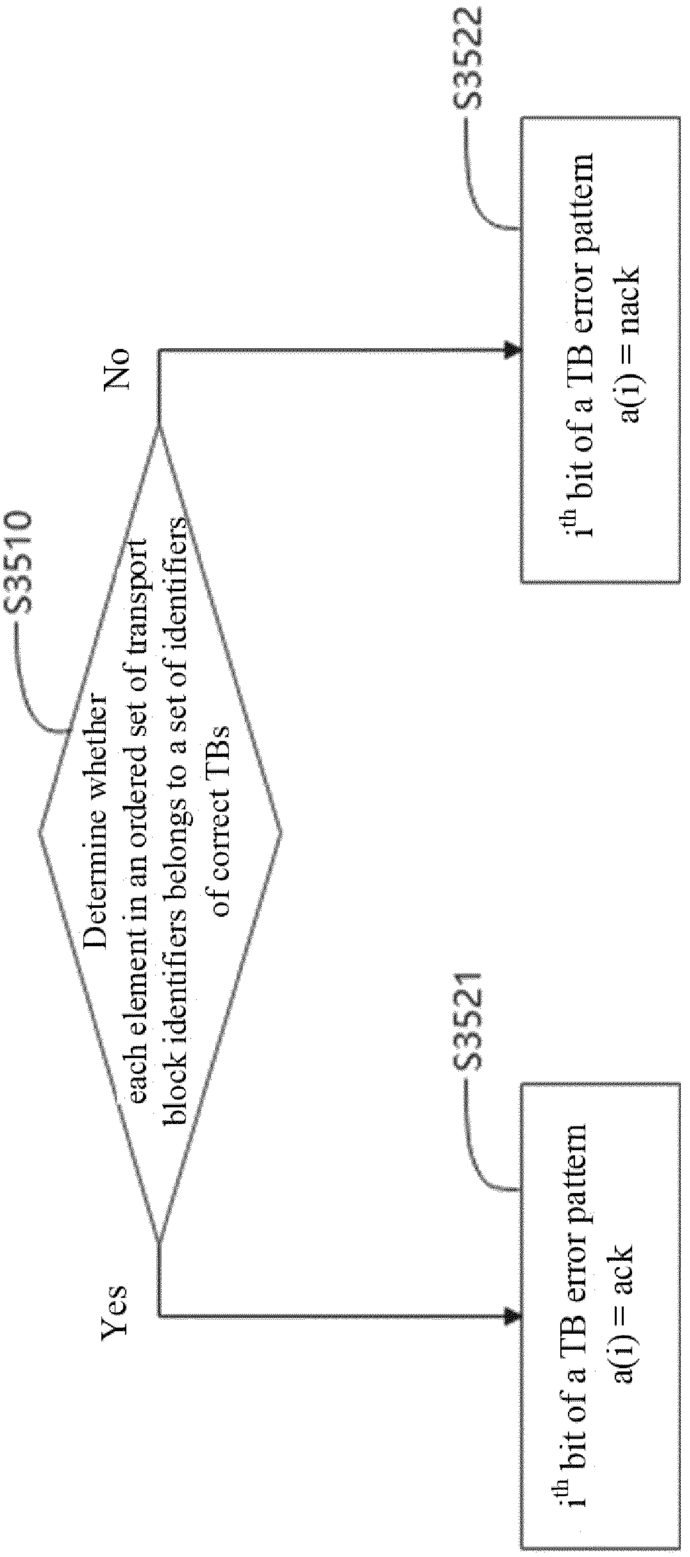
S3510
Determine whether each element in an ordered set of transport block identifiers belongs to a set of identifiers of correct TBs
Yes
No
S3521
$i^{th}$ bit of a TB error pattern
a(i) = ack
S3522
$i^{th}$ bit of a TB error pattern
a(i) = nack

FIG. 5

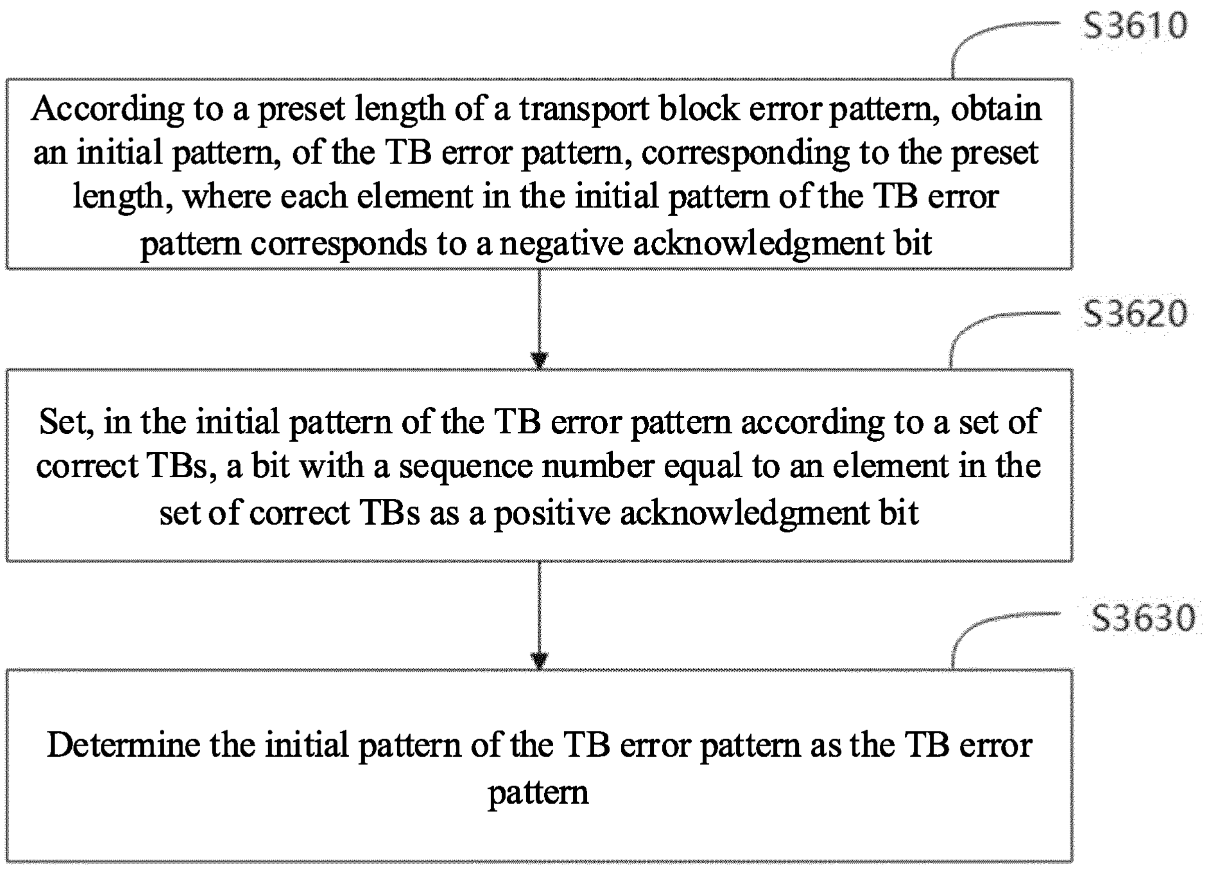
S3610
According to a preset length of a transport block error pattern, obtain an initial pattern, of the TB error pattern, corresponding to the preset length, where each element in the initial pattern of the TB error pattern corresponds to a negative acknowledgment bit
S3620
Set, in the initial pattern of the TB error pattern according to a set of correct TBs, a bit with a sequence number equal to an element in the set of correct TBs as a positive acknowledgment bit
S3630
Determine the initial pattern of the TB error pattern as the TB error pattern

FIG. 6

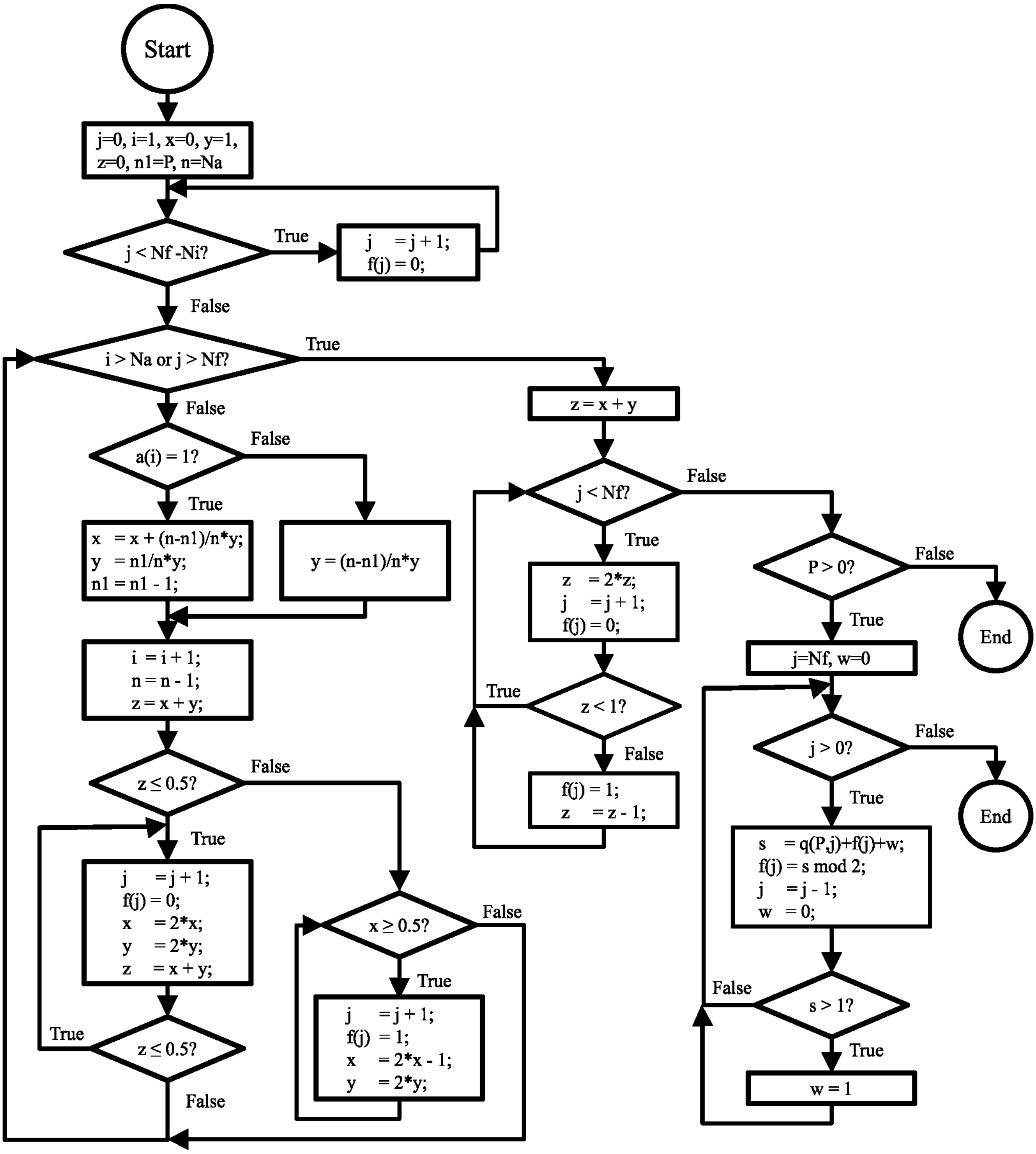
Start
j=0, i=1, x=0, y=1,
z=0, n1=P, n=Na
j < Nf -Ni?
True
j = j + 1;
f(j) = 0;
False
i > Na or j > Nf?
True
False
a(i) = 1?
False
True
x = x + (n-n1)/n*y;
y = n1/n*y;
n1 = n1 - 1;
y = (n-n1)/n*y
i = i + 1;
n = n - 1;
z = x + y;
z ≤ 0.5?
False
True
j = j + 1;
f(j) = 0;
x = 2*x;
y = 2*y;
z = x + y;
True
z ≤ 0.5?
False
x ≥ 0.5?
False
True
j = j + 1;
f(j) = 1;
x = 2*x - 1;
y = 2*y;
z = x + y
j < Nf?
False
True
z = 2*z;
j = j + 1;
f(j) = 0;
True
z < 1?
False
f(j) = 1;
z = z - 1;
P > 0?
False
End
True
j=Nf, w=0
j > 0?
False
End
True
s = q(P,j)+f(j)+w;
f(j) = s mod 2;
j = j - 1;
w = 0;
False
s > 1?
True
w = 1

FIG. 7

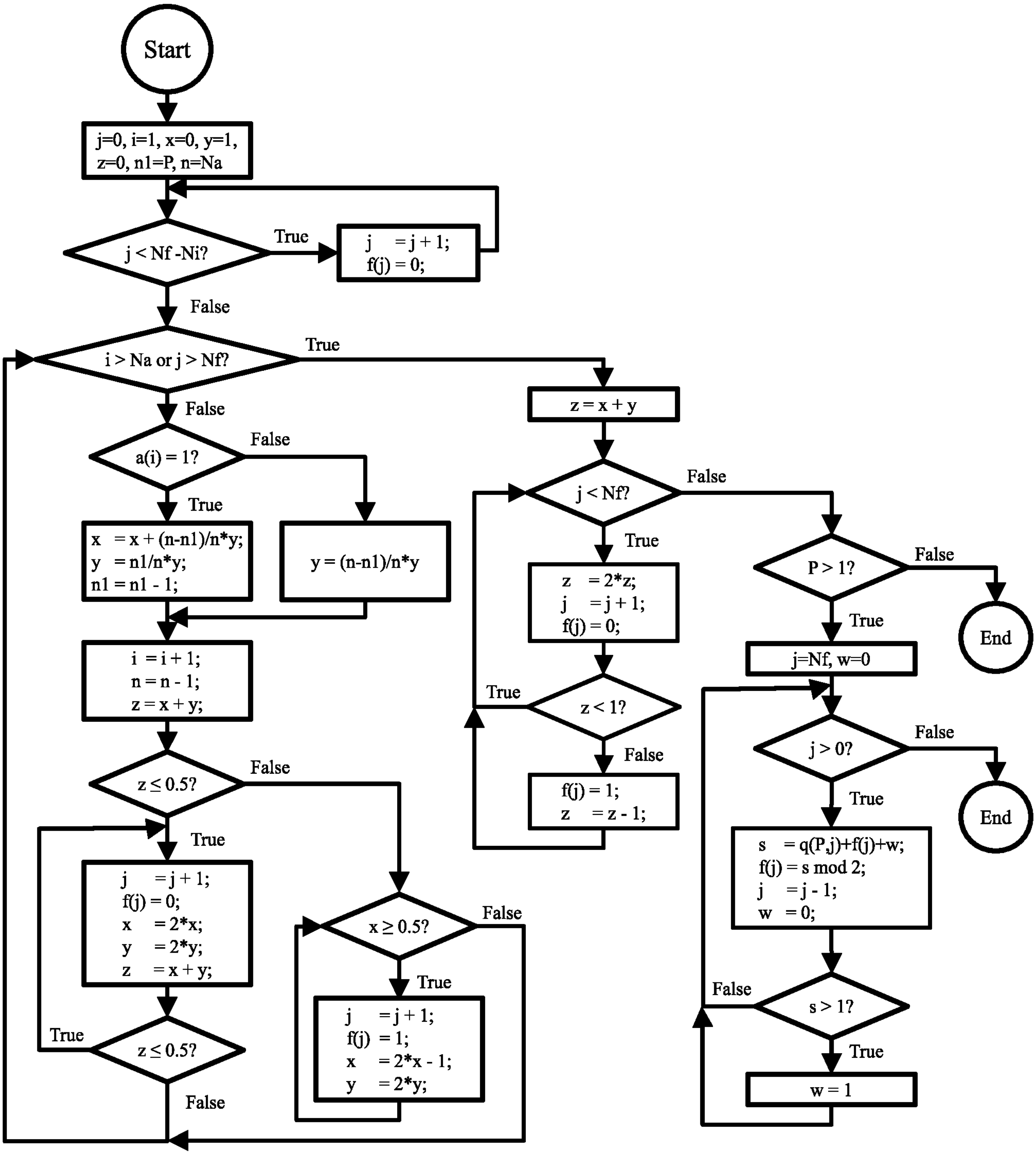
Start
j=0, i=1, x=0, y=1,
z=0, n1=P, n=Na
j < Nf -Ni?
True
j =j + 1;
f(j) = 0;
False
i > Na or j > Nf?
True
False
a(i) = 1?
False
True
x = x + (n-n1)/n*y;
y = n1/n*y;
n1 = n1 - 1;
y = (n-n1)/n*y
i = i + 1;
n = n - 1;
z = x + y;
z ≤ 0.5?
False
True
j = j + 1;
f(j) = 0;
x = 2*x;
y = 2*y;
z = x + y;
True
z ≤ 0.5?
False
x ≥ 0.5?
False
True
j = j + 1;
f(j) = 1;
x = 2*x - 1;
y = 2*y;
z = x + y
j < Nf?
False
True
z = 2*z;
j = j + 1;
f(j) = 0;
True
z < 1?
False
f(j) = 1;
z = z - 1;
P > 1?
False
End
True
j=Nf, w=0
j > 0?
False
End
True
s = q(P,j)+f(j)+w;
f(j) = s mod 2;
j = j - 1;
w = 0;
False
s > 1?
True
w = 1

FIG. 8

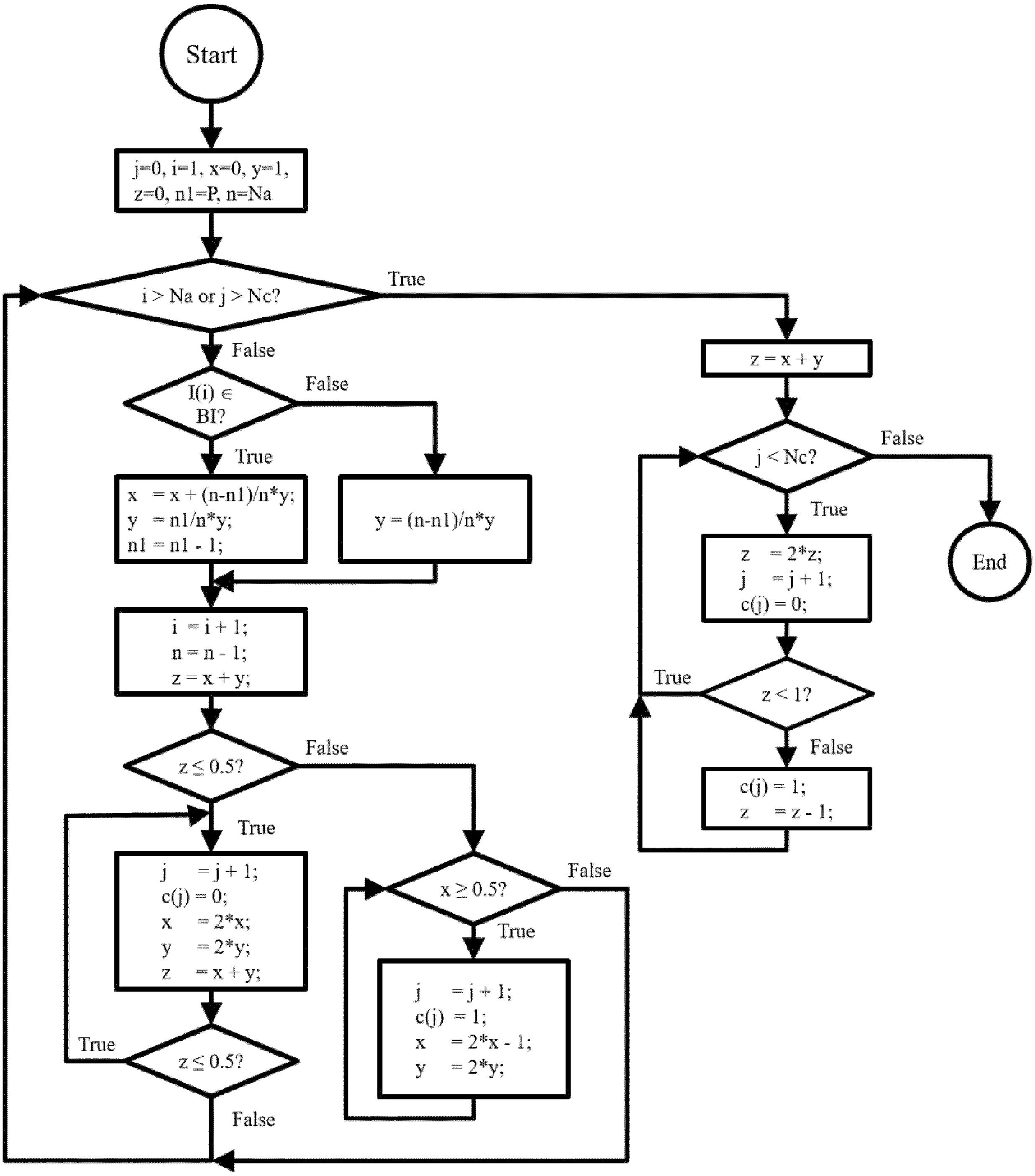
Start
j=0, i=1, x=0, y=1,
z=0, n1=P, n=Na
i > Na or j > Nc?
True
False
I(i) ∈ BI?
False
True
x = x + (n-n1)/n*y;
y = n1/n*y;
n1 = n1 - 1;
y = (n-n1)/n*y
i = i + 1;
n = n - 1;
z = x + y;
z ≤ 0.5?
False
True
j = j + 1;
c(j) = 0;
x = 2*x;
y = 2*y;
z = x + y;
True
z ≤ 0.5?
False
x ≥ 0.5?
False
True
j = j + 1;
c(j) = 1;
x = 2*x - 1;
y = 2*y;
z = x + y
j < Nc?
False
True
z = 2*z;
j = j + 1;
c(j) = 0;
End
True
z < 1?
False
c(j) = 1;
z = z - 1;

FIG. 9

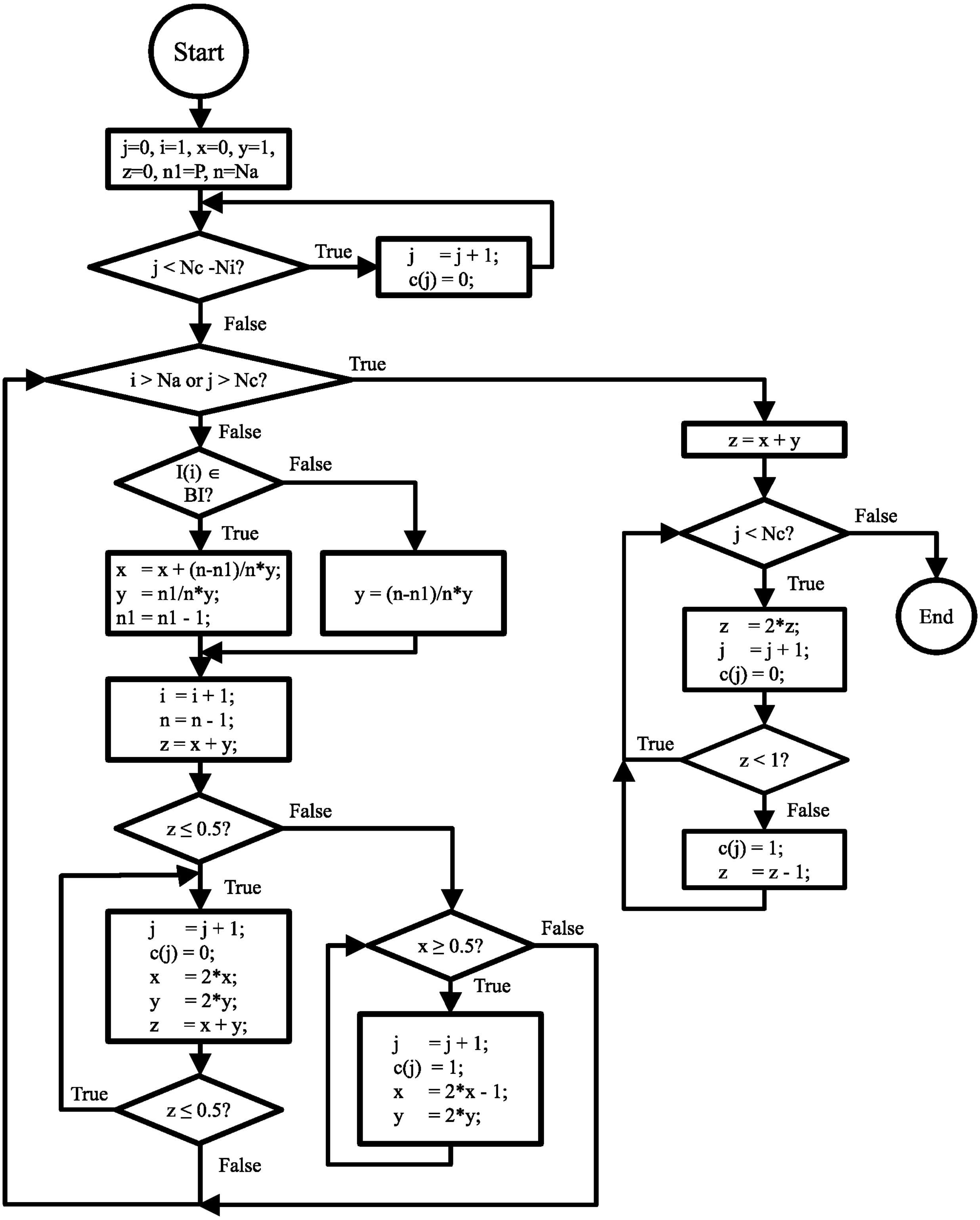

Start
j=0, i=1, x=0, y=1,
z=0, n1=P, n=Na
j < Nc -Ni?
True
j = j + 1;
c(j) = 0;
False
i > Na or j > Nc?
True
False
I(i) ∈
BI?
False
True
x = x + (n-n1)/n*y;
y = n1/n*y;
n1 = n1 - 1;
y = (n-n1)/n*y
i = i + 1;
n = n - 1;
z = x + y;
z ≤ 0.5?
False
True
j = j + 1;
c(j) = 0;
x = 2*x;
y = 2*y;
z = x + y;
True
z ≤ 0.5?
False
x ≥ 0.5?
False
True
j = j + 1;
c(j) = 1;
x = 2*x - 1;
y = 2*y;
z = x + y
j < Nc?
False
True
End
z = 2*z;
j = j + 1;
c(j) = 0;
True
z < 1?
False
c(j) = 1;
z = z - 1;


FIG. 10

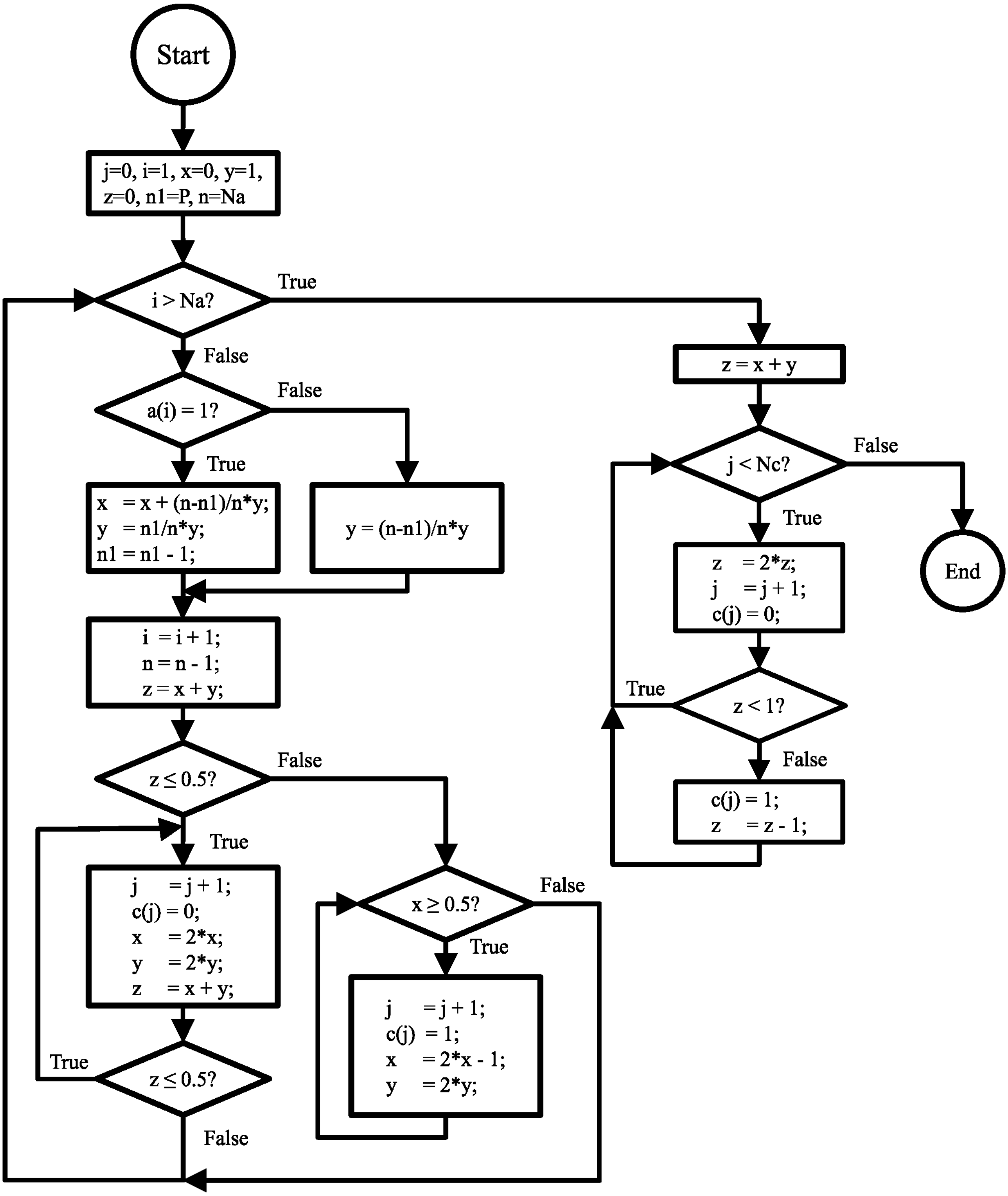
Start
j=0, i=1, x=0, y=1,
z=0, n1=P, n=Na
i > Na?
True
False
a(i) = 1?
False
True
x = x + (n-n1)/n*y;
y = n1/n*y;
n1 = n1 - 1;
y = (n-n1)/n*y
i = i + 1;
n = n - 1;
z = x + y;
z ≤ 0.5?
False
True
j = j + 1;
c(j) = 0;
x = 2*x;
y = 2*y;
z = x + y;
True
z ≤ 0.5?
False
x ≥ 0.5?
False
True
j = j + 1;
c(j) = 1;
x = 2*x - 1;
y = 2*y;
z = x + y
j < Nc?
False
True
End
z = 2*z;
j = j + 1;
c(j) = 0;
True
z < 1?
False
c(j) = 1;
z = z - 1;

FIG. 11

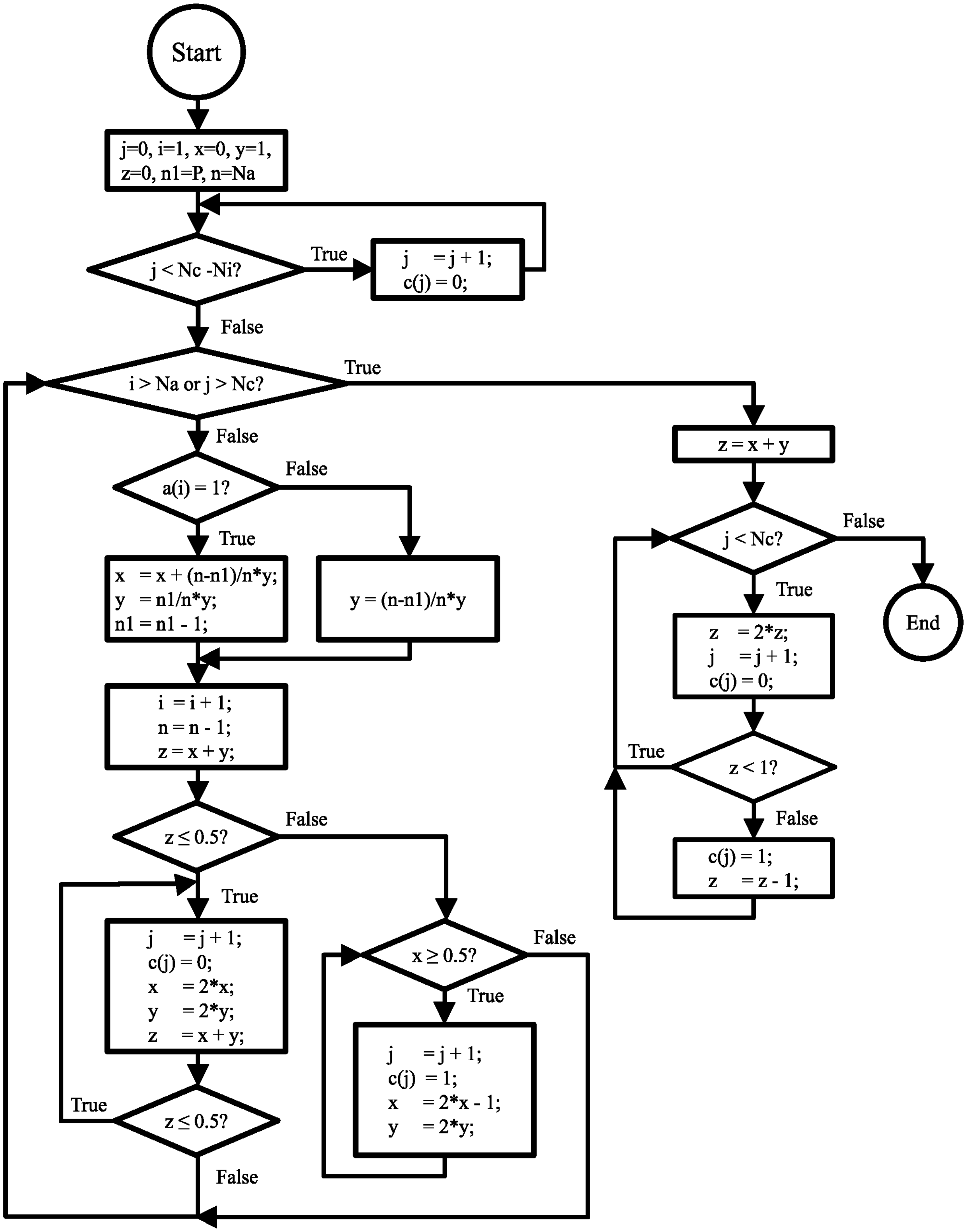
Start
j=0, i=1, x=0, y=1,
z=0, n1=P, n=Na
j < Nc -Ni?
True
j =j + 1;
c(j) = 0;
False
i > Na or j > Nc?
True
False
z = x + y
a(i) = 1?
False
True
x =x + (n-n1)/n*y;
y =n1/n*y;
n1 = n1 - 1;
y = (n-n1)/n*y
j < Nc?
False
True
End
z =2*z;
j =j + 1;
c(j) = 0;
i =i + 1;
n = n - 1;
z = x + y;
True
z < 1?
False
c(j) = 1;
z =z - 1;
z ≤ 0.5?
False
True
j =j + 1;
c(j) = 0;
x =2*x;
y =2*y;
z =x + y;
x ≥ 0.5?
False
True
j =j + 1;
c(j) =1;
x =2*x - 1;
y =2*y;
True
z ≤ 0.5?
False

FIG. 12

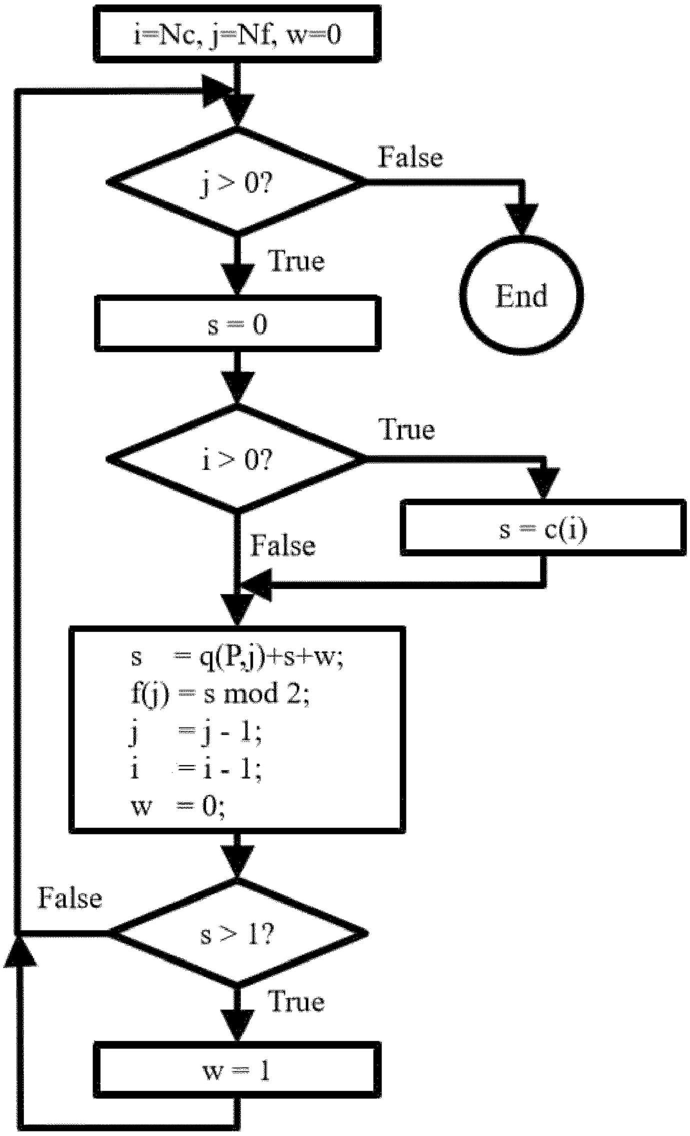
i=Nc, j=Nf, w=0
j > 0?
False
End
True
s = 0
i > 0?
True
s = c(i)
False
s = q(P,j)+s+w;
f(j) = s mod 2;
j = j - 1;
i = i - 1;
w = 0;
False
s > 1?
True
w = 1

FIG. 13

| Second node (terminal device) | Transport block | Transport block identifier (UE identifier) |
|---|---|---|
| SN(1) | b(1) | 4 |
| SN(2) | b(2) | 3 |
| SN(3) | b(3) | 2 |
| SN(4) | b(4) | 5 |

FIG. 14

| P | BI | a | | | | | | | | c | | | | | | | [q(P, 1), q(P, 2), q(P, 3), q(P, 4), q(P, 5), q(P, 6), q(P, 7)] | f | | | | | | |
|---|---|---|---|---|---|---|---|---|---|---|---|---|---|---|---|---|---|---|---|---|---|---|---|---|
| 2 | {7, 8} | 0 | 0 | 0 | 0 | 0 | 0 | 1 | 1 | 0 | 0 | 0 | 0 | 0 | 0 | 1 | [0, 0, 0, 1, 0, 0, 1] | 0 | 0 | 0 | 1 | 0 | 1 | 0 |
| | {6, 8} | 0 | 0 | 0 | 0 | 0 | 1 | 0 | 1 | 0 | 0 | 0 | 0 | 0 | 1 | 0 | | 0 | 0 | 0 | 1 | 0 | 1 | 1 |
| | {6, 7} | 0 | 0 | 0 | 0 | 0 | 1 | 1 | 0 | 0 | 0 | 0 | 0 | 0 | 1 | 1 | | 0 | 0 | 0 | 1 | 1 | 0 | 0 |
| | {5, 8} | 0 | 0 | 0 | 0 | 1 | 0 | 0 | 1 | 0 | 0 | 0 | 0 | 1 | 0 | 0 | | 0 | 0 | 0 | 1 | 1 | 0 | 1 |
| | {5, 7} | 0 | 0 | 0 | 0 | 1 | 0 | 1 | 0 | 0 | 0 | 0 | 0 | 1 | 0 | 1 | | 0 | 0 | 0 | 1 | 1 | 1 | 0 |
| | {5, 6} | 0 | 0 | 0 | 0 | 1 | 1 | 0 | 0 | 0 | 0 | 0 | 0 | 1 | 1 | 0 | | 0 | 0 | 0 | 1 | 1 | 1 | 1 |
| | {4, 8} | 0 | 0 | 0 | 1 | 0 | 0 | 0 | 1 | 0 | 0 | 0 | 0 | 1 | 1 | 1 | | 0 | 0 | 1 | 0 | 0 | 0 | 0 |
| | {4, 7} | 0 | 0 | 0 | 1 | 0 | 0 | 1 | 0 | 0 | 0 | 0 | 1 | 0 | 0 | 1 | | 0 | 0 | 1 | 0 | 0 | 1 | 0 |
| | {4, 6} | 0 | 0 | 0 | 1 | 0 | 1 | 0 | 0 | 0 | 0 | 0 | 1 | 0 | 1 | 0 | | 0 | 0 | 1 | 0 | 0 | 1 | 1 |
| | {4, 5} | 0 | 0 | 0 | 1 | 1 | 0 | 0 | 0 | 0 | 0 | 0 | 1 | 0 | 1 | 1 | | 0 | 0 | 1 | 0 | 1 | 0 | 0 |
| | {3, 8} | 0 | 0 | 1 | 0 | 0 | 0 | 0 | 1 | 0 | 0 | 0 | 1 | 1 | 0 | 0 | | 0 | 0 | 1 | 0 | 1 | 0 | 1 |
| | {3, 7} | 0 | 0 | 1 | 0 | 0 | 0 | 1 | 0 | 0 | 0 | 0 | 1 | 1 | 0 | 1 | | 0 | 0 | 1 | 0 | 1 | 1 | 0 |
| | {3, 6} | 0 | 0 | 1 | 0 | 0 | 1 | 0 | 0 | 0 | 0 | 0 | 1 | 1 | 1 | 0 | | 0 | 0 | 1 | 0 | 1 | 1 | 1 |
| | {3, 5} | 0 | 0 | 1 | 0 | 1 | 0 | 0 | 0 | 0 | 0 | 0 | 1 | 1 | 1 | 1 | | 0 | 0 | 1 | 1 | 0 | 0 | 0 |
| | {3, 4} | 0 | 0 | 1 | 1 | 0 | 0 | 0 | 0 | 0 | 0 | 1 | 0 | 0 | 0 | 1 | | 0 | 0 | 1 | 1 | 0 | 1 | 0 |
| | {2, 8} | 0 | 1 | 0 | 0 | 0 | 0 | 0 | 1 | 0 | 0 | 1 | 0 | 0 | 1 | 0 | | 0 | 0 | 1 | 1 | 0 | 1 | 1 |
| | {2, 7} | 0 | 1 | 0 | 0 | 0 | 0 | 1 | 0 | 0 | 0 | 1 | 0 | 0 | 1 | 1 | | 0 | 0 | 1 | 1 | 1 | 0 | 0 |
| | {2, 6} | 0 | 1 | 0 | 0 | 0 | 1 | 0 | 0 | 0 | 0 | 1 | 0 | 1 | 0 | 0 | | 0 | 0 | 1 | 1 | 1 | 0 | 1 |
| | {2, 5} | 0 | 1 | 0 | 0 | 1 | 0 | 0 | 0 | 0 | 0 | 1 | 0 | 1 | 0 | 1 | | 0 | 0 | 1 | 1 | 1 | 1 | 0 |
| | {2, 4} | 0 | 1 | 0 | 1 | 0 | 0 | 0 | 0 | 0 | 0 | 1 | 0 | 1 | 1 | 0 | | 0 | 0 | 1 | 1 | 1 | 1 | 1 |
| | **{2, 3}** | **0** | **1** | **1** | **0** | **0** | **0** | **0** | **0** | **0** | **0** | **1** | **0** | **1** | **1** | **1** | | **0** | **1** | **0** | **0** | **0** | **0** | **0** |
| | {1, 8} | 1 | 0 | 0 | 0 | 0 | 0 | 0 | 1 | 0 | 0 | 1 | 1 | 0 | 0 | 1 | | 0 | 1 | 0 | 0 | 0 | 1 | 0 |
| | {1, 7} | 1 | 0 | 0 | 0 | 0 | 0 | 1 | 0 | 0 | 0 | 1 | 1 | 0 | 1 | 0 | | 0 | 1 | 0 | 0 | 0 | 1 | 1 |
| | {1, 6} | 1 | 0 | 0 | 0 | 0 | 1 | 0 | 0 | 0 | 0 | 1 | 1 | 0 | 1 | 1 | | 0 | 1 | 0 | 0 | 1 | 0 | 0 |
| | {1, 5} | 1 | 0 | 0 | 0 | 1 | 0 | 0 | 0 | 0 | 0 | 1 | 1 | 1 | 0 | 0 | | 0 | 1 | 0 | 0 | 1 | 0 | 1 |
| | {1, 4} | 1 | 0 | 0 | 1 | 0 | 0 | 0 | 0 | 0 | 0 | 1 | 1 | 1 | 0 | 1 | | 0 | 1 | 0 | 0 | 1 | 1 | 0 |
| | {1, 3} | 1 | 0 | 1 | 0 | 0 | 0 | 0 | 0 | 0 | 0 | 1 | 1 | 1 | 1 | 0 | | 0 | 1 | 0 | 0 | 1 | 1 | 1 |
| | {1, 2} | 1 | 1 | 0 | 0 | 0 | 0 | 0 | 0 | 0 | 0 | 1 | 1 | 1 | 1 | 1 | | 0 | 1 | 0 | 1 | 0 | 0 | 0 |

FIG. 15

| P | BI | a | | | | | | | | c | | | | | [q(P, 1), q(P, 2), q(P, 3), q(P, 4), q(P, 5), q(P, 6), q(P, 7)] | f | | | | | | |
|---|---|---|---|---|---|---|---|---|---|---|---|---|---|---|---|---|---|---|---|---|---|---|
| 2 | {1, 2} | 0 | 0 | 1 | 1 | 1 | 1 | 1 | 1 | 0 | 0 | 0 | 0 | 1 | [0, 0, 0, 1, 0, 0, 1] | 0 | 0 | 0 | 1 | 0 | 1 | 0 |
| | {1, 3} | 0 | 1 | 0 | 1 | 1 | 1 | 1 | 1 | 0 | 0 | 0 | 1 | 0 | | 0 | 0 | 0 | 1 | 0 | 1 | 1 |
| | {1, 4} | 0 | 1 | 1 | 0 | 1 | 1 | 1 | 1 | 0 | 0 | 0 | 1 | 1 | | 0 | 0 | 0 | 1 | 1 | 0 | 0 |
| | {1, 5} | 0 | 1 | 1 | 1 | 0 | 1 | 1 | 1 | 0 | 0 | 1 | 0 | 0 | | 0 | 0 | 0 | 1 | 1 | 0 | 1 |
| | {1, 6} | 0 | 1 | 1 | 1 | 1 | 0 | 1 | 1 | 0 | 0 | 1 | 0 | 1 | | 0 | 0 | 0 | 1 | 1 | 1 | 0 |
| | {1, 7} | 0 | 1 | 1 | 1 | 1 | 1 | 0 | 1 | 0 | 0 | 1 | 1 | 0 | | 0 | 0 | 0 | 1 | 1 | 1 | 1 |
| | {1, 8} | 0 | 1 | 1 | 1 | 1 | 1 | 1 | 0 | 0 | 0 | 1 | 1 | 1 | | 0 | 0 | 1 | 0 | 0 | 0 | 0 |
| | **{2, 3}** | **1** | **0** | **0** | **1** | **1** | **1** | **1** | **1** | **0** | **1** | **0** | **0** | **1** | | **0** | **0** | **1** | **0** | **0** | **1** | **0** |
| | {2, 4} | 1 | 0 | 1 | 0 | 1 | 1 | 1 | 1 | 0 | 1 | 0 | 1 | 0 | | 0 | 0 | 1 | 0 | 0 | 1 | 1 |
| | {2, 5} | 1 | 0 | 1 | 1 | 0 | 1 | 1 | 1 | 0 | 1 | 0 | 1 | 1 | | 0 | 0 | 1 | 0 | 1 | 0 | 0 |
| | {2, 6} | 1 | 0 | 1 | 1 | 1 | 0 | 1 | 1 | 0 | 1 | 1 | 0 | 0 | | 0 | 0 | 1 | 0 | 1 | 0 | 1 |
| | {2, 7} | 1 | 0 | 1 | 1 | 1 | 1 | 0 | 1 | 0 | 1 | 1 | 0 | 1 | | 0 | 0 | 1 | 0 | 1 | 1 | 0 |
| | {2, 8} | 1 | 0 | 1 | 1 | 1 | 1 | 1 | 0 | 0 | 1 | 1 | 1 | 0 | | 0 | 0 | 1 | 0 | 1 | 1 | 1 |
| | {3, 4} | 1 | 1 | 0 | 0 | 1 | 1 | 1 | 1 | 0 | 1 | 1 | 1 | 1 | | 0 | 0 | 1 | 1 | 0 | 0 | 0 |
| | {3, 5} | 1 | 1 | 0 | 1 | 0 | 1 | 1 | 1 | 1 | 0 | 0 | 0 | 1 | | 0 | 0 | 1 | 1 | 0 | 1 | 0 |
| | {3, 6} | 1 | 1 | 0 | 1 | 1 | 0 | 1 | 1 | 1 | 0 | 0 | 1 | 0 | | 0 | 0 | 1 | 1 | 0 | 1 | 1 |
| | {3, 7} | 1 | 1 | 0 | 1 | 1 | 1 | 0 | 1 | 1 | 0 | 0 | 1 | 1 | | 0 | 0 | 1 | 1 | 1 | 0 | 0 |
| | {3, 8} | 1 | 1 | 0 | 1 | 1 | 1 | 1 | 0 | 1 | 0 | 1 | 0 | 0 | | 0 | 0 | 1 | 1 | 1 | 0 | 1 |
| | {4, 5} | 1 | 1 | 1 | 0 | 0 | 1 | 1 | 1 | 1 | 0 | 1 | 0 | 1 | | 0 | 0 | 1 | 1 | 1 | 1 | 0 |
| | {4, 6} | 1 | 1 | 1 | 0 | 1 | 0 | 1 | 1 | 1 | 0 | 1 | 1 | 0 | | 0 | 0 | 1 | 1 | 1 | 1 | 1 |
| | {4, 7} | 1 | 1 | 1 | 0 | 1 | 1 | 0 | 1 | 1 | 0 | 1 | 1 | 1 | | 0 | 1 | 0 | 0 | 0 | 0 | 0 |
| | {4, 8} | 1 | 1 | 1 | 0 | 1 | 1 | 1 | 0 | 1 | 1 | 0 | 0 | 1 | | 0 | 1 | 0 | 0 | 0 | 1 | 0 |
| | {5, 6} | 1 | 1 | 1 | 1 | 0 | 0 | 1 | 1 | 1 | 1 | 0 | 1 | 0 | | 0 | 1 | 0 | 0 | 0 | 1 | 1 |
| | {5, 7} | 1 | 1 | 1 | 1 | 0 | 1 | 0 | 1 | 1 | 1 | 0 | 1 | 1 | | 0 | 1 | 0 | 0 | 1 | 0 | 0 |
| | {5, 8} | 1 | 1 | 1 | 1 | 0 | 1 | 1 | 0 | 1 | 1 | 1 | 0 | 0 | | 0 | 1 | 0 | 0 | 1 | 0 | 1 |
| | {6, 7} | 1 | 1 | 1 | 1 | 1 | 0 | 0 | 1 | 1 | 1 | 1 | 0 | 1 | | 0 | 1 | 0 | 0 | 1 | 1 | 0 |
| | {6, 8} | 1 | 1 | 1 | 1 | 1 | 0 | 1 | 0 | 1 | 1 | 1 | 1 | 0 | | 0 | 1 | 0 | 0 | 1 | 1 | 1 |
| | {7, 8} | 1 | 1 | 1 | 1 | 1 | 1 | 0 | 0 | 1 | 1 | 1 | 1 | 1 | | 0 | 1 | 0 | 1 | 0 | 0 | 0 |

FIG. 16

| P | BI | a | | | | | | | | c | | | | | | | [q(P, 1), q(P, 2), q(P, 3), q(P, 4), q(P, 5), q(P, 6), q(P, 7)] | f | | | | | | |
|---|---|---|---|---|---|---|---|---|---|---|---|---|---|---|---|---|---|---|---|---|---|---|---|---|
| 2 | {7, 8} | 0 | 0 | 0 | 0 | 0 | 0 | 1 | 1 | 0 | 0 | 0 | 0 | 0 | 0 | 1 | [0, 0, 0, 1, 0, 0, 0] | 0 | 0 | 0 | 1 | 0 | 0 | 1 |
| | {6, 8} | 0 | 0 | 0 | 0 | 0 | 1 | 0 | 1 | 0 | 0 | 0 | 0 | 0 | 1 | 0 | | 0 | 0 | 0 | 1 | 0 | 1 | 0 |
| | {6, 7} | 0 | 0 | 0 | 0 | 0 | 1 | 1 | 0 | 0 | 0 | 0 | 0 | 0 | 1 | 1 | | 0 | 0 | 0 | 1 | 0 | 1 | 1 |
| | {5, 8} | 0 | 0 | 0 | 0 | 1 | 0 | 0 | 1 | 0 | 0 | 0 | 0 | 1 | 0 | 0 | | 0 | 0 | 0 | 1 | 1 | 0 | 0 |
| | {5, 7} | 0 | 0 | 0 | 0 | 1 | 0 | 1 | 0 | 0 | 0 | 0 | 0 | 1 | 0 | 1 | | 0 | 0 | 0 | 1 | 1 | 0 | 1 |
| | {5, 6} | 0 | 0 | 0 | 0 | 1 | 1 | 0 | 0 | 0 | 0 | 0 | 0 | 1 | 1 | 0 | | 0 | 0 | 0 | 1 | 1 | 1 | 0 |
| | {4, 8} | 0 | 0 | 0 | 1 | 0 | 0 | 0 | 1 | 0 | 0 | 0 | 0 | 1 | 1 | 1 | | 0 | 0 | 0 | 1 | 1 | 1 | 1 |
| | {4, 7} | 0 | 0 | 0 | 1 | 0 | 0 | 1 | 0 | 0 | 0 | 0 | 1 | 0 | 0 | 1 | | 0 | 0 | 1 | 0 | 0 | 0 | 1 |
| | {4, 6} | 0 | 0 | 0 | 1 | 0 | 1 | 0 | 0 | 0 | 0 | 0 | 1 | 0 | 1 | 0 | | 0 | 0 | 1 | 0 | 0 | 1 | 0 |
| | {4, 5} | 0 | 0 | 0 | 1 | 1 | 0 | 0 | 0 | 0 | 0 | 0 | 1 | 0 | 1 | 1 | | 0 | 0 | 1 | 0 | 0 | 1 | 1 |
| | {3, 8} | 0 | 0 | 1 | 0 | 0 | 0 | 0 | 1 | 0 | 0 | 0 | 1 | 1 | 0 | 0 | | 0 | 0 | 1 | 0 | 1 | 0 | 0 |
| | {3, 7} | 0 | 0 | 1 | 0 | 0 | 0 | 1 | 0 | 0 | 0 | 0 | 1 | 1 | 0 | 1 | | 0 | 0 | 1 | 0 | 1 | 0 | 1 |
| | {3, 6} | 0 | 0 | 1 | 0 | 0 | 1 | 0 | 0 | 0 | 0 | 0 | 1 | 1 | 1 | 0 | | 0 | 0 | 1 | 0 | 1 | 1 | 0 |
| | {3, 5} | 0 | 0 | 1 | 0 | 1 | 0 | 0 | 0 | 0 | 0 | 0 | 1 | 1 | 1 | 1 | | 0 | 0 | 1 | 0 | 1 | 1 | 1 |
| | {3, 4} | 0 | 0 | 1 | 1 | 0 | 0 | 0 | 0 | 0 | 0 | 1 | 0 | 0 | 0 | 1 | | 0 | 0 | 1 | 1 | 0 | 0 | 1 |
| | {2, 8} | 0 | 1 | 0 | 0 | 0 | 0 | 0 | 1 | 0 | 0 | 1 | 0 | 0 | 1 | 0 | | 0 | 0 | 1 | 1 | 0 | 1 | 0 |
| | {2, 7} | 0 | 1 | 0 | 0 | 0 | 0 | 1 | 0 | 0 | 0 | 1 | 0 | 0 | 1 | 1 | | 0 | 0 | 1 | 1 | 0 | 1 | 1 |
| | {2, 6} | 0 | 1 | 0 | 0 | 0 | 1 | 0 | 0 | 0 | 0 | 1 | 0 | 1 | 0 | 0 | | 0 | 0 | 1 | 1 | 1 | 0 | 0 |
| | {2, 5} | 0 | 1 | 0 | 0 | 1 | 0 | 0 | 0 | 0 | 0 | 1 | 0 | 1 | 0 | 1 | | 0 | 0 | 1 | 1 | 1 | 0 | 1 |
| | {2, 4} | 0 | 1 | 0 | 1 | 0 | 0 | 0 | 0 | 0 | 0 | 1 | 0 | 1 | 1 | 0 | | 0 | 0 | 1 | 1 | 1 | 1 | 0 |
| | **{2, 3}** | **0** | **1** | **1** | **0** | **0** | **0** | **0** | **0** | **0** | **0** | **1** | **0** | **1** | **1** | **1** | | **0** | **0** | **1** | **1** | **1** | **1** | **1** |
| | {1, 8} | 1 | 0 | 0 | 0 | 0 | 0 | 0 | 1 | 0 | 0 | 1 | 1 | 0 | 0 | 1 | | 0 | 1 | 0 | 0 | 0 | 0 | 1 |
| | {1, 7} | 1 | 0 | 0 | 0 | 0 | 0 | 1 | 0 | 0 | 0 | 1 | 1 | 0 | 1 | 0 | | 0 | 1 | 0 | 0 | 0 | 1 | 0 |
| | {1, 6} | 1 | 0 | 0 | 0 | 0 | 1 | 0 | 0 | 0 | 0 | 1 | 1 | 0 | 1 | 1 | | 0 | 1 | 0 | 0 | 0 | 1 | 1 |
| | {1, 5} | 1 | 0 | 0 | 0 | 1 | 0 | 0 | 0 | 0 | 0 | 1 | 1 | 1 | 0 | 0 | | 0 | 1 | 0 | 0 | 1 | 0 | 0 |
| | {1, 4} | 1 | 0 | 0 | 1 | 0 | 0 | 0 | 0 | 0 | 0 | 1 | 1 | 1 | 0 | 1 | | 0 | 1 | 0 | 0 | 1 | 0 | 1 |
| | {1, 3} | 1 | 0 | 1 | 0 | 0 | 0 | 0 | 0 | 0 | 0 | 1 | 1 | 1 | 1 | 0 | | 0 | 1 | 0 | 0 | 1 | 1 | 0 |
| | {1, 2} | 1 | 1 | 0 | 0 | 0 | 0 | 0 | 0 | 0 | 0 | 1 | 1 | 1 | 1 | 1 | | 0 | 1 | 0 | 0 | 1 | 1 | 1 |

FIG. 17

| Second node (terminal device) | Transport block | Transport block identifier (UE identifier) | Random access signature | Signature index |
|---|---|---|---|---|
| SN (1) | b (1) | 4 | r (5) | 4 |
| SN (2) | b (2) | 3 | r (4) | 3 |
| SN (3) | b (3) | 2 | r (5) | 4 |
| SN (4) | b (4) | 5 | r (2) | 1 |

FIG. 18

| P | BI | a | | | | | | | | c | | | | | [q(P, 1), q(P, 2), q(P, 3), q(P, 4), q(P, 5), q(P, 6), q(P, 7)] | f | | | | | | |
|---|---|---|---|---|---|---|---|---|---|---|---|---|---|---|---|---|---|---|---|---|---|---|
| 2 | {7, 8} | 0 | 0 | 0 | 0 | 0 | 0 | 1 | 1 | 0 | 0 | 0 | 0 | 1 | [0, 0, 0, 1, 0, 0, 0] | 0 | 0 | 0 | 1 | 0 | 0 | 1 |
| | {6, 8} | 0 | 0 | 0 | 0 | 0 | 1 | 0 | 1 | 0 | 0 | 0 | 1 | 0 | | 0 | 0 | 0 | 1 | 0 | 1 | 0 |
| | {6, 7} | 0 | 0 | 0 | 0 | 0 | 1 | 1 | 0 | 0 | 0 | 0 | 1 | 1 | | 0 | 0 | 0 | 1 | 0 | 1 | 1 |
| | {5, 8} | 0 | 0 | 0 | 0 | 1 | 0 | 0 | 1 | 0 | 0 | 1 | 0 | 0 | | 0 | 0 | 0 | 1 | 1 | 0 | 0 |
| | {5, 7} | 0 | 0 | 0 | 0 | 1 | 0 | 1 | 0 | 0 | 0 | 1 | 0 | 1 | | 0 | 0 | 0 | 1 | 1 | 0 | 1 |
| | {5, 6} | 0 | 0 | 0 | 0 | 1 | 1 | 0 | 0 | 0 | 0 | 1 | 1 | 0 | | 0 | 0 | 0 | 1 | 1 | 1 | 0 |
| | {4, 8} | 0 | 0 | 0 | 1 | 0 | 0 | 0 | 1 | 0 | 0 | 1 | 1 | 1 | | 0 | 0 | 0 | 1 | 1 | 1 | 1 |
| | {4, 7} | 0 | 0 | 0 | 1 | 0 | 0 | 1 | 0 | 0 | 1 | 0 | 0 | 1 | | 0 | 0 | 1 | 0 | 0 | 0 | 1 |
| | {4, 6} | 0 | 0 | 0 | 1 | 0 | 1 | 0 | 0 | 0 | 1 | 0 | 1 | 0 | | 0 | 0 | 1 | 0 | 0 | 1 | 0 |
| | {4, 5} | 0 | 0 | 0 | 1 | 1 | 0 | 0 | 0 | 0 | 1 | 0 | 1 | 1 | | 0 | 0 | 1 | 0 | 0 | 1 | 1 |
| | {3, 8} | 0 | 0 | 1 | 0 | 0 | 0 | 0 | 1 | 0 | 1 | 1 | 0 | 0 | | 0 | 0 | 1 | 0 | 1 | 0 | 0 |
| | {3, 7} | 0 | 0 | 1 | 0 | 0 | 0 | 1 | 0 | 0 | 1 | 1 | 0 | 1 | | 0 | 0 | 1 | 0 | 1 | 0 | 1 |
| | {3, 6} | 0 | 0 | 1 | 0 | 0 | 1 | 0 | 0 | 0 | 1 | 1 | 1 | 0 | | 0 | 0 | 1 | 0 | 1 | 1 | 0 |
| | {3, 5} | 0 | 0 | 1 | 0 | 1 | 0 | 0 | 0 | 0 | 1 | 1 | 1 | 1 | | 0 | 0 | 1 | 0 | 1 | 1 | 1 |
| | {3, 4} | 0 | 0 | 1 | 1 | 0 | 0 | 0 | 0 | 1 | 0 | 0 | 0 | 1 | | 0 | 0 | 1 | 1 | 0 | 0 | 1 |
| | {2, 8} | 0 | 1 | 0 | 0 | 0 | 0 | 0 | 1 | 1 | 0 | 0 | 1 | 0 | | 0 | 0 | 1 | 1 | 0 | 1 | 0 |
| | {2, 7} | 0 | 1 | 0 | 0 | 0 | 0 | 1 | 0 | 1 | 0 | 0 | 1 | 1 | | 0 | 0 | 1 | 1 | 0 | 1 | 1 |
| | {2, 6} | 0 | 1 | 0 | 0 | 0 | 1 | 0 | 0 | 1 | 0 | 1 | 0 | 0 | | 0 | 0 | 1 | 1 | 1 | 0 | 0 |
| | {2, 5} | 0 | 1 | 0 | 0 | 1 | 0 | 0 | 0 | 1 | 0 | 1 | 0 | 1 | | 0 | 0 | 1 | 1 | 1 | 0 | 1 |
| | {2, 4} | 0 | 1 | 0 | 1 | 0 | 0 | 0 | 0 | 1 | 0 | 1 | 1 | 0 | | 0 | 0 | 1 | 1 | 1 | 1 | 0 |
| | **{2, 3}** | **0** | **1** | **1** | **0** | **0** | **0** | **0** | **0** | **1** | **0** | **1** | **1** | **1** | | **0** | **0** | **1** | **1** | **1** | **1** | **1** |
| | {1, 8} | 1 | 0 | 0 | 0 | 0 | 0 | 0 | 1 | 1 | 1 | 0 | 0 | 1 | | 0 | 1 | 0 | 0 | 0 | 0 | 1 |
| | {1, 7} | 1 | 0 | 0 | 0 | 0 | 0 | 1 | 0 | 1 | 1 | 0 | 1 | 0 | | 0 | 1 | 0 | 0 | 0 | 1 | 0 |
| | {1, 6} | 1 | 0 | 0 | 0 | 0 | 1 | 0 | 0 | 1 | 1 | 0 | 1 | 1 | | 0 | 1 | 0 | 0 | 0 | 1 | 1 |
| | {1, 5} | 1 | 0 | 0 | 0 | 1 | 0 | 0 | 0 | 1 | 1 | 1 | 0 | 0 | | 0 | 1 | 0 | 0 | 1 | 0 | 0 |
| | {1, 4} | 1 | 0 | 0 | 1 | 0 | 0 | 0 | 0 | 1 | 1 | 1 | 0 | 1 | | 0 | 1 | 0 | 0 | 1 | 0 | 1 |
| | {1, 3} | 1 | 0 | 1 | 0 | 0 | 0 | 0 | 0 | 1 | 1 | 1 | 1 | 0 | | 0 | 1 | 0 | 0 | 1 | 1 | 0 |
| | {1, 2} | 1 | 1 | 0 | 0 | 0 | 0 | 0 | 0 | 1 | 1 | 1 | 1 | 1 | | 0 | 1 | 0 | 0 | 1 | 1 | 1 |

FIG. 19

| Second node (terminal device) | Transport block | User equipment identifier | Random access signature | Transport block identifier (signature index) |
|---|---|---|---|---|
| SN(1) | b(1) | 4 | r(4) | 4 |
| SN(2) | b(2) | 3 | r(3) | 3 |
| SN(3) | b(3) | 2 | r(2) | 2 |
| SN(4) | b(4) | 5 | r(1) | 1 |

FIG. 20

| P | BI | a | | | | | | c | | | | [q(P, 1), q(P, 2), q(P, 3), q(P, 4), q(P, 5), q(P, 6)] | f | | | | | |
|---|---|---|---|---|---|---|---|---|---|---|---|---|---|---|---|---|---|---|
| 2 | {5, 6} | 0 | 0 | 0 | 0 | 1 | 1 | 0 | 0 | 0 | 1 | [0, 0, 1, 0, 0, 0] | 0 | 0 | 1 | 0 | 0 | 1 |
| | {4, 6} | 0 | 0 | 0 | 1 | 0 | 1 | 0 | 0 | 1 | 0 | | 0 | 0 | 1 | 0 | 1 | 0 |
| | {4, 5} | 0 | 0 | 0 | 1 | 1 | 0 | 0 | 0 | 1 | 1 | | 0 | 0 | 1 | 0 | 1 | 1 |
| | {3, 6} | 0 | 0 | 1 | 0 | 0 | 1 | 0 | 1 | 0 | 0 | | 0 | 0 | 1 | 1 | 0 | 0 |
| | {3, 5} | 0 | 0 | 1 | 0 | 1 | 0 | 0 | 1 | 0 | 1 | | 0 | 0 | 1 | 1 | 0 | 1 |
| | {3, 4} | 0 | 0 | 1 | 1 | 0 | 0 | 0 | 1 | 1 | 0 | | 0 | 0 | 1 | 1 | 1 | 0 |
| | {2, 6} | 0 | 1 | 0 | 0 | 0 | 1 | 0 | 1 | 1 | 1 | | 0 | 0 | 1 | 1 | 1 | 1 |
| | {2, 5} | 0 | 1 | 0 | 0 | 1 | 0 | 1 | 0 | 0 | 0 | | 0 | 1 | 0 | 0 | 0 | 0 |
| | {2, 4} | 0 | 1 | 0 | 1 | 0 | 0 | 1 | 0 | 0 | 1 | | 0 | 1 | 0 | 0 | 0 | 1 |
| | **{2, 3}** | **0** | **1** | **1** | **0** | **0** | **0** | **1** | **0** | **1** | **0** | | **0** | **1** | **0** | **0** | **1** | **0** |
| | {1, 6} | 1 | 0 | 0 | 0 | 0 | 1 | 1 | 0 | 1 | 1 | | 0 | 1 | 0 | 0 | 1 | 1 |
| | {1, 5} | 1 | 0 | 0 | 0 | 1 | 0 | 1 | 1 | 0 | 0 | | 0 | 1 | 0 | 1 | 0 | 0 |
| | {1, 4} | 1 | 0 | 0 | 1 | 0 | 0 | 1 | 1 | 0 | 1 | | 0 | 1 | 0 | 1 | 0 | 1 |
| | {1, 3} | 1 | 0 | 1 | 0 | 0 | 0 | 1 | 1 | 1 | 0 | | 0 | 1 | 0 | 1 | 1 | 0 |
| | {1, 2} | 1 | 1 | 0 | 0 | 0 | 0 | 1 | 1 | 1 | 1 | | 0 | 1 | 0 | 1 | 1 | 1 |

FIG. 21

| Second node (terminal device) | Transport block | Random access signature | Transport block identifier (signature index) |
|---|---|---|---|
| SN(1) | b(1) | r(4) | 4 |
| SN(2) | b(2) | r(3) | 3 |
| SN(3) | b(3) | r(2) | 2 |
| SN(1) | b(4) | r(1) | 1 |

FIG. 22

| P | BI | a | | | | | c | | | | [q(P, 1), q(P, 2), q(P, 3), q(P, 4), q(P, 5)] | f | | | | |
|---|---|---|---|---|---|---|---|---|---|---|---|---|---|---|---|---|
| 0 | {} | 0 | 0 | 0 | 0 | 0 | - | | | | - | 0 | 0 | 0 | 0 | 0 |
| 1 | {5} | 0 | 0 | 0 | 0 | 1 | 0 | 0 | 1 | | [0, 0, 0, 0, 1] | 0 | 0 | 0 | 1 | 0 |
| | {4} | 0 | 0 | 0 | 1 | 0 | 0 | 1 | 1 | | | 0 | 0 | 1 | 0 | 0 |
| | {3} | 0 | 0 | 1 | 0 | 0 | 1 | 0 | 0 | | | 0 | 0 | 1 | 0 | 1 |
| | {2} | 0 | 1 | 0 | 0 | 0 | 1 | 1 | 0 | | | 0 | 0 | 1 | 1 | 1 |
| | {1} | 1 | 0 | 0 | 0 | 0 | 1 | 1 | 1 | | | 0 | 1 | 0 | 0 | 0 |
| 2 | {4, 5} | 0 | 0 | 0 | 1 | 1 | 0 | 0 | 0 | 1 | [0, 1, 0, 0, 1] | 0 | 1 | 0 | 1 | 0 |
| | {3, 5} | 0 | 0 | 1 | 0 | 1 | 0 | 0 | 1 | 1 | | 0 | 1 | 1 | 0 | 0 |
| | {3, 4} | 0 | 0 | 1 | 1 | 0 | 0 | 1 | 0 | 0 | | 0 | 1 | 1 | 0 | 1 |
| | {2, 5} | 0 | 1 | 0 | 0 | 1 | 0 | 1 | 1 | 0 | | 0 | 1 | 1 | 1 | 1 |
| | {2, 4} | 0 | 1 | 0 | 1 | 0 | 0 | 1 | 1 | 1 | | 1 | 0 | 0 | 0 | 0 |
| | **{2, 3}** | **0** | **1** | **1** | **0** | **0** | **1** | **0** | **0** | **1** | | **1** | **0** | **0** | **1** | **0** |
| | {1, 5} | 1 | 0 | 0 | 0 | 1 | 1 | 0 | 1 | 1 | | 1 | 0 | 1 | 0 | 0 |
| | {1, 4} | 1 | 0 | 0 | 1 | 0 | 1 | 1 | 0 | 0 | | 1 | 0 | 1 | 0 | 1 |
| | {1, 3} | 1 | 0 | 1 | 0 | 0 | 1 | 1 | 1 | 0 | | 1 | 0 | 1 | 1 | 1 |
| | {1, 2} | 1 | 1 | 0 | 0 | 0 | 1 | 1 | 1 | 1 | | 1 | 1 | 0 | 0 | 0 |

FIG. 23

| P | BI | a | | | | | Q(P+1) | Q(P+2) | f | | | |
|---|---|---|---|---|---|---|---|---|---|---|---|---|
| 0 | {} | 0 | 0 | 0 | 0 | 0 | 0 | 1 | 0 | 0 | 0 | 0 |
| 1 | {5} | 0 | 0 | 0 | 0 | 1 | 1 | 6 | 0 | 0 | 0 | 1 |
| | {4} | 0 | 0 | 0 | 1 | 0 | | | 0 | 0 | 1 | 0 |
| | {3} | 0 | 0 | 1 | 0 | 0 | | | 0 | 0 | 1 | 1 |
| | {2} | 0 | 1 | 0 | 0 | 0 | | | 0 | 1 | 0 | 0 |
| | {1} | 1 | 0 | 0 | 0 | 0 | | | 0 | 1 | 0 | 1 |
| 2 | {4, 5} | 0 | 0 | 0 | 1 | 1 | 6 | 16 | 0 | 1 | 1 | 0 |
| | {3, 5} | 0 | 0 | 1 | 0 | 1 | | | 0 | 1 | 1 | 1 |
| | {3, 4} | 0 | 0 | 1 | 1 | 0 | | | 1 | 0 | 0 | 0 |
| | {2, 5} | 0 | 1 | 0 | 0 | 1 | | | 1 | 0 | 0 | 1 |
| | {2, 4} | 0 | 1 | 0 | 1 | 0 | | | 1 | 0 | 1 | 0 |
| | **{2, 3}** | **0** | 1 | 1 | **0** | **0** | | | 1 | **0** | 1 | 1 |
| | {1, 5} | 1 | 0 | 0 | 0 | 1 | | | 1 | 1 | 0 | 0 |
| | {1, 4} | 1 | 0 | 0 | 1 | 0 | | | 1 | 1 | 0 | 1 |
| | {1, 3} | 1 | 0 | 1 | 0 | 0 | | | 1 | 1 | 1 | 0 |
| | {1, 2} | 1 | 1 | 0 | 0 | 0 | | | 1 | 1 | 1 | 1 |

FIG. 24

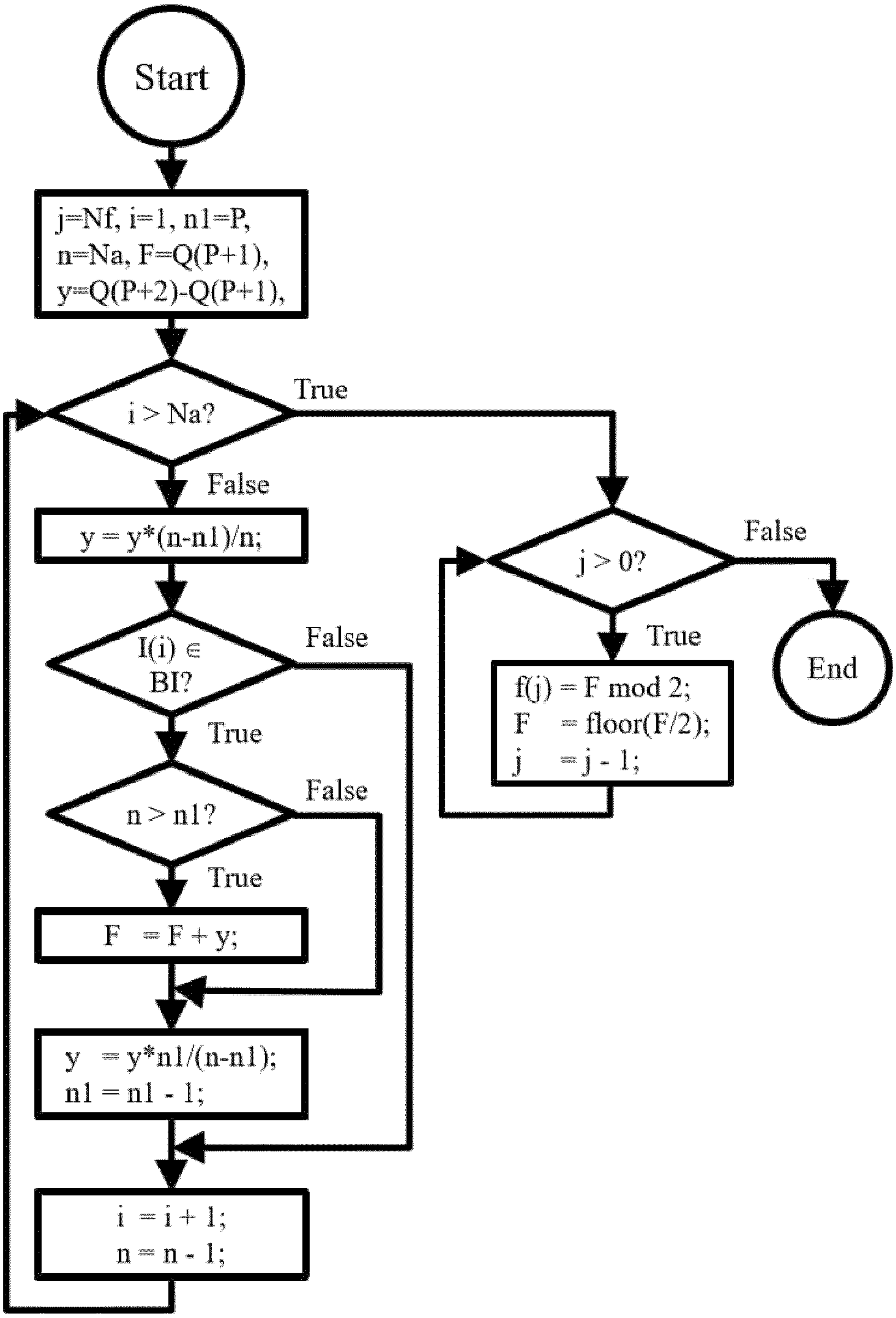
Start
j=Nf, i=1, n1=P,
n=Na, F=Q(P+1),
y=Q(P+2)-Q(P+1),
i > Na?
True
False
y = y*(n-n1)/n;
I(i) ∈
BI?
False
True
n > n1?
False
True
F = F + y;
y = y*n1/(n-n1);
n1 = n1 - 1;
i = i + 1;
n = n - 1;
j > 0?
False
True
f(j) = F mod 2;
F = floor(F/2);
j = j - 1;
End

FIG. 25

| P | BI | a | | | | | Q(P) | Q(P+1) | f | | | |
|---|---|---|---|---|---|---|---|---|---|---|---|---|
| 0 | {} | 0 | 0 | 0 | 0 | 0 | – | 0 | – | | | |
| 1 | {5} | 0 | 0 | 0 | 0 | 1 | 0 | 5 | 0 | 0 | 0 | 0 |
| | {4} | 0 | 0 | 0 | 1 | 0 | | | 0 | 0 | 0 | 1 |
| | {3} | 0 | 0 | 1 | 0 | 0 | | | 0 | 0 | 1 | 0 |
| | {2} | 0 | 1 | 0 | 0 | 0 | | | 0 | 0 | 1 | 1 |
| | {1} | 1 | 0 | 0 | 0 | 0 | | | 0 | 1 | 0 | 0 |
| 2 | {4, 5} | 0 | 0 | 0 | 1 | 1 | 5 | 15 | 0 | 1 | 0 | 1 |
| | {3, 5} | 0 | 0 | 1 | 0 | 1 | | | 0 | 1 | 1 | 0 |
| | {3, 4} | 0 | 0 | 1 | 1 | 0 | | | 0 | 1 | 1 | 1 |
| | {2, 5} | 0 | 1 | 0 | 0 | 1 | | | 1 | 0 | 0 | 0 |
| | {2, 4} | 0 | 1 | 0 | 1 | 0 | | | 1 | 0 | 0 | 1 |
| | **{2, 3}** | **0** | **1** | **1** | **0** | **0** | | | **1** | **0** | **1** | **0** |
| | {1, 5} | 1 | 0 | 0 | 0 | 1 | | | 1 | 0 | 1 | 1 |
| | {1, 4} | 1 | 0 | 0 | 1 | 0 | | | 1 | 1 | 0 | 0 |
| | {1, 3} | 1 | 0 | 1 | 0 | 0 | | | 1 | 1 | 0 | 1 |
| | {1, 2} | 1 | 1 | 0 | 0 | 0 | | | 1 | 1 | 1 | 0 |

FIG. 26

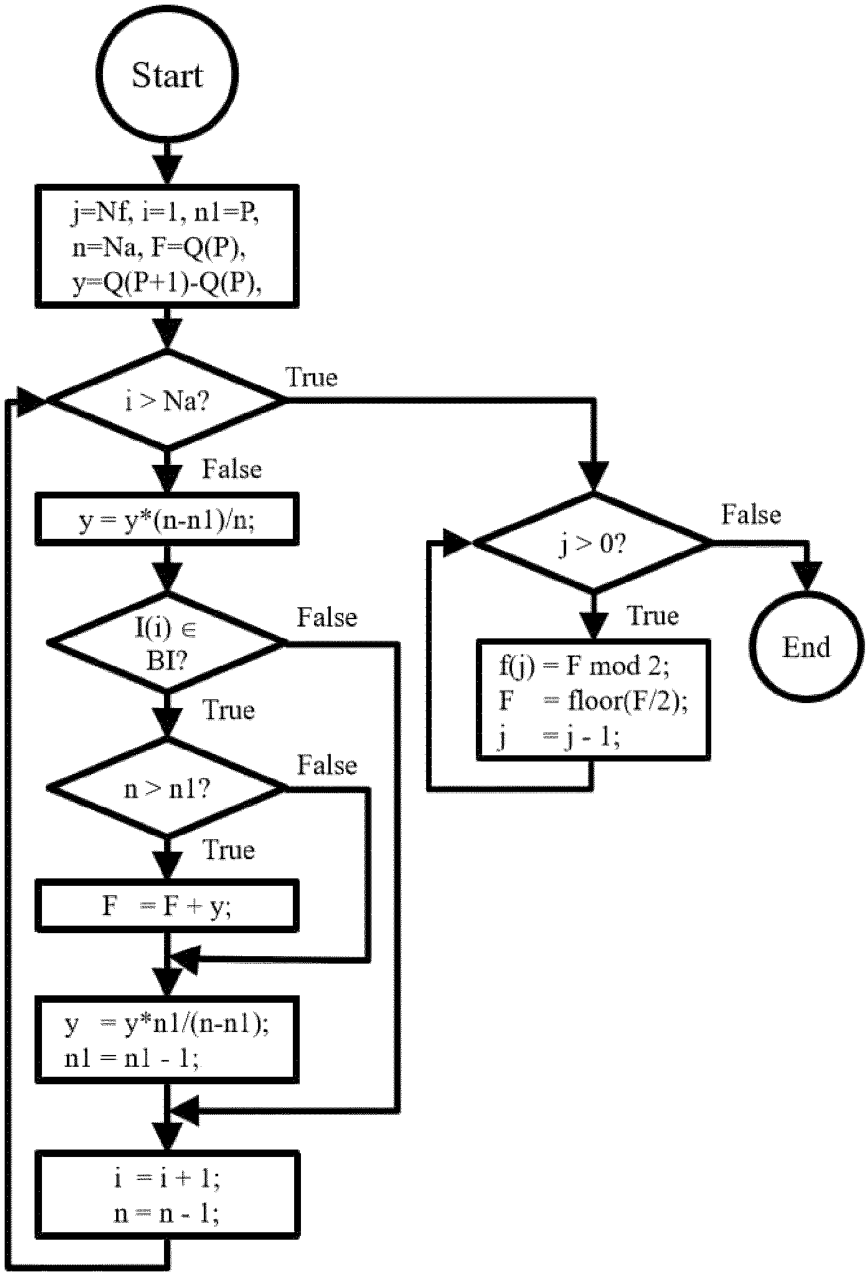


FIG. 27

| Second node (terminal device) | Transport block | Random access signature | Transport block identifier (signature index) |
|---|---|---|---|
| SN(1) | b(1) | r(4) | 3 |
| SN(2) | b(2) | r(3) | 2 |
| SN(3) | b(3) | r(2) | 1 |
| SN(1) | b(4) | r(1) | 0 |

FIG. 28

| Second node (terminal device) | Transport block | User equipment identifier | Transport block identifier (index value of UE identifier) |
|---|---|---|---|
| SN(1) | b(1) | 13 | 4 |
| SN(2) | b(2) | 10 | 3 |
| SN(3) | b(3) | 6 | 2 |
| SN(4) | b(4) | 51 | 5 |

FIG. 29

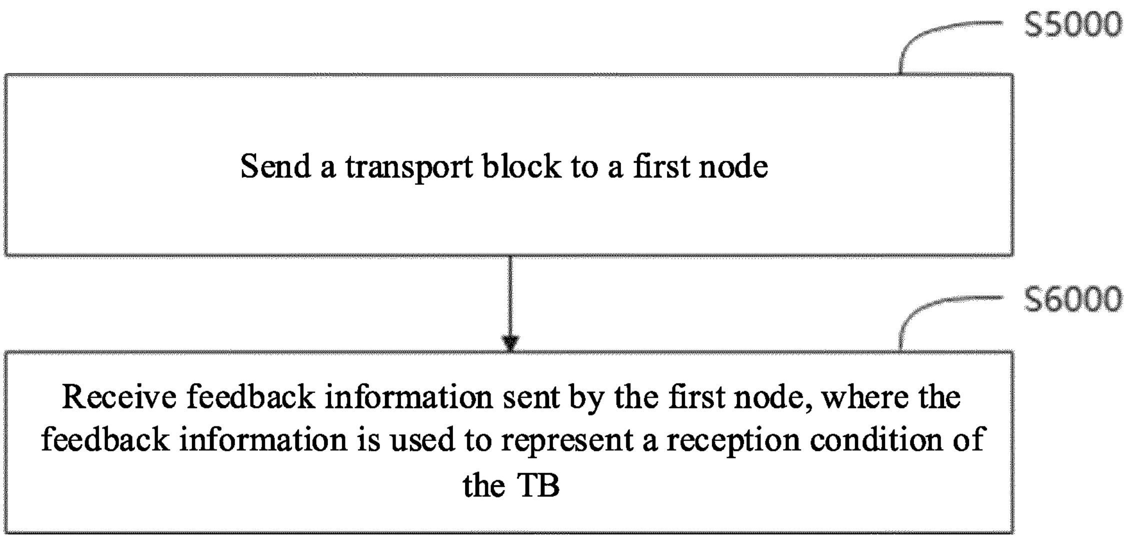


FIG. 30

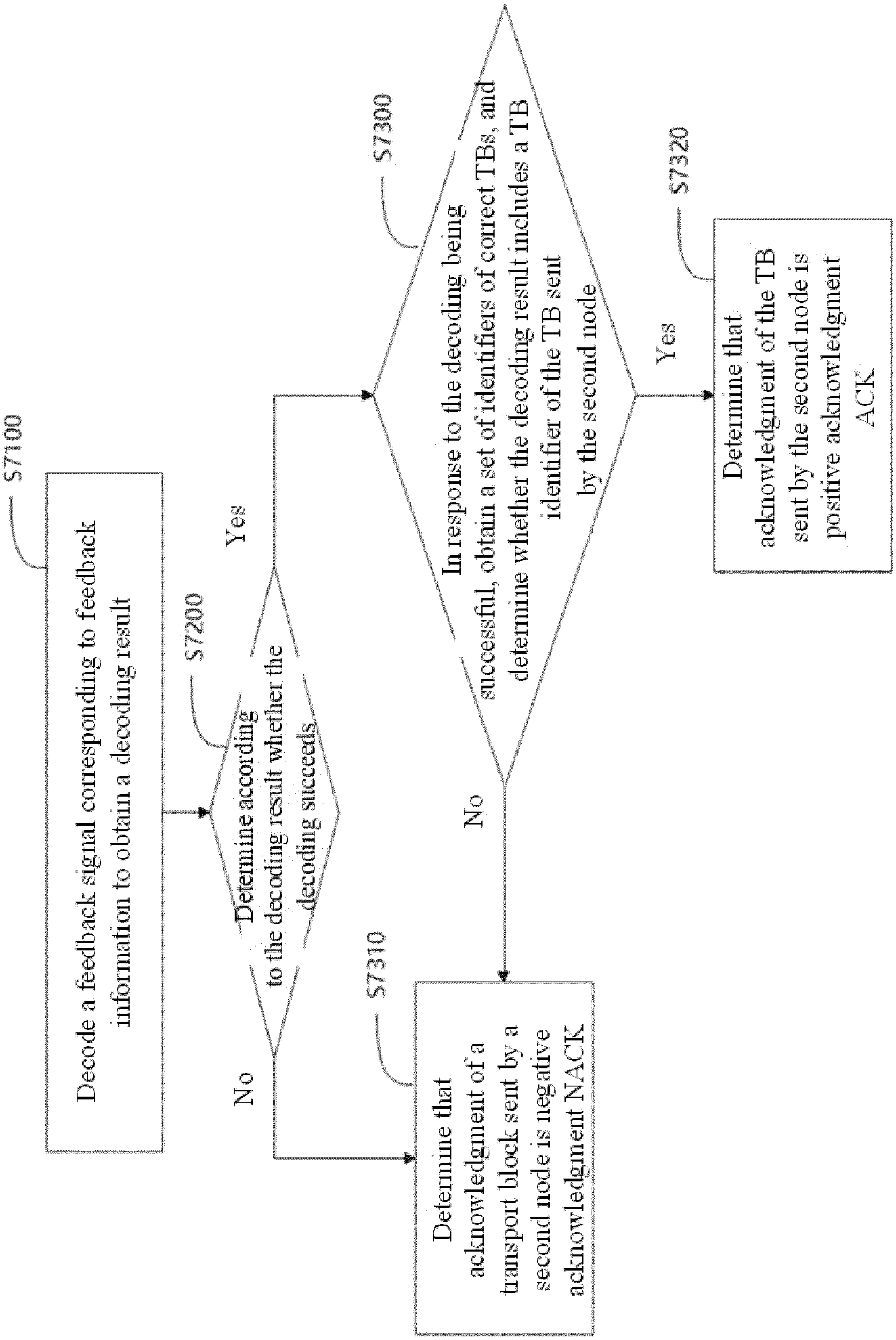
S7100
Decode a feedback signal corresponding to feedback information to obtain a decoding result
S7200
Determine according to the decoding result whether the decoding succeeds
Yes
No
S7300
In response to the decoding being successful, obtain a set of identifiers of correct TBs, and determine whether the decoding result includes a TB identifier of the TB sent by the second node
Yes
No
S7310
Determine that acknowledgment of a transport block sent by a second node is negative acknowledgment NACK
S7320
Determine that acknowledgment of the TB sent by the second node is positive acknowledgment ACK

FIG. 31

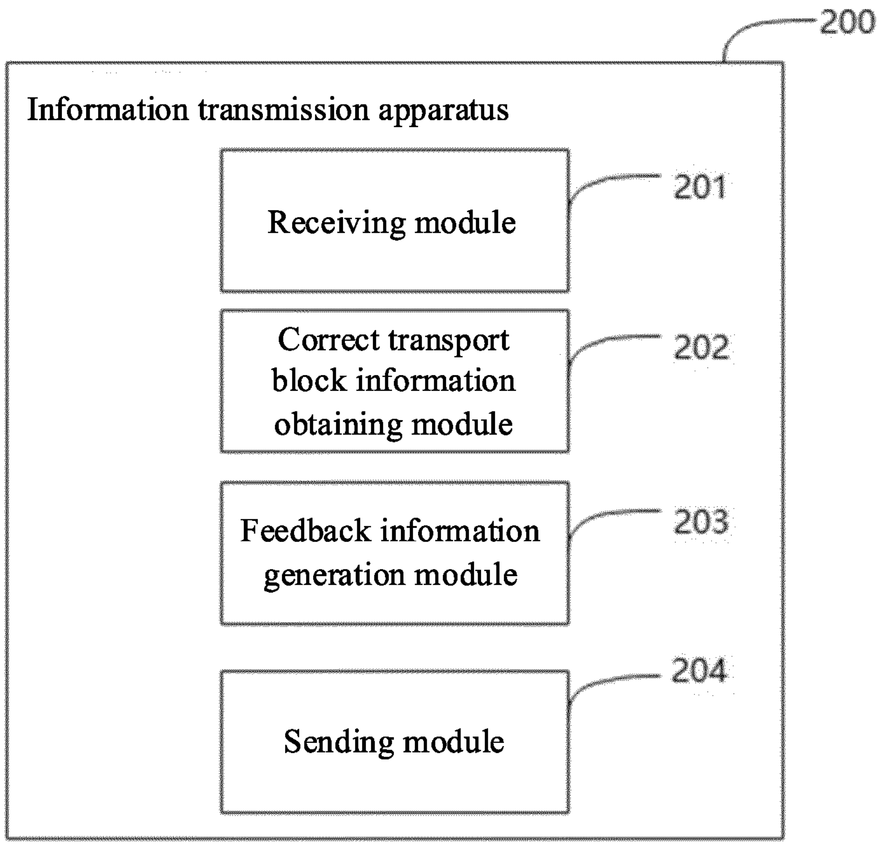
200
Information transmission apparatus
Receiving module
201
Correct transport block information obtaining module
202
Feedback information generation module
203
204
Sending module

FIG. 32

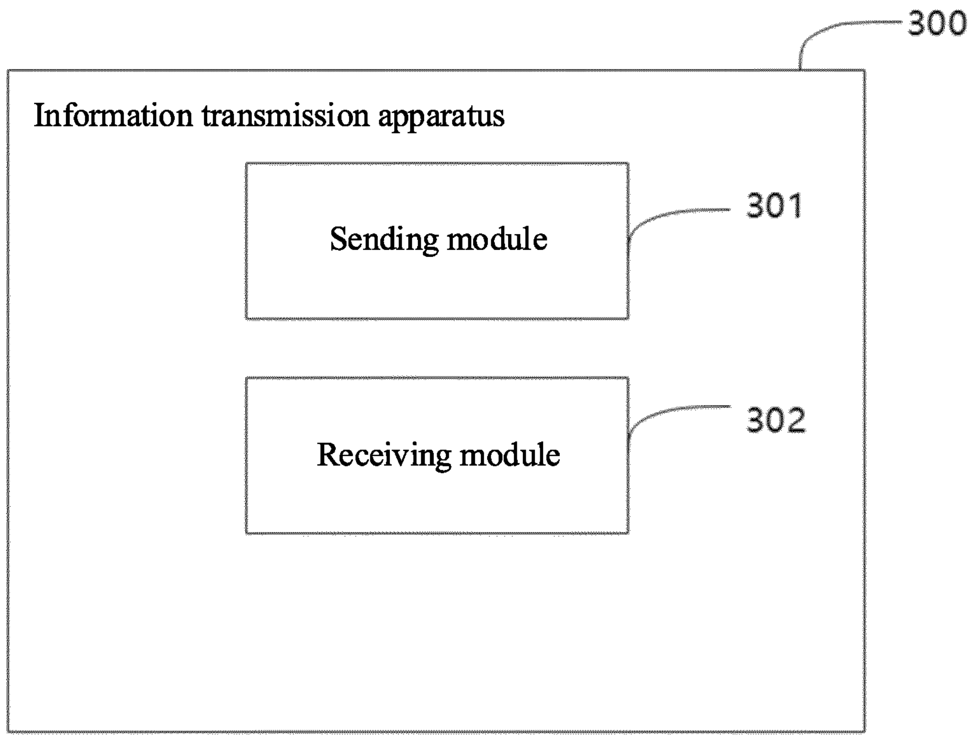
300
Information transmission apparatus
Sending module
301
Receiving module
302

FIG. 33

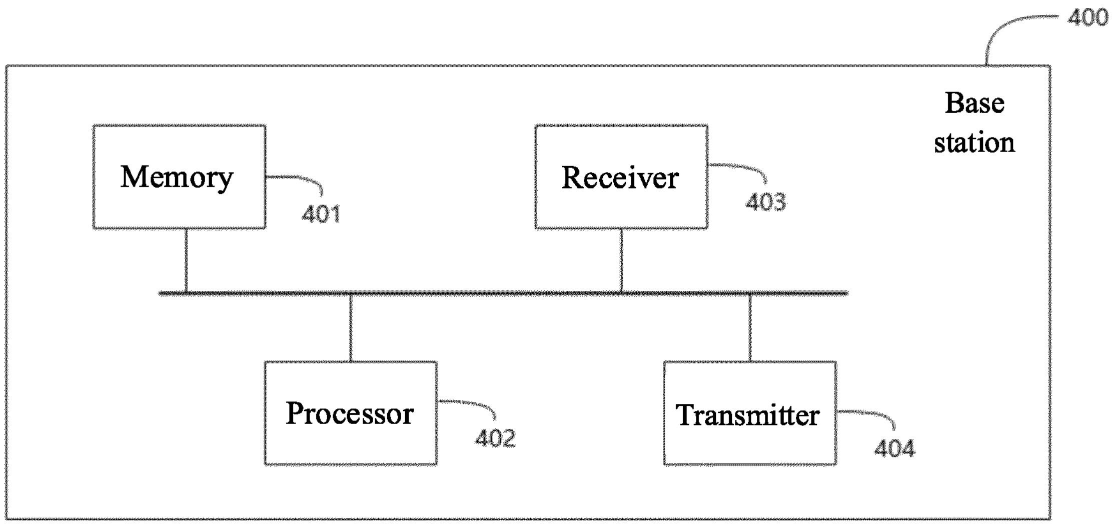
400
Base station
Memory
401
Receiver
403
Processor
402
Transmitter
404

FIG. 34

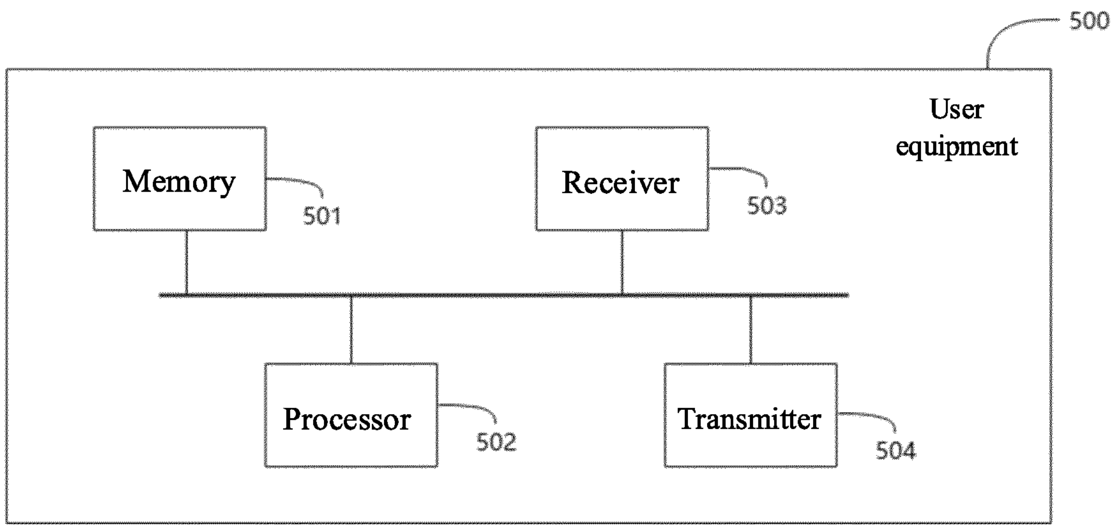
500
User equipment
Memory
501
Receiver
503
Processor
502
Transmitter
504

FIG. 35

## INTERNATIONAL SEARCH REPORT

International application No.
**PCT/CN2023/094340**

**A. CLASSIFICATION OF SUBJECT MATTER**

H04W28/04(2009.01)i; H04L1/1812(2023.01)i

According to International Patent Classification (IPC) or to both national classification and IPC

**B. FIELDS SEARCHED**

Minimum documentation searched (classification system followed by classification symbols)

IPC: H04W, H04L

Documentation searched other than minimum documentation to the extent that such documents are included in the fields searched

Electronic data base consulted during the international search (name of data base and, where practicable, search terms used)

3GPP, CNTXT, ENTXTC, WPABSC, DWPI, CNKI, IEEE: 多, 集合, 传输块, 数据包, 数据块, TB, 正确, 编码, 压缩, 开销, 序号, 编号, 索引, 标识, 反馈, multi, set, transport block, ACK, code, compress, overhead, index, ID, number, feedback

**C. DOCUMENTS CONSIDERED TO BE RELEVANT**

| Category* | Citation of document, with indication, where appropriate, of the relevant passages | Relevant to claim No. |
|---|---|---|
| X | CN 106301703 A (ZTE CORP.) 04 January 2017 (2017-01-04)<br>description, paragraphs 60-152 | 17-21, 23-27 |
| Y | CN 106301703 A (ZTE CORP.) 04 January 2017 (2017-01-04)<br>description, paragraphs 60-152 | 1-3, 6, 8-16, 22 |
| Y | CN 110012678 A (GUANGDONG OPPO MOBILE COMMUNICATIONS CO., LTD.) 12 July 2019 (2019-07-12)<br>description, paragraphs 106-120 | 1-3, 6, 8-16, 22 |
| A | CN 112398597 A (HUAWEI TECHNOLOGIES CO., LTD.) 23 February 2021 (2021-02-23)<br>entire document | 1-27 |
| A | US 2015256298 A1 (TELEFONAKTIEBOLAGET LM ERICSSON (PUBL)) 10 September 2015 (2015-09-10)<br>entire document | 1-27 |
| A | US 2011032925 A1 (LG ELECTRONICS INC.) 10 February 2011 (2011-02-10)<br>entire document | 1-27 |

☐ Further documents are listed in the continuation of Box C.   ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 August 2023** | **21 August 2023** |
| Name and mailing address of the ISA/CN<br>**China National Intellectual Property Administration (ISA/CN)**<br>**China No. 6, Xitucheng Road, Jimenqiao, Haidian District, Beijing 100088** | Authorized officer<br><br>Telephone No. |

Form PCT/ISA/210 (second sheet) (July 2022)

**INTERNATIONAL SEARCH REPORT**
**Information on patent family members**

International application No.
**PCT/CN2023/094340**

| Patent document cited in search report | | | Publication date (day/month/year) | Patent family member(s) | | | Publication date (day/month/year) |
|---|---|---|---|---|---|---|---|
| CN | 106301703 | A | 04 January 2017 | WO | 2016184289 | A1 | 24 November 2016 |
| | | | | EP | 3297199 | A1 | 21 March 2018 |
| | | | | EP | 3297199 | A4 | 23 May 2018 |
| | | | | EP | 3297199 | B1 | 19 August 2020 |
| | | | | US | 2018287741 | A1 | 04 October 2018 |
| | | | | US | 10749636 | B2 | 18 August 2020 |
| CN | 110012678 | A | 12 July 2019 | US | 2021328722 | A1 | 21 October 2021 |
| | | | | US | 11343020 | B2 | 24 May 2022 |
| | | | | EP | 3512145 | A1 | 17 July 2019 |
| | | | | EP | 3512145 | A4 | 23 October 2019 |
| | | | | EP | 3512145 | B1 | 05 August 2020 |
| | | | | WO | 2019090710 | A1 | 16 May 2019 |
| CN | 112398597 | A | 23 February 2021 | None | | | |
| US | 2015256298 | A1 | 10 September 2015 | JP | 2016502292 | A | 21 January 2016 |
| | | | | JP | 5974182 | B2 | 23 August 2016 |
| | | | | IN | 1658 | KON2014A | 23 October 2015 |
| | | | | BR | 112015006724 | A2 | 04 July 2017 |
| | | | | BR | 112015006724 | B1 | 16 August 2022 |
| | | | | PL | 2901596 | T3 | 31 December 2019 |
| | | | | IL | 237873 | B | 30 April 2018 |
| | | | | US | 9350498 | B2 | 24 May 2016 |
| | | | | EP | 2901596 | A1 | 05 August 2015 |
| | | | | EP | 2901596 | B1 | 10 July 2019 |
| | | | | ES | 2749680 | T3 | 23 March 2020 |
| | | | | RU | 2015115897 | A | 20 November 2016 |
| | | | | RU | 2621002 | C2 | 30 May 2017 |
| | | | | WO | 2014051491 | A1 | 03 April 2014 |
| | | | | US | 2016261392 | A1 | 08 September 2016 |
| US | 2011032925 | A1 | 10 February 2011 | KR | 20090099469 | A | 22 September 2009 |
| | | | | KR | 101615231 | B1 | 25 April 2016 |
| | | | | WO | 2009116759 | A2 | 24 September 2009 |
| | | | | WO | 2009116759 | A3 | 17 December 2009 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202210675040